(19) Europäisches Patentamt / European Patent Office / Office européen des brevets

(11) EP 4 571 813 A1

(12) **EUROPEAN PATENT APPLICATION**
published in accordance with Art. 153(4) EPC

(43) Date of publication:
**18.06.2025 Bulletin 2025/25**

(21) Application number: **23868097.9**

(22) Date of filing: **12.09.2023**

(51) International Patent Classification (IPC):
***H01L 21/02*** *(2006.01)* ***B32B 27/36*** *(2006.01)*
***C08G 59/14*** *(2006.01)* ***C08G 63/00*** *(2006.01)*
***C09D 5/00*** *(2006.01)* ***C09D 167/00*** *(2006.01)*
***C09D 171/12*** *(2006.01)* ***C09J 7/30*** *(2018.01)*
***C09J 7/40*** *(2018.01)* ***C09J 201/00*** *(2006.01)*
***H01L 21/304*** *(2006.01)* ***H01L 21/683*** *(2006.01)*

(52) Cooperative Patent Classification (CPC):
**B32B 27/36; C08G 59/14; C08G 63/00; C09D 5/00; C09D 167/00; C09D 171/12; C09J 7/30; C09J 7/40; C09J 201/00; H01L 21/02; H01L 21/304; H01L 21/683**

(86) International application number:
**PCT/JP2023/033176**

(87) International publication number:
**WO 2024/062974 (28.03.2024 Gazette 2024/13)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **22.09.2022 JP 2022151567**

(71) Applicant: **Nissan Chemical Corporation**
**Tokyo 103-6119 (JP)**

(72) Inventors:
- **YAGYU, Masafumi**
  **Toyama-shi, Toyama 939-2792 (JP)**
- **SHINJO, Tetsuya**
  **Toyama-shi, Toyama 939-2792 (JP)**

(74) Representative: **Hoffmann Eitle**
**Patent- und Rechtsanwälte PartmbB**
**Arabellastraße 30**
**81925 München (DE)**

(54) **REMOVER COMPOSITION FOR LIGHT IRRADIATION REMOVAL, MULTILAYER BODY, AND METHOD FOR PRODUCING PROCESSED SEMICONDUCTOR SUBSTRATE**

(57) A release agent composition for release by irradiation with light contains at least one of a compound and a polymer having a structure represented by the following formula (1) and having a carbon content of 80% or less, and a solvent,

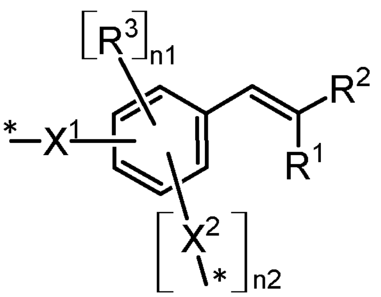

(1)

wherein in the formula (1), $R^1$ and $R^2$ each independently represent a hydrogen atom, a cyano group, a phenyl group, an alkyl group having 1 to 13 carbon atoms, a halogen atom, -$COOR^{11}$ ($R^{11}$ represents a hydrogen atom or an alkyl group having 1 to 4 carbon atoms), or -COO-,
$R^3$ represents a methoxy group, an alkyl group having 1 to 13 carbon atoms, or a halogen atom,
n1 represents an integer of 0 to 4, and n2 represents 0 or 1, provided that the sum of n1 and n2 is 4 or less,
$X^1$ represents an ether bond or an ester bond,
$X^2$ represents an ether bond or an ester bond, and
* represents a bond.

EP 4 571 813 A1

FIG. 1

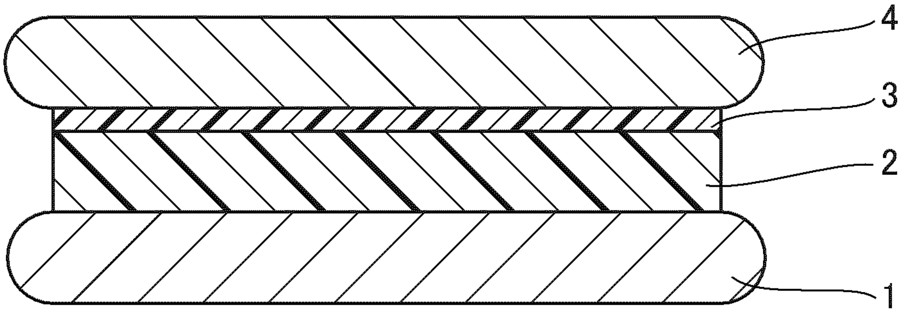

## Description

### Technical Field

The present invention relates to a release agent composition for release by irradiation with light, a laminate, and a method for producing a processed semiconductor substrate.

### Background Art

For a semiconductor wafer that has been conventionally integrated in a two-dimensional planar direction, a semiconductor integration technology is required by which a planar surface is further integrated (laminated) also in a three-dimensional direction for the purpose of further integration. This three-dimensional lamination is a technique of integrating layers while connecting them by a through silicon via (TSV). At the time of multi-layer integration, respective wafers to be integrated are thinned by polishing on the side opposite to the formed circuit surface (that is, the back surface), and the thinned semiconductor wafers are laminated.

A pre-thinned semiconductor wafer (also referred to herein simply as a wafer) is adhered to a support in order to be polished with a polishing apparatus. The adhesion at that time need to be easily released after polishing, and therefore is referred to as temporary adhesion. This temporary adhesion must allow for easy removal from the support. Otherwise, the thinned semiconductor wafer may be cut or deformed when a large force is applied for the removal. The removal is easily performed such that such a situation does not occur. On the other hand, at the time of polishing the back surface of the semiconductor wafer, it is not preferable that the semiconductor wafer is detached or displaced due to polishing stress. Therefore, the performance required for temporary adhesion is to withstand the stress during polishing and to allow for easy removal after polishing.

For example, there is a demand for a performance having a high stress (strong adhesion force) in the planar direction at the time of polishing and a low stress (weak adhesion force) in the longitudinal direction at the time of removal.

Although a method by irradiation with a laser has been disclosed for such adhesion and separation processes (see, for example, Patent Literatures 1 and 2), a new technique related to release by irradiation with light such as a laser is always required with further progress in the recent semiconductor field.

The present applicant has proposed a laminate for allowing for processing of a workpiece, the laminate including an intermediate layer adhered between a support and the workpiece to be releasable, in which the intermediate layer includes at least a release layer in contact with the support side, and the release layer includes a Novolac resin that is altered by absorbing light having a wavelength of 190 nm to 600 nm emitted through the support (see Patent Literature 3).

### Citation List

#### Patent Literature

Patent Literature 1: JP 2004-64040 A
Patent Literature 2: JP 2012-106486 A
Patent Literature 3: WO 2019/088103 A

### Summary of Invention

#### Technical Problem

In a method for release by irradiation with light, after a semiconductor substrate such as a semiconductor wafer is processed, a release agent layer is altered by irradiation with light to facilitate release of the semiconductor substrate from a support substrate. Since foreign matter such as an adhesive layer, a release agent layer, and residues thereof may attach to the surface of the semiconductor substrate and/or the support substrate after release, the semiconductor substrate and/or the support substrate is cleaned. However, depending on the type of the release agent layer, foreign matter on the semiconductor substrate and the support substrate is hardly removed, so that cleaning may be difficult. In addition, when foreign matter remains as contamination in a cleaning agent, the foreign matter reattaches to the semiconductor substrate and the support substrate. When the foreign matter remains on the semiconductor substrate without being removed, a problem such as a decrease in yield of the semiconductor product occurs. In addition, when the foreign matter remains on the support substrate without being removed, it is difficult to reuse the support substrate. Furthermore, when foreign matter remains as contamination in a cleaning agent, the cleaning agent is hardly reused.

The present invention has been made in view of the above circumstances, and an object of the present invention is to provide a release agent composition for release by irradiation with light in which a release agent layer having releasability and cleanability can be formed in a wide range of light irradiation amount, a laminate obtained using the release agent composition, and a method for producing a processed semiconductor substrate.

Solution to Problem

As a result of intensive studies to solve the above-mentioned problems, the present inventors have found that the above-mentioned problems can be solved, and completed the present invention having the following gist.

That is, the present invention encompasses the following.

[1] A release agent composition for release by irradiation with light, containing:

at least one of a compound and a polymer having a structure represented by a following formula (1) and having a carbon content of 80% or less; and a solvent,

[Chem. 1]

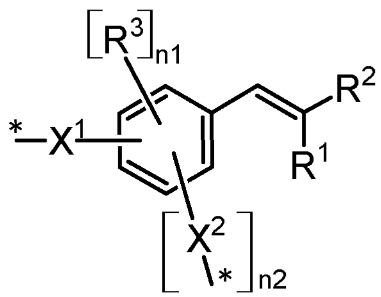

(1)

wherein in the formula (1), $R^1$ and $R^2$ each independently represent a hydrogen atom, a cyano group, a phenyl group, an alkyl group having 1 to 13 carbon atoms, a halogen atom, $-COOR^{11}$ ($R^{11}$ represents a hydrogen atom or an alkyl group having 1 to 4 carbon atoms), or -COO-,
$R^3$ represents a methoxy group, an alkyl group having 1 to 13 carbon atoms, or a halogen atom,
n1 represents an integer of 0 to 4, and n2 represents 0 or 1, provided that the sum of n1 and n2 is 4 or less,
$X^1$ represents an ether bond or an ester bond,
$X^2$ represents an ether bond or an ester bond, and
* represents a bond.

[2] The release agent composition according to [1], wherein at least one of the compound and the polymer has at least one of a structure represented by a following formula (2), a structure represented by a following formula (3), and a structure represented by a following formula (4),

[Chem. 2]

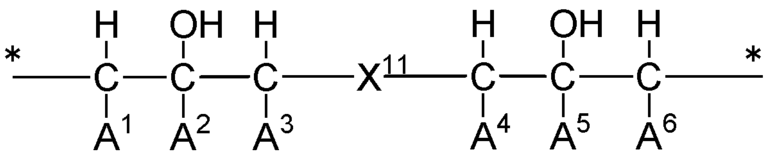

(2)

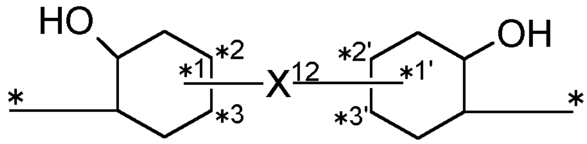

(3)

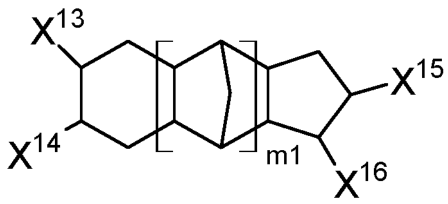

(4)

wherein in the formula (2), $X^{11}$ represents a divalent group, $A^1$, $A^2$, $A^3$, $A^4$, $A^5$, and $A^6$ each independently represent a hydrogen atom, a methyl group, or an ethyl group, and * represents a bond,
in the formula (3), $X^{12}$ represents a divalent group, *, *1, and *1' represent a bond, the bond *1 is bonded to a carbon atom *2 or a carbon atom *3, and the bond *1' is bonded to a carbon atom *2' or a carbon atom *3', and
in the formula (4), one of $X^{13}$ and $X^{14}$ represents a hydroxy group, the other represents a bond, and one of $X^{15}$ and $X^{16}$ represents a hydroxy group, the other represents a bond, and m1 represents 0 or 1.

[3] The release agent composition according to [2], wherein $X^{11}$ in the formula (2) is either a structure represented by a following formula (2-1) or a structure represented by a following formula (2-2),

[Chem. 3]

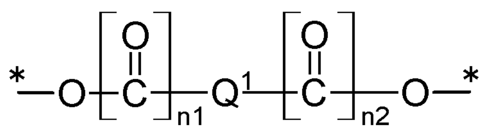

(2-1)

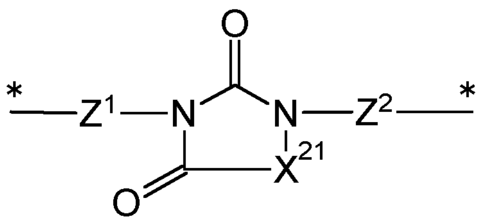

(2-2)

wherein in the formula (2-1), $Q^1$ represents a divalent acyclic hydrocarbon group having 2 to 20 carbon atoms which may be interrupted by an oxygen atom, a divalent organic group represented by a following formula (2-1-1), a divalent organic group represented by a following formula (2-1-2), a divalent organic group represented by a following formula (2-1-3), or a divalent organic group represented by a following formula (2-1-4), n1 and n2 each independently represent 0 or 1, and * represents a bond,
in the formula (2-2), $X^{21}$ represents a divalent group represented by any one of following formulas (2-2-1) to (2-2-4), and $Z^1$ and $Z^2$ each independently represent a single bond or a divalent group represented by a following formula (2-2-5),

[Chem. 4]

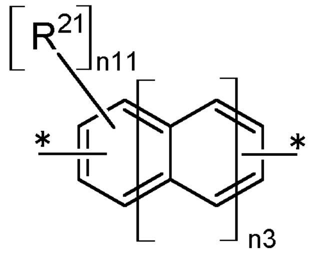

(2-1-1)

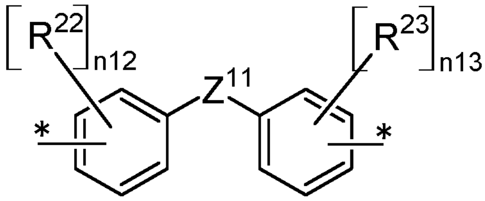

(2-1-2)

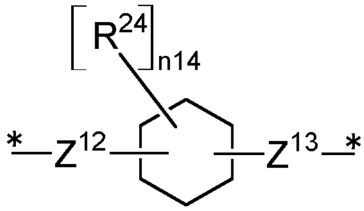

(2-1-3)

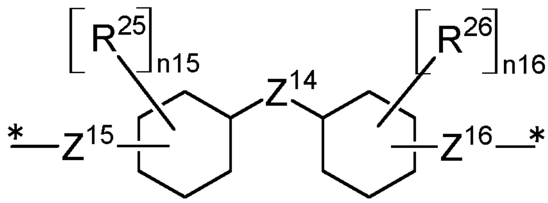

(2-1-4)

in the formulas (2-1-1) to (2-1-4), $R^{21}$ to $R^{26}$ each independently represent a halogen atom, a hydroxy group, an alkyl group having 1 to 6 carbon atoms, an alkenyl group having 2 to 6 carbon atoms, an alkynyl group having 2 to 6 carbon atoms, an alkoxy group having 1 to 6 carbon atoms, an alkenyloxy group having 2 to 6 carbon atoms, an alkynyloxy group having 2 to 6 carbon atoms, an acyl group having 2 to 6 carbon atoms, an aryloxy group having 6 to 12 carbon atoms, an arylcarbonyl group having 7 to 13 carbon atoms, or an aralkyl group having 7 to 13 carbon atoms, and * represents a bond,

in the formula (2-1-1), n3 represents 0 or 1, when n3 is 0, n11 represents an integer of 0 to 4, when n3 is 1, n11 represents an integer of 0 to 6, and when two or more $R^{21}$s are present, the two or more $R^{21}$s may be identical to or different from each other,

in the formula (2-1-2), $Z^{11}$ represents a single bond, an oxygen atom, a sulfur atom, a carbonyl group, a sulfonyl group, or an alkylene group having 1 to 6 carbon atoms, n12 and n13 each independently represent an integer of 0 to 4, when two or more $R^{22}$s are present, the two or more $R^{22}$s may be identical to or different from each other, and when two or more $R^{23}$s are present, the two or more $R^{23}$s may be identical to or different from each other,

in the formula (2-1-3), $Z^{12}$ and $Z^{13}$ each independently represent a single bond or a linear or branched alkylene group having 1 to 6 carbon atoms, n14 represents an integer of 0 to 4, and when two or more $R^{24}$s are present, the two or more $R^{24}$s may be identical to or different from each other, and

in the formula (2-1-4), $Z^{14}$ represents a single bond, an oxygen atom, a sulfur atom, a carbonyl group, a sulfonyl group, or an alkylene group having 1 to 6 carbon atoms, $Z^{15}$ and $Z^{16}$ each independently represent a single bond or a linear or branched alkylene group having 1 to 6 carbon atoms, n15 and n16 each independently represent an integer of 0 to 4, when two or more $R^{25}$s are present, the two or more $R^{25}$s may be identical to or different from each other, and when two or more $R^{26}$s are present, the two or more $R^{26}$s may be identical to or different from each other,

[Chem. 5]

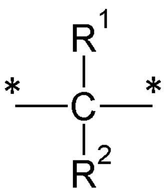
(2-2-1)

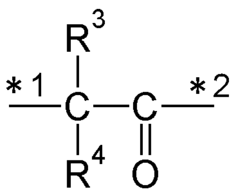
(2-2-2)

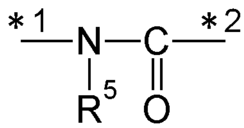
(2-2-3)

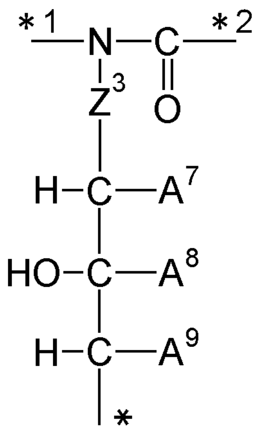
(2-2-4)

in the formulas (2-2-1) to (2-2-3), $R^1$ to $R^5$ each independently represent a hydrogen atom, an alkyl group having 1 to 10 carbon atoms which may be interrupted by an oxygen atom or a sulfur atom, an alkenyl group having 2 to 10 carbon atoms which may be interrupted by an oxygen atom or a sulfur atom, an alkynyl group having 2 to 10 carbon atoms which may be interrupted by an oxygen atom or a sulfur atom, a benzyl group, or a phenyl group, wherein the phenyl group may be substituted with at least one monovalent group selected from the group consisting of an alkyl group having 1 to 6 carbon atoms, a halogen atom, an alkoxy group having 1 to 6 carbon atoms, a nitro group, a cyano group, and an alkylthio group having 1 to 6 carbon atoms, $R^1$ and $R^2$ may be bonded to each other to form a ring having 3 to 6 carbon atoms, and $R^3$ and $R^4$ may be bonded to each other to form a ring having 3 to 6 carbon atoms, and
in the formula (2-2-4), $Z^3$ represents a single bond or a divalent group represented by a following formula (2-2-5), $A^7$, $A^8$, and $A^9$ each independently represent a hydrogen atom, a methyl group, or an ethyl group,
* represents a bond, *1 represents a bond bonded to a carbon atom in the formula (2-2), and *2 represents a bond bonded to a nitrogen atom in the formula (2-2), and

[Chem. 6]

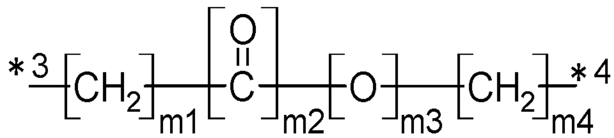
(2-2-5)

in the formula (2-2-5), m1 is an integer of 0 to 4, m2 is 0 or 1, m3 is 0 or 1, and m4 is an integer of 0 to 2, provided that, when m3 is 1, m1 and m2 are not both 0 at the same time, *3 represents a bond bonded to a nitrogen atom in the formula (2-2) or (2-2-4), and *4 represents a bond.

[4] The release agent composition according to any one of [1] to [3], wherein the carbon content is 50% or more.
[5] The release agent composition according to any one of [1] to [4], wherein

$X^1$ in the formula (1) represents an ether bond,
$R^1$ in the formula (1) represents a cyano group,
$R^2$ in the formula (1) represents -COO-, and
n2 in the formula (1) represents 0.

[6] A laminate including:

a semiconductor substrate or an electronic device layer;
a light-transmissive support substrate; and
a release agent layer provided between the semiconductor substrate or the electronic device layer and the

support substrate, wherein
the release agent layer is a release agent layer formed of the release agent composition according to any one of [1] to [5].

[7] The laminate according to [6], including an adhesive layer provided between the semiconductor substrate or the electronic device layer and the support substrate.
[8] A method for producing a processed semiconductor substrate or a processed electronic device layer, the method including:

Step 5A of processing the semiconductor substrate of the laminate according to [6] or [7], or Step 5B of processing the electronic device layer of the laminate according to [6] or [7]; and
Step 6A of separating the semiconductor substrate processed in the Step 5A and the support substrate from each other, or Step 6B of separating the electronic device layer processed in the Step 5B and the support substrate from each other.

[9] The method for producing a processed semiconductor substrate or a processed electronic device layer according to [8], wherein the Step 6A or the Step 6B includes a step of irradiating the laminate with a laser from a support substrate side.

Advantageous Effects of Invention

According to the present invention, it is possible to provide a release agent composition for release by irradiation with light in which a release agent layer having releasability and cleanability can be formed in a wide range of light irradiation amount, a laminate obtained using the release agent composition, and a method for producing a processed semiconductor substrate.

Brief Description of Drawings

Fig. 1 is a schematic cross-sectional view of an example of a laminate according to a first embodiment.
Fig. 2A is a schematic cross-sectional view for illustrating a method for producing a laminate showing an example in a first embodiment (part 1).
Fig. 2B is a schematic cross-sectional view for illustrating a method for producing a laminate showing an example in a first embodiment (part 2).
Fig. 2C is a schematic cross-sectional view for illustrating a method for producing a laminate showing an example in a first embodiment (part 3).
Fig. 3 is a schematic cross-sectional view of an example of a laminate according to a second embodiment.
Fig. 4 is a schematic cross-sectional view of another example of a laminate according to a second embodiment.
Fig. 5A is a schematic cross-sectional view for illustrating a method for producing a laminate showing an example in a second embodiment (part 1).
Fig. 5B is a schematic cross-sectional view for illustrating a method for producing a laminate showing an example in a second embodiment (part 2).
Fig. 5C is a schematic cross-sectional view for illustrating a method for producing a laminate showing an example in a second embodiment (part 3).
Fig. 5D is a schematic cross-sectional view for illustrating a method for producing a laminate showing an example in a second embodiment (part 4).
Fig. 6A is a schematic cross-sectional view for illustrating a method for processing a laminate showing an example in a first embodiment (part 1).
Fig. 6B is a schematic cross-sectional view for illustrating a method for processing a laminate showing an example in a first embodiment (part 2).
Fig. 6C is a schematic cross-sectional view for illustrating a method for processing a laminate showing an example in a first embodiment (part 3).
Fig. 6D is a schematic cross-sectional view for illustrating a method for processing a laminate showing an example in a first embodiment (part 4).
Fig. 7A is a schematic cross-sectional view for illustrating a method for processing a laminate showing an example in a second embodiment (part 1).
Fig. 7B is a schematic cross-sectional view for illustrating a method for processing a laminate showing an example in a

second embodiment (part 2).

Fig. 7C is a schematic cross-sectional view for illustrating a method for processing a laminate showing an example in a second embodiment (part 3).

Fig. 7D is a schematic cross-sectional view for illustrating a method for processing a laminate showing an example in a second embodiment (part 4).

Fig. 7E is a schematic cross-sectional view for illustrating a method for processing a laminate showing an example in a second embodiment (part 5).

Fig. 7F is a schematic cross-sectional view for illustrating a method for processing a laminate showing an example in a second embodiment (part 6).

Description of Embodiments

(Release agent composition for release by irradiation with light)

A release agent composition for release by irradiation with light of the present invention contains at least one of a compound and a polymer having a structure represented by the following formula (1) and having a carbon content of 80% or less, and a solvent.

[Chem. 7]

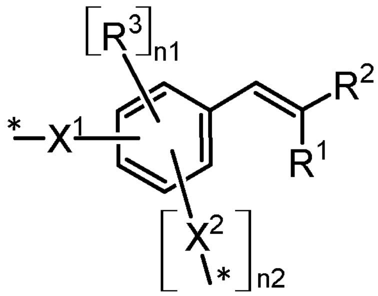

(1)

wherein in the formula (1), $R^1$ and $R^2$ each independently represent a hydrogen atom, a cyano group, a phenyl group, an alkyl group having 1 to 13 carbon atoms, a halogen atom, -COOR$^{11}$ ($R^{11}$ represents a hydrogen atom or an alkyl group having 1 to 4 carbon atoms), or -COO-,

$R^3$ represents a methoxy group, an alkyl group having 1 to 13 carbon atoms, or a halogen atom,

n1 represents an integer of 0 to 4, and n2 represents 0 or 1, provided that the sum of n1 and n2 is 4 or less,

$X^1$ represents an ether bond or an ester bond,

$X^2$ represents an ether bond or an ester bond, and

* represents a bond.

In a method for release by irradiation with light, after a semiconductor substrate such as a semiconductor wafer is processed, a release agent layer is altered by irradiation with light to facilitate release of the semiconductor substrate from a support substrate. Since foreign matter such as an adhesive layer, a release agent layer, and residues thereof may attach to the surface of the semiconductor substrate and/or the support substrate after release, the semiconductor substrate and/or the support substrate is cleaned. However, depending on the type of the release agent layer, foreign matter on the semiconductor substrate and the support substrate is hardly removed, so that cleaning may be difficult. In addition, when foreign matter remains as contamination in a cleaning agent, the foreign matter reattaches to the semiconductor substrate and the support substrate. When the foreign matter remains on the semiconductor substrate without being removed, a problem such as a decrease in yield of the semiconductor product occurs. In addition, when the foreign matter remains on the support substrate without being removed, it is difficult to reuse the support substrate. Furthermore, when foreign matter remains as contamination in a cleaning agent, the cleaning agent is hardly reused.

On the other hand, when the release agent layer is irradiated with light, it is difficult to uniformly irradiate the entire surface of the release agent layer with light, and there is an in-plane variation in the irradiation amount when the local irradiation amount is viewed. As a result of examination by the present inventors, it has been found that the releasability and the cleanability depend on the irradiation amount. The larger the irradiation amount, the better the releasability. On the other hand, the smaller the irradiation amount, the better the cleanability.

Accordingly, it is desired that both the releasability and the cleanability can be achieved in a wide range of light irradiation amount.

Therefore, the present inventors have conducted intensive studies in order to provide a release agent composition for release by irradiation with light capable of forming a release agent layer having releasability and cleanability in a wide range of light irradiation amount.

As a result, the present inventors have found that a release agent composition containing at least one of a compound and a polymer having a structure represented by the formula (1) and having a carbon content of 80% or less and a solvent can form a release agent layer having releasability and cleanability in a wide range of light irradiation amount, and have completed the present invention.

The present inventors consider that the release agent composition of the present invention can form a release agent layer having releasability and cleanability in a wide range of light irradiation amount as follows.

When the compound and polymer have a structure represented by the formula (1), the release agent layer is easily altered by irradiation with light, and as a result, a release agent layer having releasability in a wide range of light irradiation amount is obtained. On the other hand, when the carbon contents of the compound and polymer are not too large, the cleanability is easily maintained even if the release agent layer is altered by irradiation with light. As the alteration, for example, carbonization is considered.

<Compound or polymer>

The compound and polymer (hereinafter, it may be referred to as "specific compound and polymer") contained in the release agent composition have a structure represented by the following formula (1), and have a carbon content of 80% or less.

In the present invention, the difference between the compound and the polymer does not need to be particularly clear. For example, as long as the compound and the polymer are substances having a structure represented by the formula (1) and having a carbon content of 80% or less, they may have a low molecular weight or a high molecular weight, may be of a single composition, or may have a molecular weight distribution (for example, the polydispersity (weight average molecular weight/number average molecular weight) may be more than 1).

[Chem. 8]

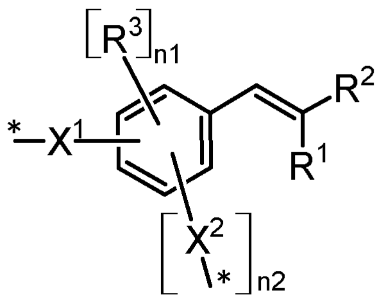

(1)

wherein in the formula (1), $R^1$ and $R^2$ each independently represent a hydrogen atom, a cyano group, a phenyl group, an alkyl group having 1 to 13 carbon atoms, a halogen atom, $-COOR^{11}$ ($R^{11}$ represents a hydrogen atom or an alkyl group having 1 to 4 carbon atoms), or -COO-,
$R^3$ represents a methoxy group, an alkyl group having 1 to 13 carbon atoms, or a halogen atom,
n1 represents an integer of 0 to 4, and n2 represents 0 or 1, provided that the sum of n1 and n2 is 4 or less,
$X^1$ represents an ether bond (-O-) or an ester bond (-COO-).
$X^2$ represents an ether bond (-O-) or an ester bond (-COO-).
* represents a bond.

Examples of the alkyl group having 1 to 13 carbon atoms of $R^1$ to $R^3$ in the formula (1) include an alkyl group having 1 to 6 carbon atoms.

Examples of the alkyl group having 1 to 6 carbon atoms include a methyl group, an ethyl group, an isopropyl group, an n-butyl group, and a cyclohexyl group.

Examples of the alkyl group having 1 to 4 carbon atoms of $R^{11}$ in the formula (1) include a methyl group, an ethyl group, an isopropyl group, and an n-butyl group.

$X^1$ in the formula (1) preferably represents an ether bond.

$R^1$ in the formula (1) preferably represents a cyano group.

$R^2$ in the formula (1) preferably represents -COO-.

n2 in the formula (1) preferably represents 0.

The carbon contents of the specific compound and polymer are not particularly limited as long as they are 80% or less, but are preferably 75% or less, more preferably 70% or less.

The lower limit of the carbon contents of the specific compound and polymer is not particularly limited, but the carbon content is preferably 45% or more, more preferably 50% or more, particularly preferably 55% or more.

The carbon contents of the compound and polymer can be determined, for example, by the following method.

The composition formula of the compound or polymer is determined. When the compound or polymer is synthesized, the composition formula of the compound or polymer can be estimated from the type of reaction raw materials, the amount of the reaction raw materials used, the reaction conditions, the molecular weight of the product, and the like. When the composition formula of the compound or polymer is obtained by analyzing the compound or polymer, the composition formula can be obtained using gel permeation chromatography (GPC), mass spectrometry, elemental analysis, infrared spectroscopic analysis, or the like.

The carbon content of the compound or polymer is calculated using the obtained composition formula of the compound or polymer. The carbon content represents a mass ratio of carbon in the compound or polymer. The carbon content can be determined using the types of elements constituting the compound or polymer, the molar ratio of these elements, and the atomic weight of these elements. The carbon content can be determined, for example, by the following formula.

[Mathematical formula 1]

$$\text{Carbon content(\%)} = 100 \times \frac{12 \times C_{atom}}{x_1 \times X_{1,atom} + x_2 \times X_{2,atom} + x_3 \times X_{3,atom} + \cdot\cdot\cdot\cdot\cdot + x_n + X_{n,atom}}$$

$C_{atom}$: represents the molar ratio of carbon in the composition formula.
$X_{1,atom}$: represents the molar ratio of the element $X_1$ in the composition.
$x_1$: represents the atomic weight of the element $X_1$.
$X_{2,atom}$: represents the molar ratio of the element $X^2$ in the composition.
$x_2$: represents the atomic weight of the element $X_2$.
$X_{n,atom}$: represents the molar ratio of the element $X_n$ in the composition.
$x_n$: represents the atomic weight of the element $X_n$.

Here, as an example, the carbon atom amount of benzene is determined.

Benzene has the molecular formula $C_6H_6$, and the composition formula is CH. Therefore, the carbon atom amount (%) of benzene is 100 × 12 × 1/[12 × 1 + 1 × 1] = 92.3%.

Next, as an example, the carbon atom amount of the reaction product produced in Synthesis Example E described later is determined.

The reaction product produced in Synthesis Example E is composed of a structural unit represented by the following formula (A-5) except for the terminal.

Formula (A-5)

[Chem. 9]

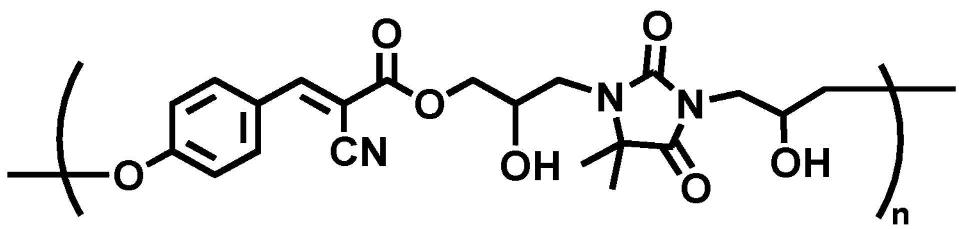

The composition formula of this reaction product is the composition formula $C_{21}H_{23}O_7N_3$. Accordingly, the carbon atom amount (%) of this reaction product is 100 × 12 × 21/[(12 × 21) + (1 × 23) + (16 × 7) + (14 × 3)] = 58.7%.

When the specific compound and polymer have a polysiloxane structure, the carbon content is reduced. This is

because the polysiloxane structure has a high ratio of silicon atoms and oxygen atoms. For example, the carbon content of the -(Si($CH_2$)$_2$-O)- unit in polydimethylsiloxane is 33.3%.

The specific compound and polymer may have a silicon atom or otherwise.

The specific compound and polymer may have a siloxane bond or otherwise.

The specific compound and polymer may have a polysiloxane structure or otherwise.

The specific compound and polymer have a structure represented by the formula (1), and preferably further have at least one of an alkylene group having 4 to 10 carbon atoms, an aliphatic hydrocarbon ring, a heterocyclic ring, and an aromatic hydrocarbon ring. From the viewpoint of suitably obtaining the effect of the present invention, the specific compound and polymer more preferably have at least one of an alkylene group having 4 to 10 carbon atoms, an aliphatic hydrocarbon ring, and a heterocyclic ring.

The alkylene group having 4 to 10 carbon atoms may have a linear structure or a branched structure.

Examples of the aliphatic hydrocarbon ring include a 5 to 7 membered aliphatic hydrocarbon ring.

The heterocyclic ring has, for example, a nitrogen atom, a carbon atom, and an oxygen atom.

Examples of the aromatic hydrocarbon ring include a benzene ring, a naphthalene ring, and an anthracene ring.

The specific compound and polymer preferably further have at least one of a structure represented by the following formula (2), a structure represented by the following formula (3), and a structure represented by the following formula (4).

[Chem. 10]

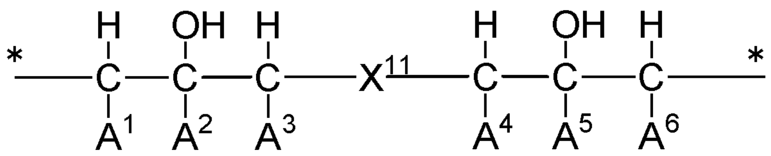

(2)

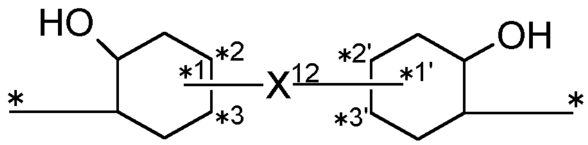

(3)

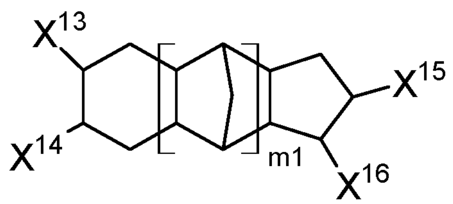

(4)

wherein in the formula (2), $X^{11}$ represents a divalent group, $A^1$, $A^2$, $A^3$, $A^4$, $A^5$, and $A^6$ each independently represent a hydrogen atom, a methyl group, or an ethyl group, and * represents a bond,
in the formula (3), $X^{12}$ represents a divalent group, *, *1, and *1' represent a bond, the bond *1 is bonded to a carbon atom *2 or a carbon atom *3, and the bond *1' is bonded to a carbon atom *2' or a carbon atom *3', and
in the formula (4), one of $X^{13}$ and $X^{14}$ represents a hydroxy group, the other represents a bond, and one of $X^{15}$ and $X^{16}$ represents a hydroxy group, the other represents a bond, and m1 represents 0 or 1.

In the formula (2), $X^{11}$ represents, for example, either a structure represented by the following formula (2-1) or a structure represented by the following formula (2-2).

[Chem. 11]

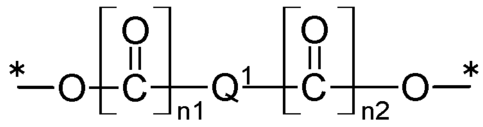

(2-1)

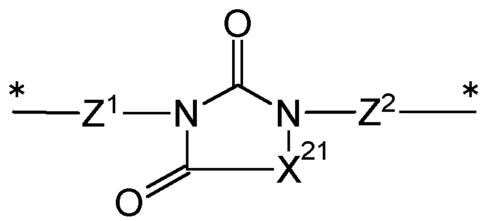

(2-2)

wherein in the formula (2-1), $Q^1$ represents a divalent acyclic hydrocarbon group having 2 to 20 carbon atoms which may be interrupted by an oxygen atom, a divalent organic group represented by a following formula (2-1-1), a divalent organic group represented by a following formula (2-1-2), a divalent organic group represented by a following formula (2-1-3), or a divalent organic group represented by a following formula (2-1-4), n1 and n2 each independently represent 0 or 1, and * represents a bond,
in the formula (2-2), $X^{21}$ represents a divalent group represented by any one of following formulas (2-2-1) to (2-2-4), and $Z^1$ and $Z^2$ each independently represent a single bond or a divalent group represented by a following formula (2-2-5),

[Chem. 12]

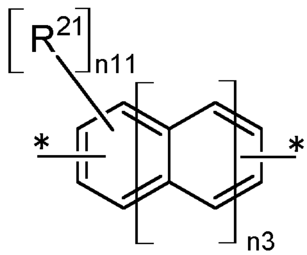

(2-1-1)

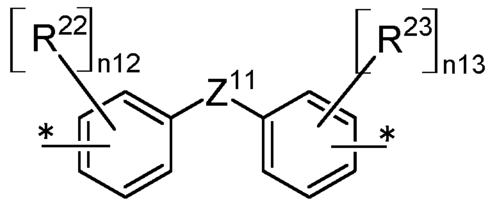

(2-1-2)

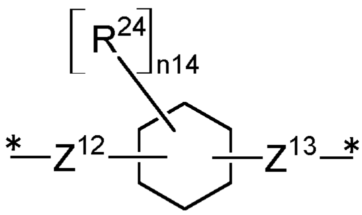

(2-1-3)

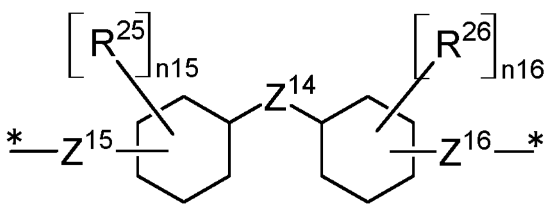

(2-1-4)

in the formulas (2-1-1) to (2-1-4), $R^{21}$ to $R^{26}$ each independently represent a halogen atom, a hydroxy group, an alkyl group having 1 to 6 carbon atoms, an alkenyl group having 2 to 6 carbon atoms, an alkynyl group having 2 to 6 carbon atoms, an alkoxy group having 1 to 6 carbon atoms, an alkenyloxy group having 2 to 6 carbon atoms, an alkynyloxy group having 2 to 6 carbon atoms, an acyl group having 2 to 6 carbon atoms, an aryloxy group having 6 to 12 carbon atoms, an arylcarbonyl group having 7 to 13 carbon atoms, or an aralkyl group having 7 to 13 carbon atoms, and * represents a bond,

in the formula (2-1-1), n3 represents 0 or 1, when n3 is 0, n11 represents an integer of 0 to 4, when n3 is 1, n11 represents an integer of 0 to 6, and when two or more $R^{21}$s are present, the two or more $R^{21}$s may be identical to or different from each other,

in the formula (2-1-2), $Z^{11}$ represents a single bond, an oxygen atom, a sulfur atom, a carbonyl group, a sulfonyl group, or an alkylene group having 1 to 6 carbon atoms, n12 and n13 each independently represent an integer of 0 to 4, when two or more $R^{22}$s are present, the two or more $R^{22}$s may be identical to or different from each other, and when two or more $R^{23}$s are present, the two or more $R^{23}$s may be identical to or different from each other,

in the formula (2-1-3), $Z^{12}$ and $Z^{13}$ each independently represent a single bond or a linear or branched alkylene group having 1 to 6 carbon atoms, n14 represents an integer of 0 to 4, and when two or more $R^{24}$s are present, the two or more $R^{24}$s may be identical to or different from each other, and

in the formula (2-1-4), $Z^{14}$ represents a single bond, an oxygen atom, a sulfur atom, a carbonyl group, a sulfonyl group, or an alkylene group having 1 to 6 carbon atoms, $Z^{15}$ and $Z^{16}$ each independently represent a single bond or a linear or branched alkylene group having 1 to 6 carbon atoms, n15 and n16 each independently represent an integer of 0 to 4, when two or more $R^{25}$s are present, the two or more $R^{25}$s may be identical to or different from each other, and when two or more $R^{26}$s are present, the two or more $R^{26}$s may be identical to or different from each other,

[Chem. 13]

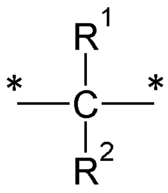

(2-2-1)

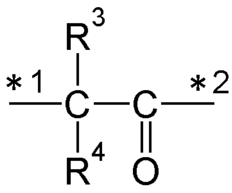

(2-2-2)

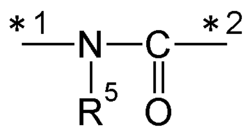

(2-2-3)

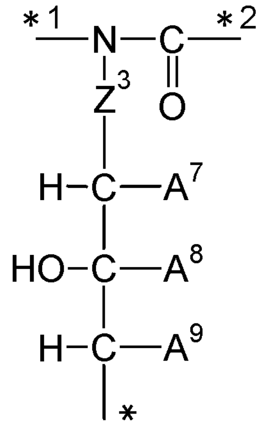

(2-2-4)

in the formulas (2-2-1) to (2-2-3), $R^1$ to $R^5$ each independently represent a hydrogen atom, an alkyl group having 1 to 10 carbon atoms which may be interrupted by an oxygen atom or a sulfur atom, an alkenyl group having 2 to 10 carbon atoms which may be interrupted by an oxygen atom or a sulfur atom, an alkynyl group having 2 to 10 carbon atoms which may be interrupted by an oxygen atom or a sulfur atom, a benzyl group, or a phenyl group, wherein the phenyl group may be substituted with at least one monovalent group selected from the group consisting of an alkyl group having 1 to 6 carbon atoms, a halogen atom, an alkoxy group having 1 to 6 carbon atoms, a nitro group, a cyano group, and an alkylthio group having 1 to 6 carbon atoms, $R^1$ and $R^2$ may be bonded to each other to form a ring having 3 to 6 carbon atoms, and $R^3$ and $R^4$ may be bonded to each other to form a ring having 3 to 6 carbon atoms, and

in the formula (2-2-4), $Z^3$ represents a single bond or a divalent group represented by a following formula (2-2-5), $A^7$, $A^8$, and $A^9$ each independently represent a hydrogen atom, a methyl group, or an ethyl group,

* represents a bond, *1 represents a bond bonded to a carbon atom in the formula (2-2), and *2 represents a bond bonded to a nitrogen atom in the formula (2-2), and

[Chem. 14]

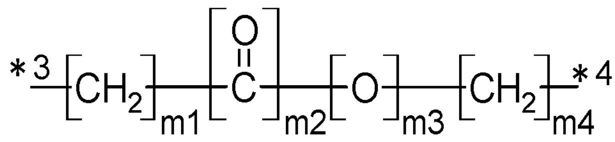

(2-2-5)

in the formula (2-2-5), m1 is an integer of 0 to 4, m2 is 0 or 1, m3 is 0 or 1, and m4 is an integer of 0 to 2, provided that, when m3 is 1, m1 and m2 are not both 0 at the same time, *3 represents a bond bonded to a nitrogen atom in the formula (2-2) or (2-2-4), and *4 represents a bond.

In the present description, examples of the halogen atom include a fluorine atom, a chlorine atom, a bromine atom, and an iodine atom.

In the present description, the alkyl group is not limited to a linear form, and may be a branched form or a cyclic form. Examples of the linear or branched alkyl group include a methyl group, an ethyl group, an isopropyl group, a tert-butyl group, and an n-hexyl group. Examples of the cyclic alkyl group (cycloalkyl group) include a cyclobutyl group, a cyclopentyl group, and a cyclohexyl group.

In the present description, examples of the alkoxy group include a methoxy group, an ethoxy group, an n-pentyloxy group, and an isopropoxy group.

In the present description, examples of the alkylthio group include a methylthio group, an ethylthio group, an n-pentylthio group, and an isopropylthio group.

In the present description, examples of the alkenyl group include an ethenyl group, a 1-propenyl group, a 2-propenyl group, a 1-methyl-1-ethenyl group, a 1-butenyl group, a 2-butenyl group, a 3-butenyl group, a 2-methyl-1-propenyl group, and a 2-methyl-2-propenyl group.

In the present description, examples of the alkynyl group include groups in which a double bond of the alkenyl groups listed above as "alkenyl group" is replaced with a triple bond.

In the present description, examples of the alkenyloxy group include a vinyloxy group, a 1-propenyloxy group, a 2-n-propenyloxy group (allyloxy group), a 1-n-butenyloxy group, and a prenyloxy group.

In the present description, examples of the alkynyloxy group include a 2-propynyloxy group, a 1-methyl-2-propynyloxy group, a 2-methyl-2-propynyloxy group, a 2-butynyloxy group, and a 3-butynyloxy group.

In the present description, examples of the acyl group include an acetyl group and a propionyl group.

In the present description, examples of the aryloxy group include a phenoxy group and a naphthyloxy.

In the present description, examples of the arylcarbonyl group include a phenylcarbonyl group.

In the present description, examples of the aralkyl group include a benzyl group and a phenethyl group.

In the present description, examples of the alkylene group include a methylene group, an ethylene group, a 1,3-propylene group, a 2,2-propylene group, a 1-methylethylene group, a 1,4-butylene group, a 1-ethylethylene group, a 1-methylpropylene group, a 2-methylpropylene group, a 1,5-pentylene group, a 1-methylbutylene group, a 2-methylbutylene group, a 1,1-dimethylpropylene group, a 1,2-dimethylpropylene group, a 1-ethylpropylene group, a 2-ethylpropylene group, a 1,6-hexylene group, a 1,4-cyclohexylene group, a 1,8-octylene group, a 2-ethyloctylene group, a 1,9-nonylene group, and a 1,10-decylene group.

Examples of the divalent acyclic hydrocarbon group having 2 to 20 carbon atoms which may be interrupted by an oxygen atom of $Q^1$ in the formula (2-1) include an alkylene group having 2 to 10 carbon atoms, $-CH_2CH_2-(OCH_2CH_2)_n-$ (n represents an integer of 1 to 9), and $-CH(CH_3)CH_2-(OCH(CH_3)CH_2)_n-$ (n represents an integer of 1 to 5).

The alkylene group having 2 to 10 carbon atoms may be linear or branched.

Examples of the alkyl group having 1 to 10 carbon atoms which may be interrupted by an oxygen atom or a sulfur atom of $R^1$ to $R^5$ in the formulas (2-2-1) to (2-2-3) include an alkyl group having 1 to 10 carbon atoms, an alkoxy group having 1 to 10 carbon atoms, an alkoxyalkyl group having 2 to 10 carbon atoms, an alkoxyalkoxyalkyl group having 3 to 10 carbon atoms, an alkylthio group having 1 to 10 carbon atoms, and an alkylthioalkyl group having 2 to 10 carbon atoms.

In addition, the alkyl group having 1 to 10 carbon atoms which may be interrupted by an oxygen atom or a sulfur atom may include two or more oxygen atoms or sulfur atoms.

Examples of the structure represented by the formula (2-1) include structures exemplified below.

[Chem. 15]

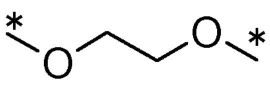
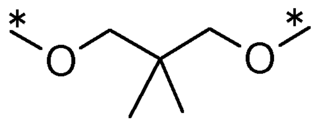
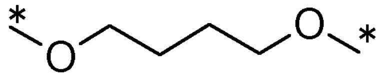

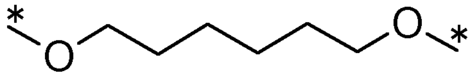

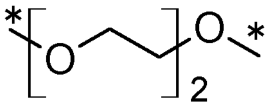
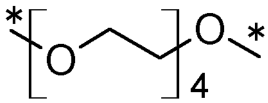
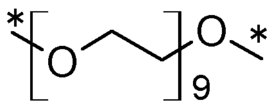

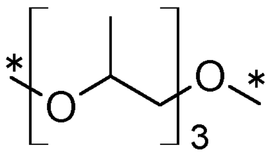

The above examples are examples when $Q^1$ in the formula (2-1) is a divalent acyclic hydrocarbon group having 2 to 20 carbon atoms which may be interrupted by an oxygen atom.

[Chem. 16]

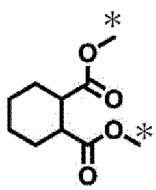

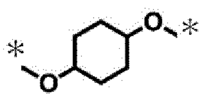
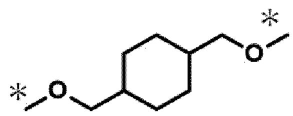

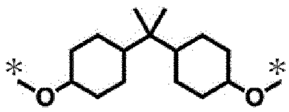

[Chem. 17]

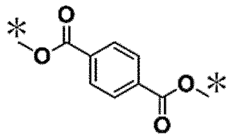
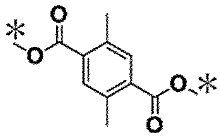
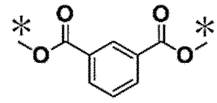
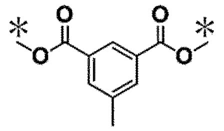
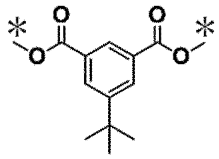
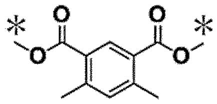
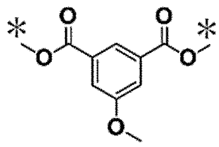
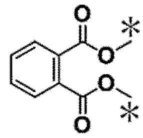
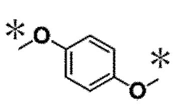
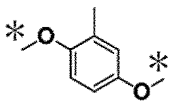
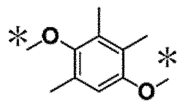
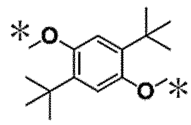
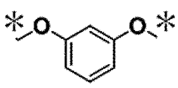
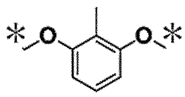
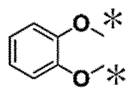
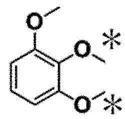

[Chem. 18]

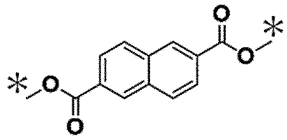
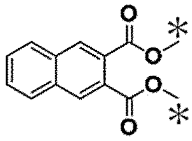
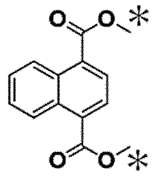
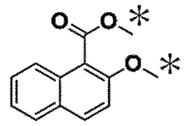
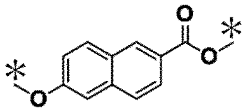
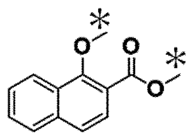
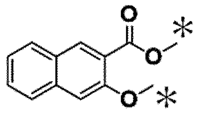
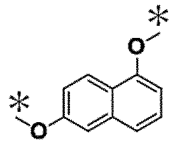
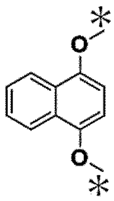
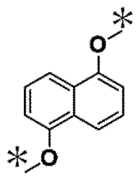
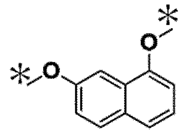
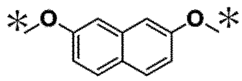
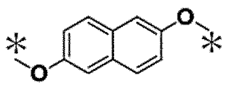
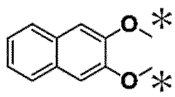

[Chem. 19]

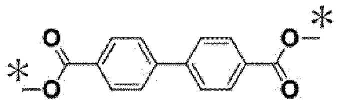
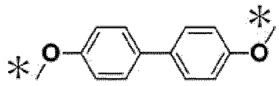
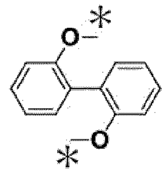

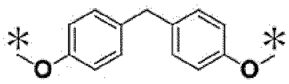
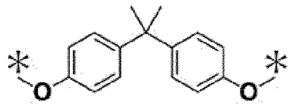
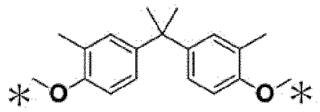

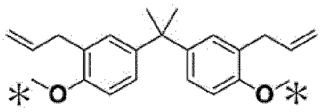
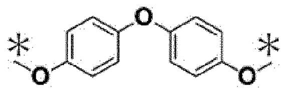
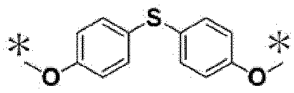

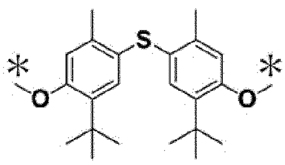
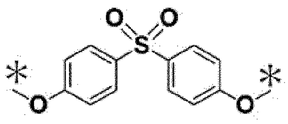
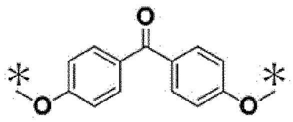

(* represents a bond.)

Examples of the structure represented by the formula (2-2) include structures exemplified below.

[Chem. 20]

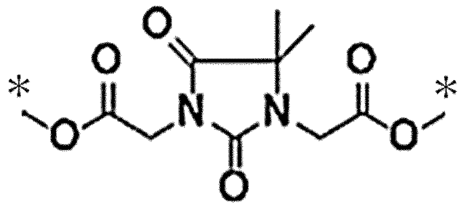

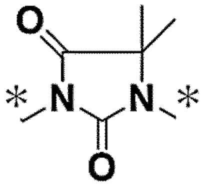

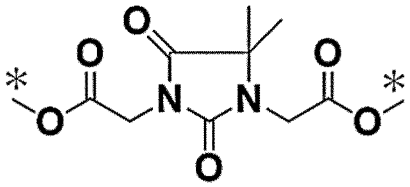

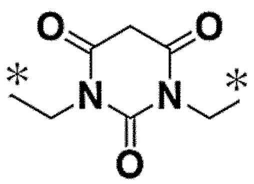

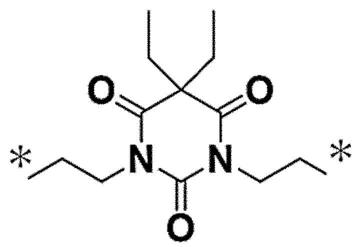

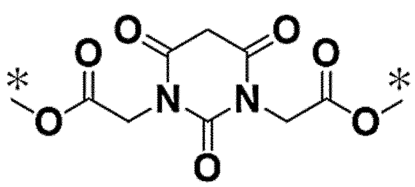

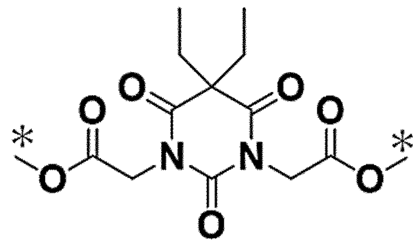

[Chem. 21]

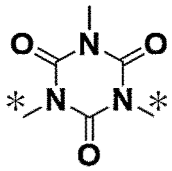
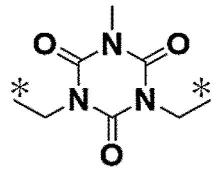
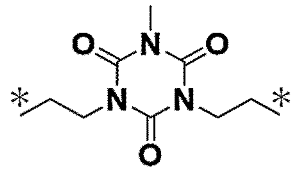
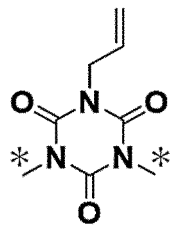
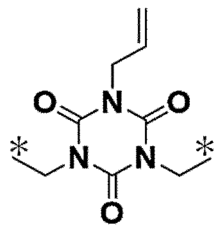
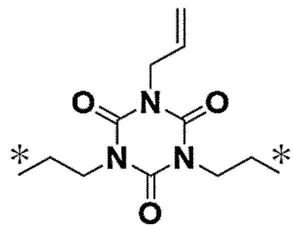
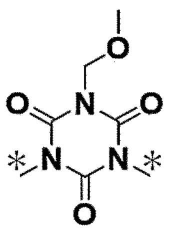
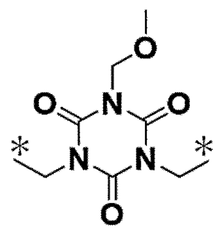
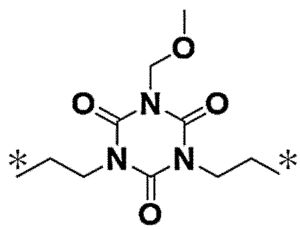

[Chem. 22]

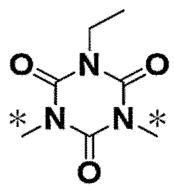
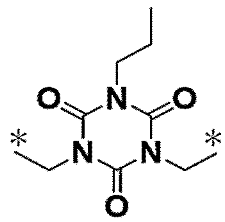
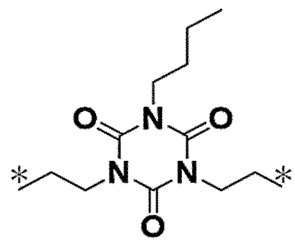
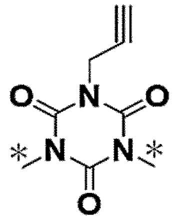
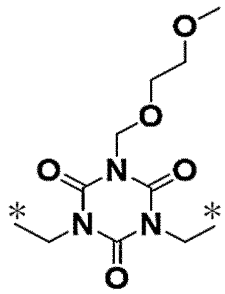
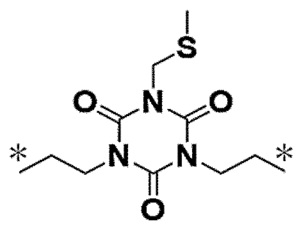

[Chem. 23]

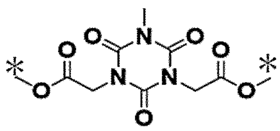
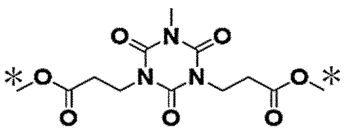
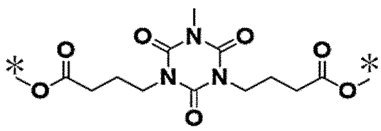
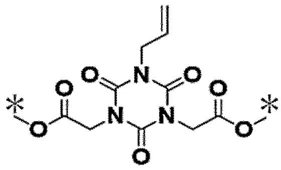
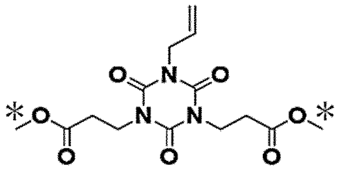
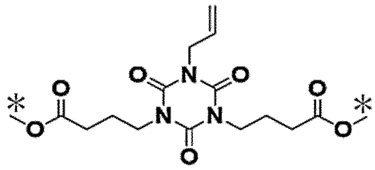
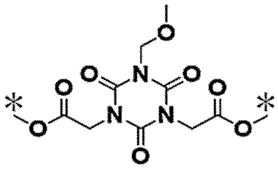
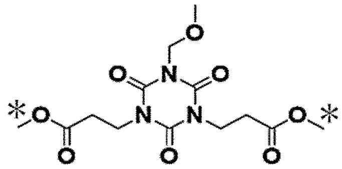
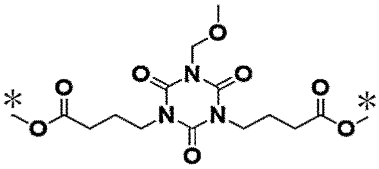

[Chem. 24]

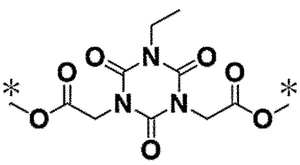
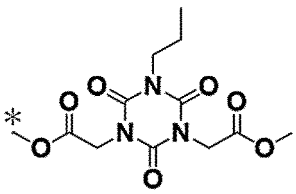
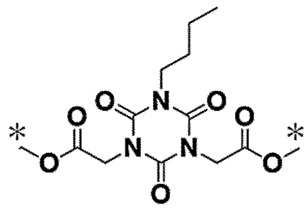
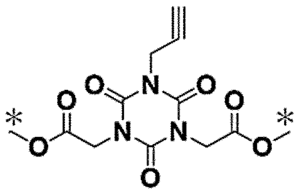
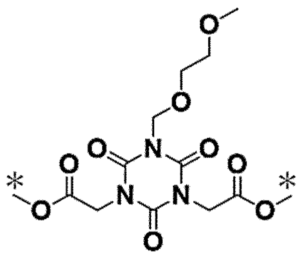
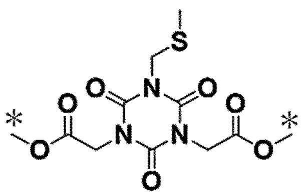

[Chem. 25]

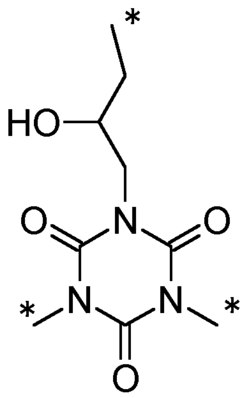

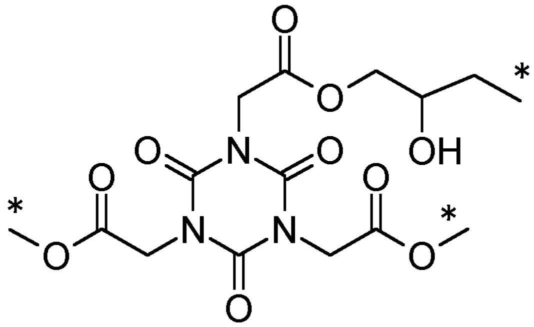

(* represents a bond.)

In the formula (3), $X^{12}$ represents a divalent group.

Examples of the divalent group of $X^{12}$ include - $C(=O)OCH_2$-, -NH-, and -N=C=N-.

Specific examples of the structure represented by the formula (4) are as follows.

[Chem. 26]

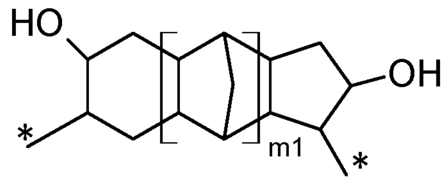

(4-1)

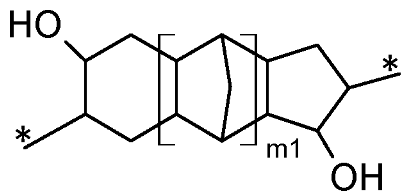

(4-2)

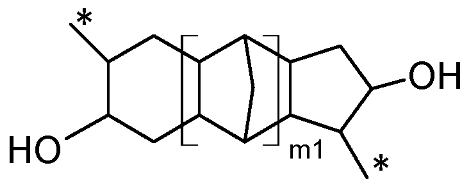

(4-3)

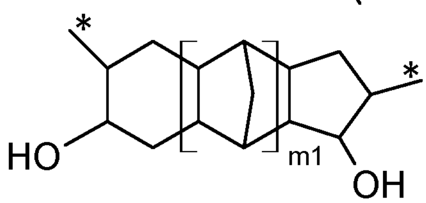

(4-4)

In the formulas (4-1) to (4-4), m1 represents 0 or 1. * represents a bond.

The specific compound and polymer preferably have, as a structure having the structure represented by the formula (1), at least one of a structure represented by the following formula (1-2), a structure represented by the following formula (1-3), and a structure represented by the following formula (1-4). The structure represented by the formula (1-2) may be a repeating unit in the polymer. The structure represented by the formula (1-3) may be a repeating unit in the polymer. The structure represented by the formula (1-4) may be a repeating unit in the polymer.

[Chem. 27]

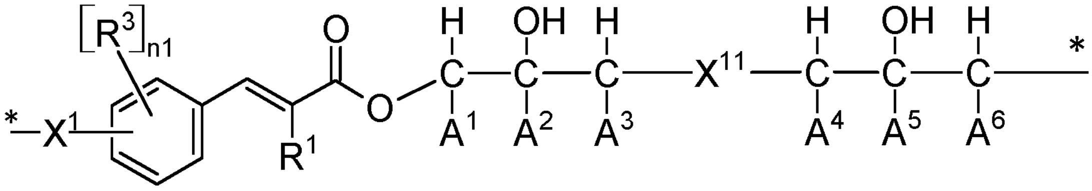

(1-2)

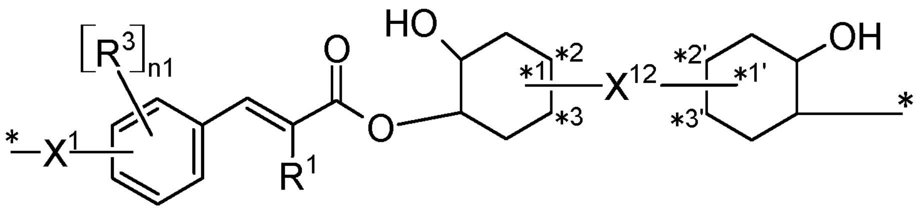

(1-3)

[Chem. 28]

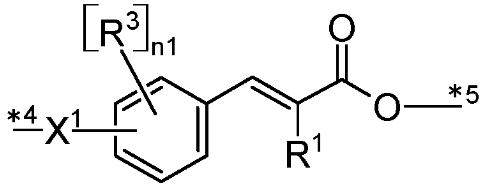

(A)

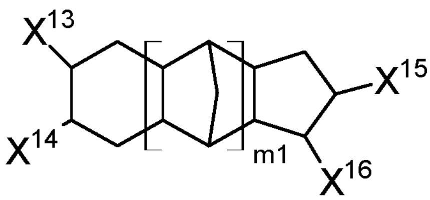

(B)

(1-4)

(In the formulas (1-2) to (1-4), $X^1$, $R^3$, and n1 have the same meanings as $X^1$, $R^3$, and n1 in the formula (1), respectively.

In the formula (1-2), $X^{11}$, $A^1$, $A^2$, $A^3$, $A^4$, $A^5$, and $A^6$ have the same meanings as $X^{11}$, $A^1$, $A^2$, $A^3$, $A^4$, $A^5$, and $A^6$ in the formula (2), respectively.

In the formula (1-3), $X^{12}$ has the same meaning as $X^{12}$ in the formula (3).

In the formulas (1-2) to (1-4), $R^1$ represents a hydrogen atom, a cyano group, a phenyl group, an alkyl group having 1 to 13 carbon atoms, a halogen atom, or - $COOR^{11}$ ($R^{11}$ represents a hydrogen atom or an alkyl group having 1 to 4 carbon atoms).

In the formulas (1-2) to (1-4), *, *1, *1', *4, and *5 represent a bond. the bond *1 is bonded to a carbon atom *2 or a carbon atom *3, and the bond *1' is bonded to a carbon atom *2' or a carbon atom *3', and

In the formula (1-4), one of $X^{13}$ and $X^{14}$ represents a hydroxy group, the other represents a bond, and one of $X^{15}$ and $X^{16}$ represents a hydroxy group, the other represents a bond. m1 represents 0 or 1. The formula (A) and the formula (B) are bonded via a bond *4 or *5 in the formula (A) and any one of bonds $X^{13}$ to $X^{16}$ in the formula (B).)

Examples of the structure represented by the formula (1-4) are as follows.

[Chem. 29]

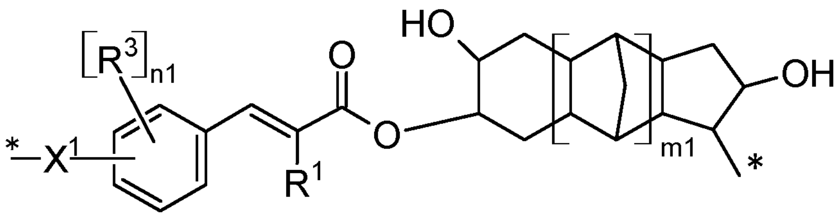

(1-4-1)

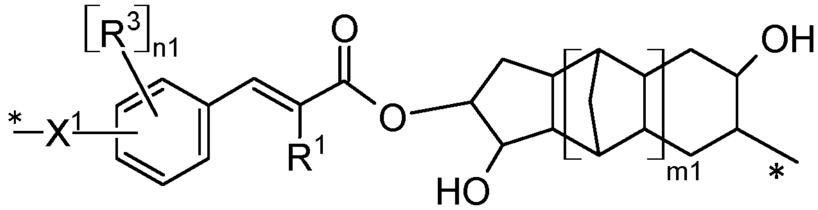

(1-4-2)

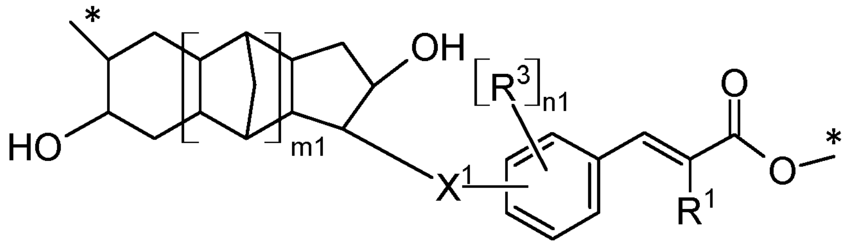

(1-4-3)

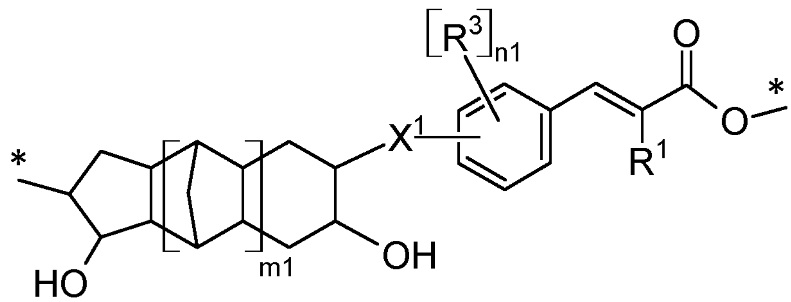

(1-4-4)

(In the formulas (1-4-1) to (1-4-4), $X^1$, $R^1$, $R^3$, m1, and n1 have the same meanings as $X^1$, $R^1$, $R^3$, m1, and n1 in the formula (1-4), respectively. * represents a bond.

The weight average molecular weight of the compound or polymer is, for example, 300 to 100,000, preferably 800 to 50,000, more preferably 1,000 to 10,000, particularly preferably 1,200 to 5,000.

A method for producing an example of the specific compound and polymer will be described. An example of the specific compound and polymer is obtained by, for example, the following reactions (I) to (II).

(I): Reaction between a compound represented by the following formula (1A) and at least one of a compound represented by the following formula (2A), a compound represented by the following formula (3A), and a compound represented by the following formula (4A).

[Chem. 30]

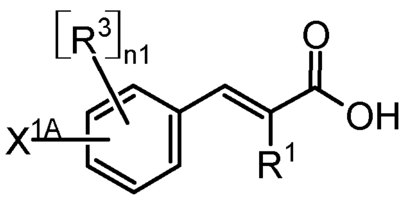

(1A)

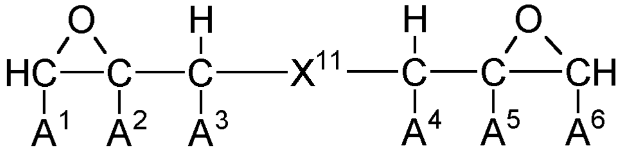

(2A)

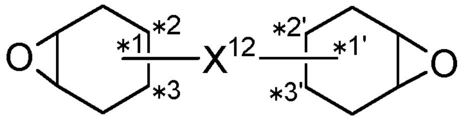

(3A)

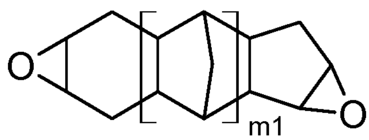

(4A)

(In the formula (1A), $X^{1A}$ represents a hydroxy group or a carboxy group.

In the formula (1A), $R^3$ and n1 have the same meanings as $R^3$ and n1 in the formula (1), respectively.

In the formula (1A), $R^1$ represents a hydrogen atom, a cyano group, a phenyl group, an alkyl group having 1 to 13 carbon atoms, a halogen atom, or $-COOR^{11}$ ($R^{11}$ represents a hydrogen atom or an alkyl group having 1 to 4 carbon atoms) .

In the formula (2A), $X^{11}$, $A^1$, $A^2$, $A^3$, $A^4$, $A^5$, and $A^6$ have the same meanings as $X^{11}$, $A^1$, $A^2$, $A^3$, $A^4$, $A^5$, and $A^6$ in the formula (2), respectively.

In the formula (3A), $X^{12}$ has the same meaning as $X^{12}$ in the formula (3). *1 and *1' represent a bond. the bond *1 is bonded to a carbon atom *2 or a carbon atom *3, and the bond *1' is bonded to a carbon atom *2' or a carbon atom *3', and

In the formula (4A), m1 represents 0 or 1.)

(II): Reaction between a compound represented by the formula (1B) and at least one of a compound represented by the formula (2A), a compound represented by the formula (3A), and a compound represented by the formula (4A).

[Chem. 31]

(In the formula (1B), $R^3$ and n1 have the same meanings as $R^3$ and n1 in the formula (1), respectively. $R^1$ and $R^2$ each independently represent a hydrogen atom, a cyano group, a phenyl group, an alkyl group having 1 to 13 carbon atoms, a halogen atom, or $-COOR^{11}$ ($R^{11}$ represents a hydrogen atom or an alkyl group having 1 to 4 carbon atoms).)

Examples of the compound represented by the formula (1A) include the following compounds.

[Chem. 32]

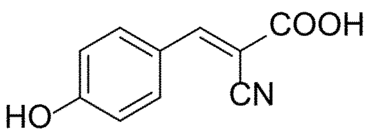

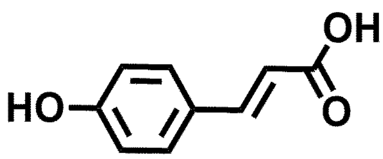

Examples of the compound represented by the formula (2A) include the following compounds.

[Chem. 33]

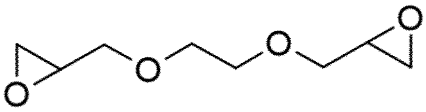
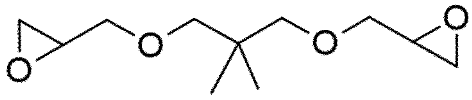
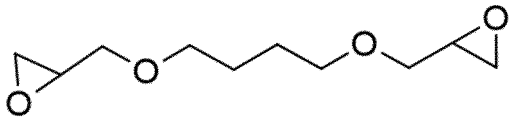
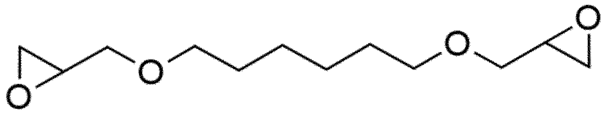
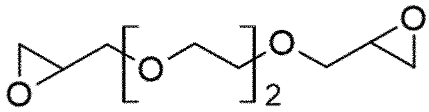
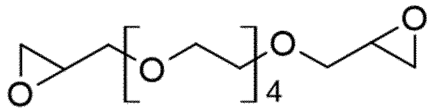
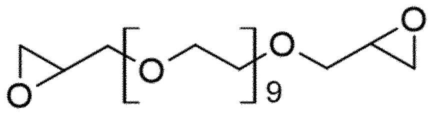
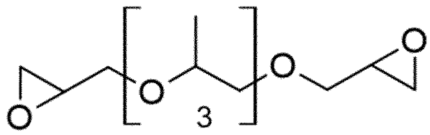

The above examples are examples when $Q^1$ is a divalent acyclic hydrocarbon group having 2 to 20 carbon atoms which may be interrupted by an oxygen atom.

[Chem. 34]

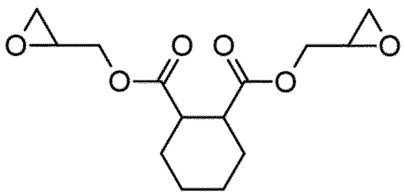
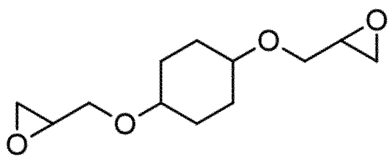
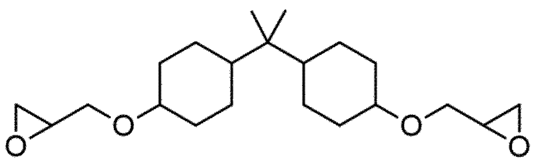
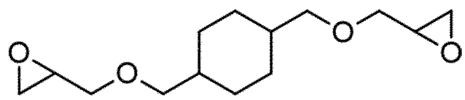

[Chem. 35]

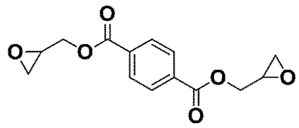 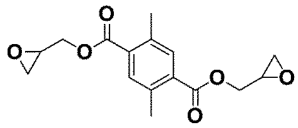 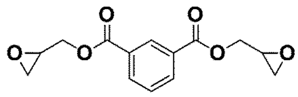 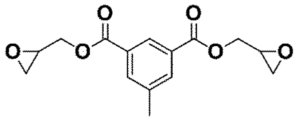

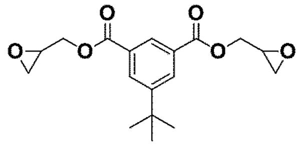 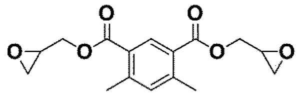 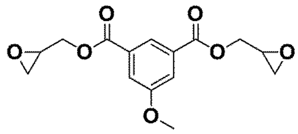 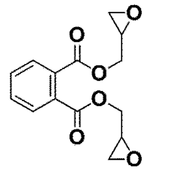

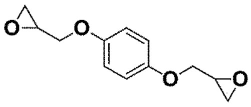 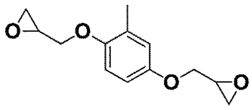 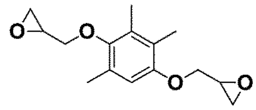 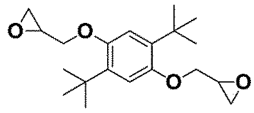

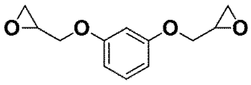 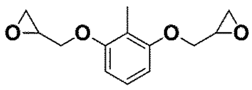 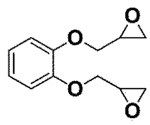 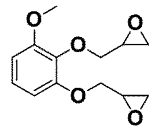

[Chem. 36]

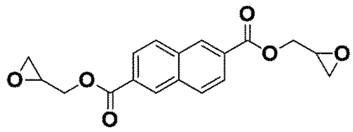 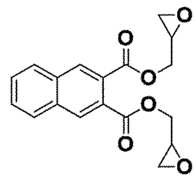 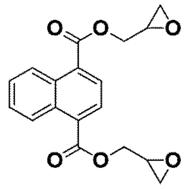 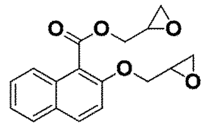

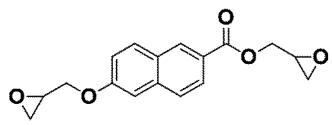 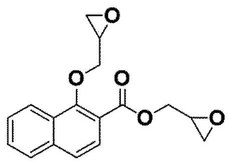 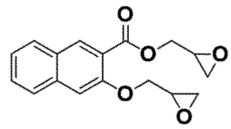 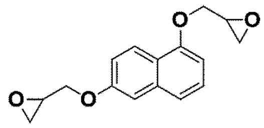

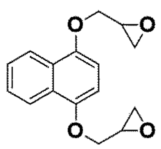 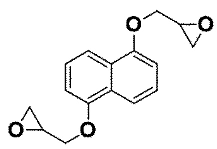 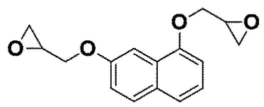 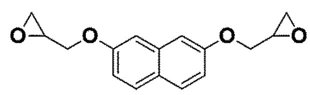

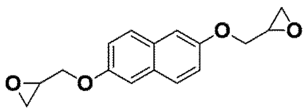 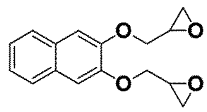

[Chem. 37]

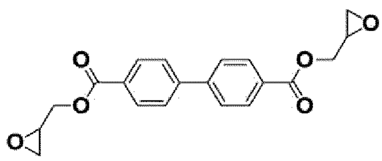
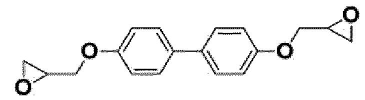
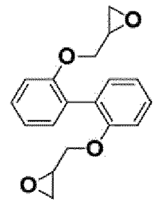
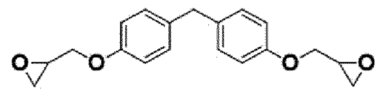
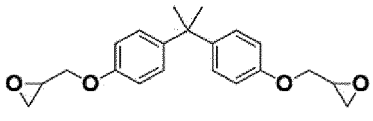
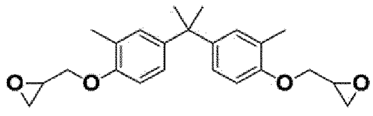
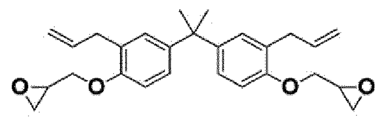
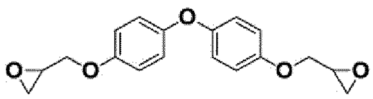
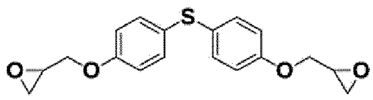
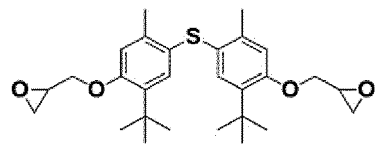
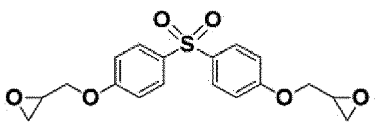
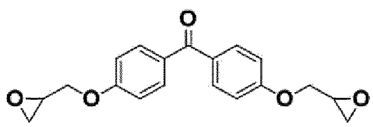
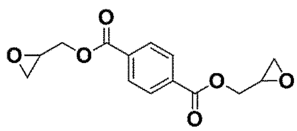
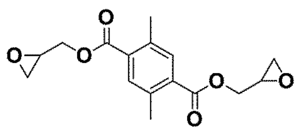
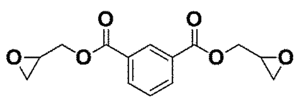
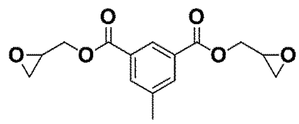
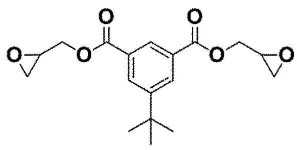
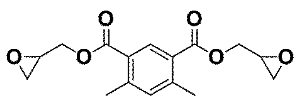
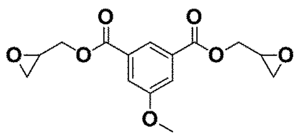
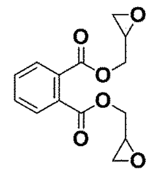
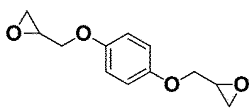
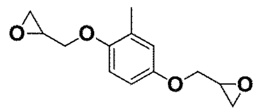
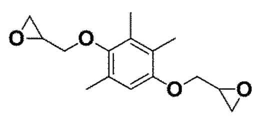
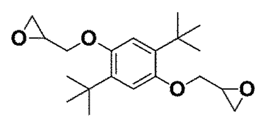
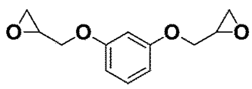
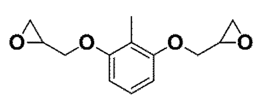
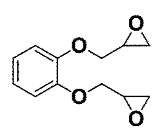
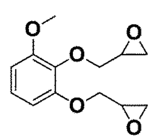

[Chem. 38]

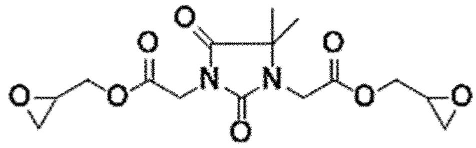

[Chem. 39]

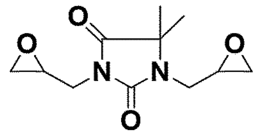

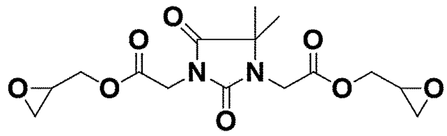

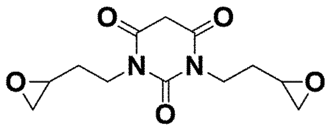

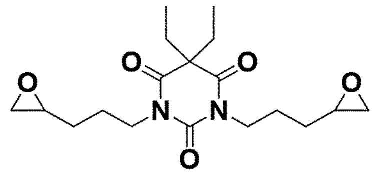

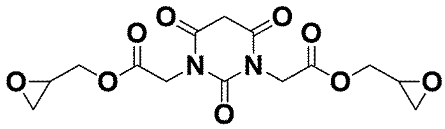

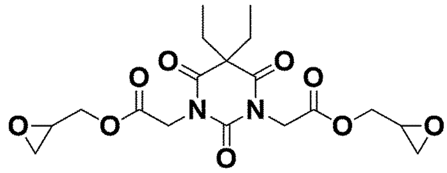

[Chem. 40]

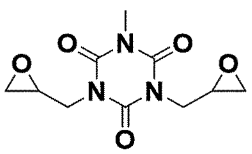

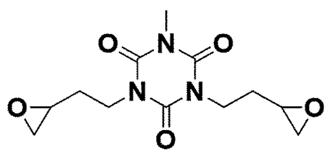

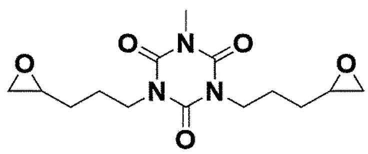

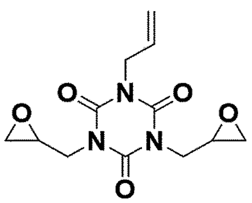

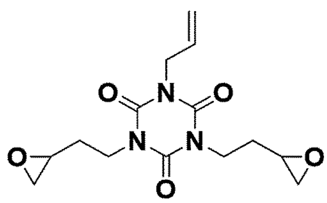

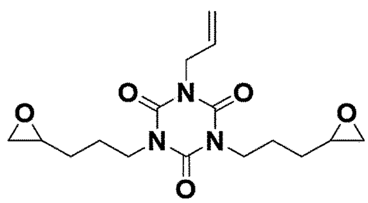

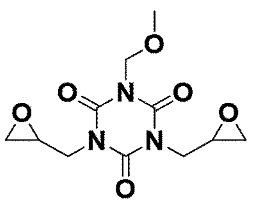

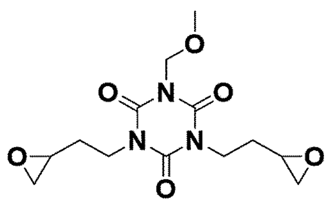

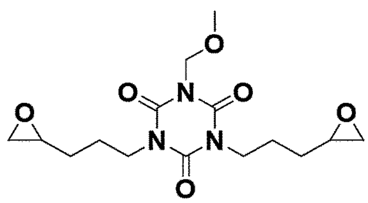

[Chem. 41]

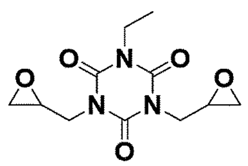

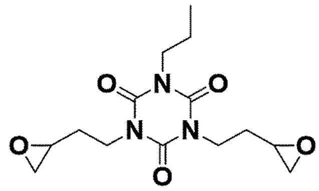

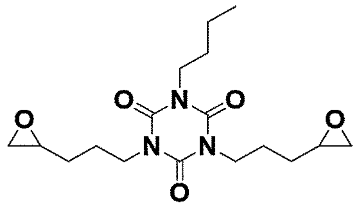

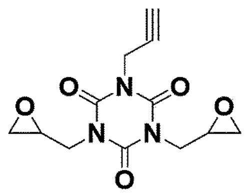

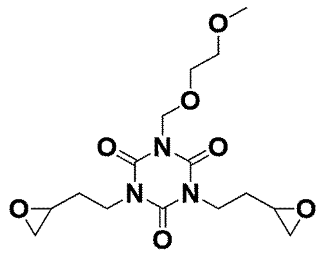

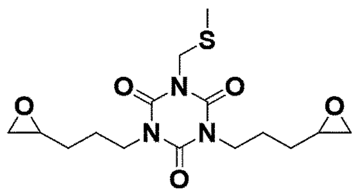

[Chem. 42]

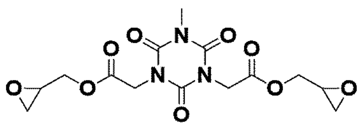

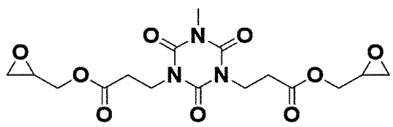

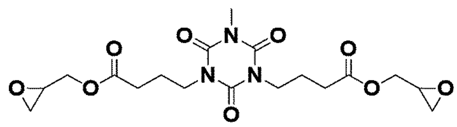

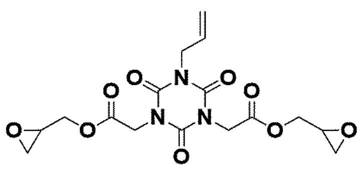

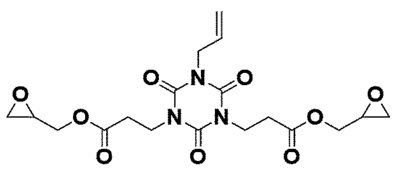

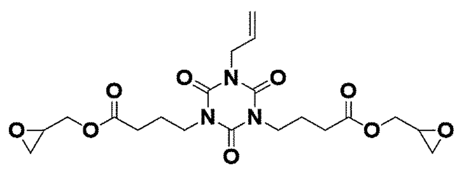

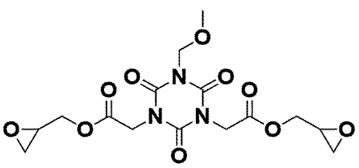

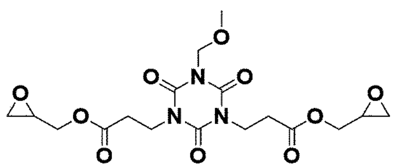

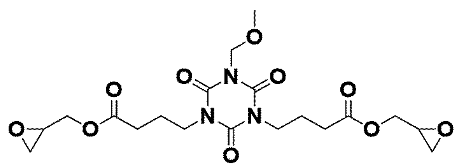

[Chem. 43]

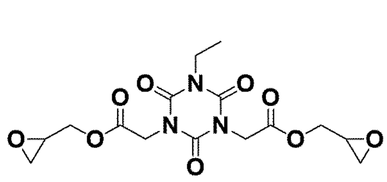
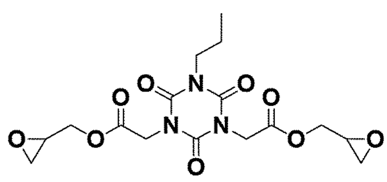
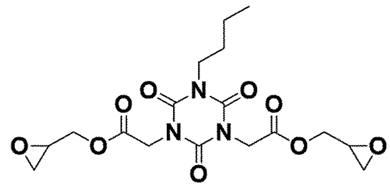
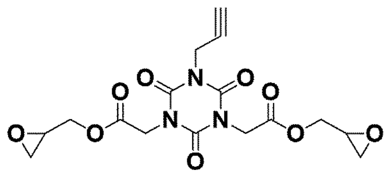
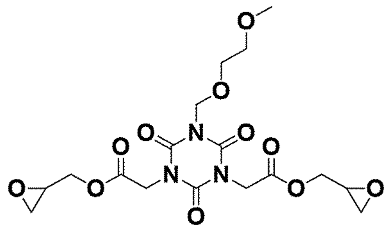
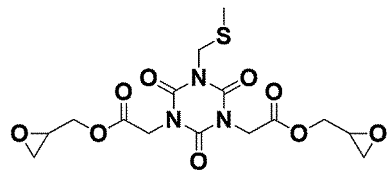

[Chem. 44]

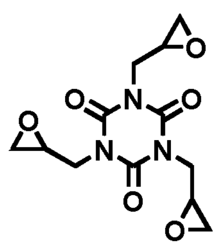
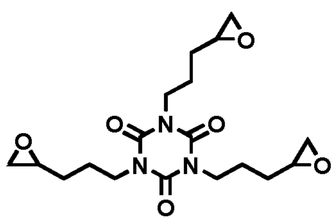
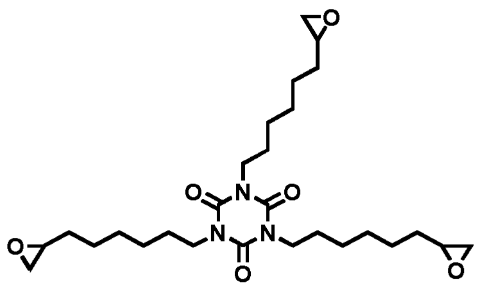
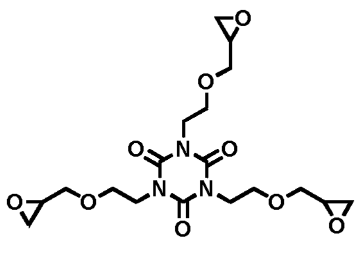
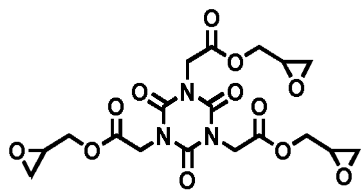
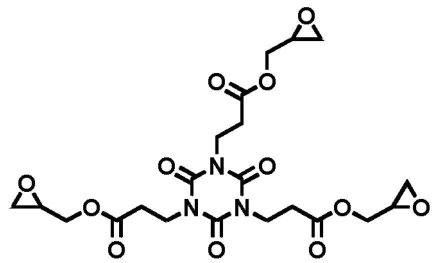
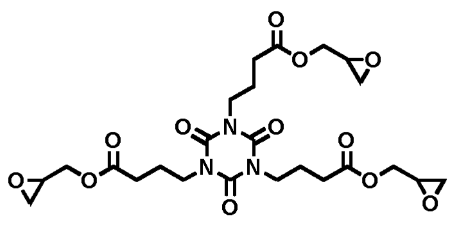
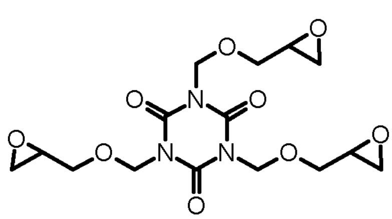

Examples of the compound represented by the formula (3A) include the following compound.

[Chem. 45]

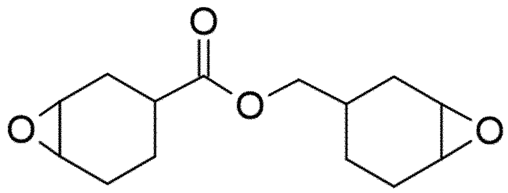

Examples of the compound represented by the formula (4A) include the following compounds.

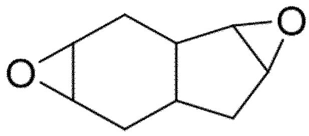

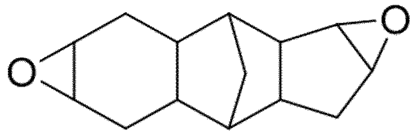

Examples of the compound represented by the formula (1B) include the following compounds.

[Chem. 46]

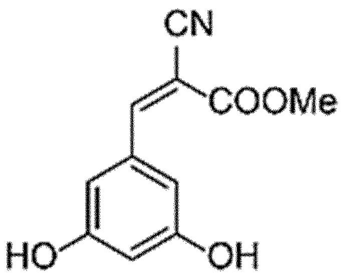

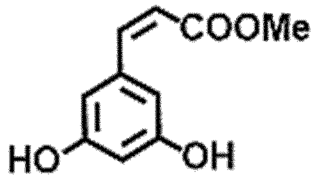

In the formula, Me represents a methyl group.

The reactions (I) to (II) may be performed, for example, in the presence of a catalyst. The catalyst is, for example, a quaternary phosphonium salt such as tetrabutylphosphonium bromide or ethyltriphenylphosphonium bromide, or a quaternary ammonium salt such as benzyltriethylammonium chloride. As the amount of the catalyst used, an appropriate amount can be selected and used from a range of 0.1 to 10 mass% with respect to the total mass of a reaction raw material used in the reaction. As the temperature and time for the reaction, for example, optimum conditions can be selected from a range of 80 to 160°C and 2 to 50 hours.

The content of the specific compound and polymer in the release agent composition is not particularly limited, but is preferably 60 mass% to 100 mass%, more preferably 70 mass% to 100 mass%, particularly preferably 80 mass% to 100 mass% with respect to the film constituent component in the release agent composition.

The film constituent components refer to components other than a solvent in the release agent composition.

<Crosslinking agent>

The release agent composition may include a crosslinking agent.

The crosslinking agent may cause a crosslinking reaction by self-condensation, but when a crosslinkable substituent is present in the specific compound and polymer, the crosslinking agent can cause a crosslinking reaction with the crosslinkable substituent.

Specific examples of the crosslinking agent are not particularly limited, but typically include phenol-based crosslinking agents, melamine-based crosslinking agents, urea-based crosslinking agents, thiourea-based crosslinking agents, and the like, each of which has a crosslinking-forming group in the molecule, such as an alkoxymethyl group (for example, a hydroxymethyl group, a methoxymethyl group, or a butoxymethyl group), and these may be low molecular weight compounds or high molecular weight compounds.

The crosslinking agent contained in the release agent composition usually has two or more crosslinking-forming groups, but from the viewpoint of achieving more suitable curing with good reproducibility, the number of crosslinking groups contained in a compound as the crosslinking agent is preferably 2 to 10, more preferably 2 to 6.

The crosslinking agent contained in the release agent composition preferably has an aromatic ring (for example, a benzene ring or a naphthalene ring) in the molecule from the viewpoint of achieving higher heat resistance, and typical examples of such a crosslinking agent include, but are not limited to, a phenol-based crosslinking agent.

The phenol-based crosslinking agent having a crosslinking-forming group is a compound having a crosslinking-forming group bonded to an aromatic ring and having at least one of a phenolic hydroxy group and an alkoxy group derived from a phenolic hydroxy group, and examples of such an alkoxy group derived from a phenolic hydroxy group include, but are not limited to, a methoxy group and a butoxy group.

Each of the aromatic ring to which the crosslinking-forming group is bonded and an aromatic ring to which the phenolic hydroxy group and/or the alkoxy group derived from a phenolic hydroxy group is bonded is not limited to a noncondensed ring type aromatic ring such as a benzene ring, and may be a condensed ring type aromatic ring such as a naphthalene ring or anthracene.

When a plurality of aromatic rings are present in the molecule of the phenol-based crosslinking agent, the crosslinking-forming group and the phenolic hydroxy group and the alkoxy group derived from a phenolic hydroxy group may be bonded to the same aromatic ring in the molecule or may be bonded to different aromatic rings.

The aromatic ring to which the crosslinking-forming group, the phenolic hydroxy group, and the alkoxy group derived from a phenolic hydroxy group are bonded may be further substituted with an alkyl group such as a methyl group, an ethyl group, or a butyl group, a hydrocarbon group such as an aryl group (for example, a phenyl group), a halogen atom such as a fluorine atom, or the like.

For example, specific examples of the phenol-based crosslinking agent having a crosslinking-forming group include compounds represented by any of the formulas (L1) to (L4).

[Chem. 47]

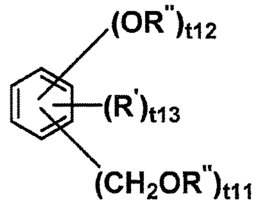

(L1)

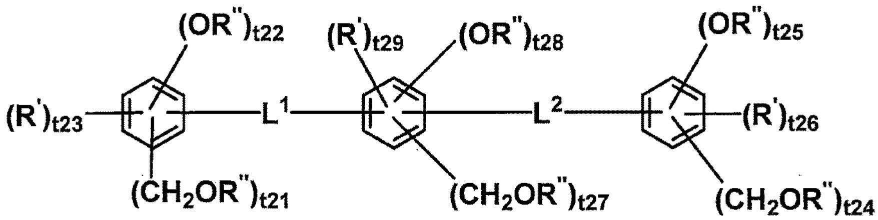

(L2)

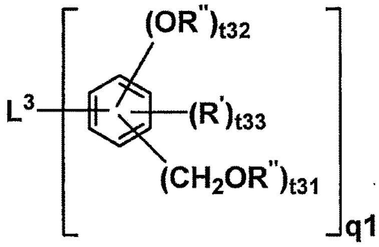

(L3)

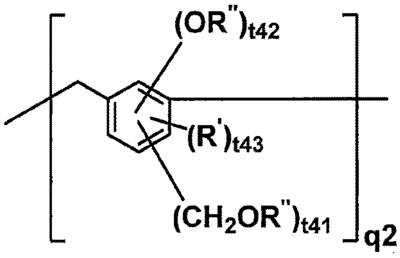

(L4)

In each formula, each R' independently represents a fluorine atom, an aryl group, or an alkyl group, each R" independently represents a hydrogen atom or an alkyl group, $L^1$ and $L^2$ each independently represent a single bond, a methylene group, or a propane-2,2-diyl group, $L^3$ is determined depending on q1 and represents a single bond, a methylene group, a propane-2,2-diyl group, a methantriyl group, or an ethane-1,1,1-triyl group, t11, t12, and t13 are integers satisfying $2 \leq t11 \leq 5$, $1 \leq t12 \leq 4$, $0 \leq t13 \leq 3$, and $t11 + t12 + t13 \leq 6$, t21, t22, and t23 are integers satisfying $2 \leq t21 \leq 4$, $1 \leq t22 \leq 3$, $0 \leq t23 \leq 2$, and $t21 + t22 + t23 \leq 5$, t24, t25, and t26 are integers satisfying $2 \leq t24 \leq 4$, $1 \leq t25 \leq 3$, $0 \leq t26 \leq 2$, and $t24 + t25 + t26 \leq 5$, t27, t28, and t29 are integers satisfying $0 \leq t27 \leq 4$, $0 \leq t28 \leq 4$, $0 \leq t29 \leq 4$, and $t27 + t28 + t29 \leq 4$, t31, t32, and t33 are integers satisfying $2 \leq t31 \leq 4$, $1 \leq t32 \leq 3$, $0 \leq t33 \leq 2$, and $t31 + t32 + t33 \leq 5$, t41, t42, and t43 are integers satisfying $2 \leq t41 \leq 3$, $1 \leq t42 \leq 2$, $0 \leq t43 \leq 1$, and $t41 + t42 + t43 \leq 4$, q1 is 2 or 3, q2 represents the number of repetitions and is an integer of 0 or more, and specific examples of the aryl group and the alkyl group include those same as the following specific examples, but the aryl group is preferably a phenyl group, and the alkyl group is preferably a methyl group or a t-butyl group.

Hereinafter, specific examples of the compounds represented by the formulas (L1) to (L4) will be given, but the

compounds are not limited thereto. Note that these compounds may be synthesized by a known method, and can also be obtained, for example, as a product of Asahi Yukizai Corporation or Honshu Chemical Industry Co., Ltd.

[Chem. 48]

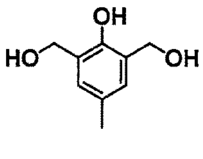
(L1)

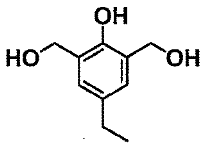
(L2)

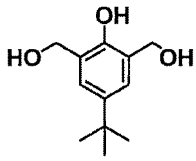
(L3)

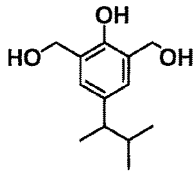
(L4)

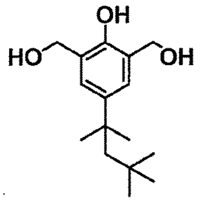
(L5)

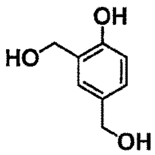
(L6)

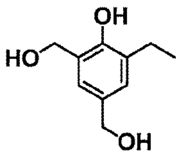
(L7)

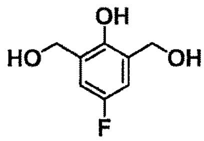
(L8)

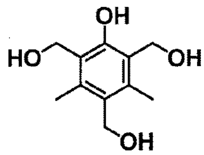
(L9)

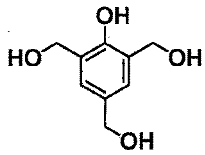
(L10)

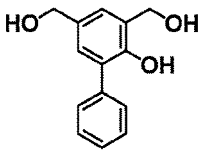
(L11)

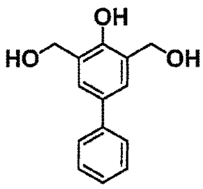
(L12)

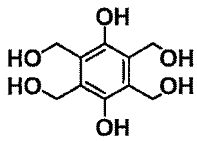
(L13)

[Chem. 49]

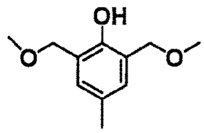
(L1M)

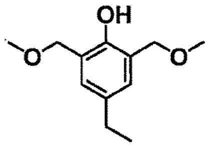
(L2M)

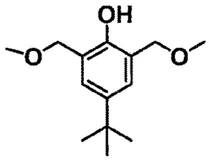
(L3M)

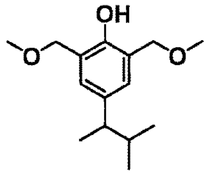
(L4M)

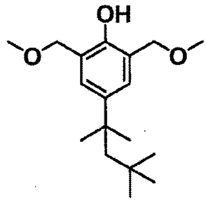
(L5M)

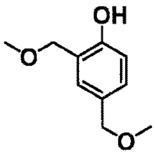
(L6M)

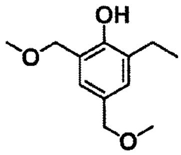
(L7M)

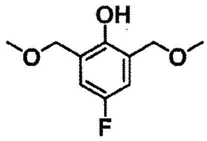
(L8M)

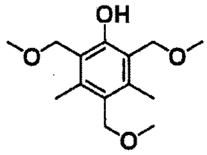
(L9M)

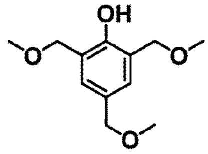
(L10M)

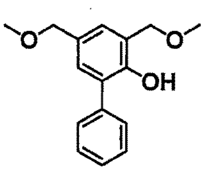
(L11M)

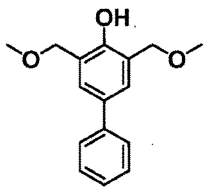
(L12M)

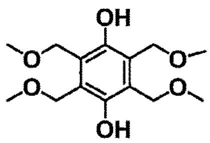
(L13M)

[Chem. 50]

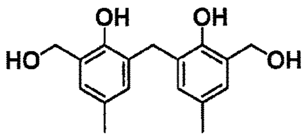
(L14)

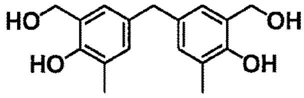
(L15)

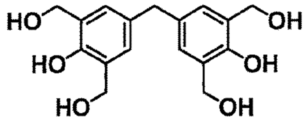
(L16)

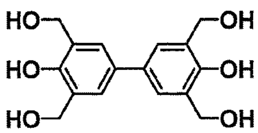
(L17)

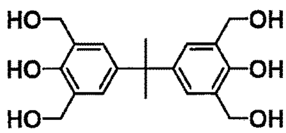
(L18)

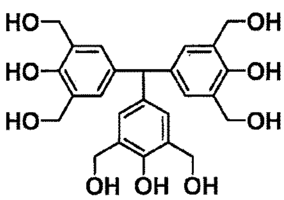
(L19)

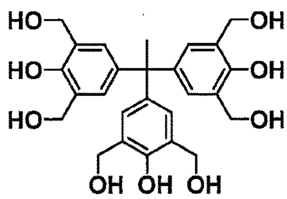
(L20)

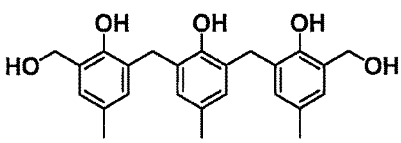
(L21)

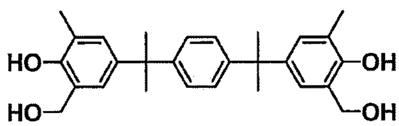
(L22)

[Chem. 51]

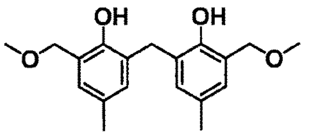

(L14M)

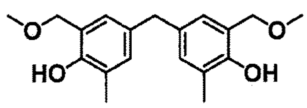

(L15M)

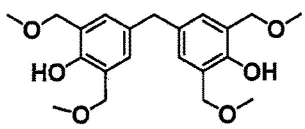

(L16M)

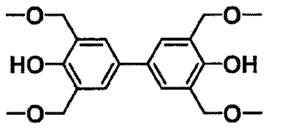

(L17M)

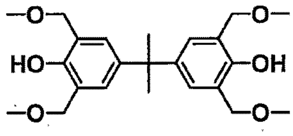

(L18M)

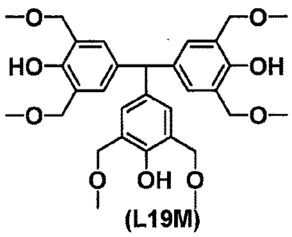

(L19M)

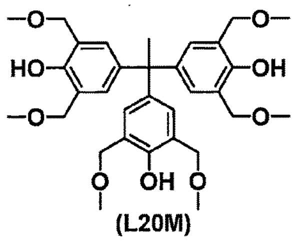

(L20M)

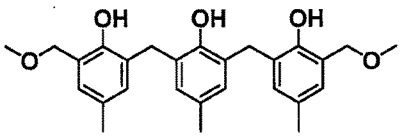

(L21M)

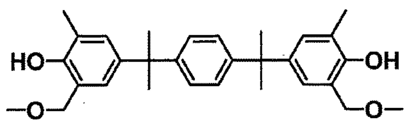

(L22M)

The melamine-based crosslinking agent having a crosslinking-forming group is a melamine derivative, a 2,4-diamino-1,3,5-triazine derivative, or a 2-amino-1,3,5-triazine derivative in which at least one of hydrogen atoms of an amino group bonded to the triazine ring is substituted with a crosslinking-forming group, and the triazine ring may further have a substituent such as an aryl group such as a phenyl group.

Specific examples of the melamine-based crosslinking agent having a crosslinking-forming group include, but are not limited to, mono-, bis-, tris-, tetrakis-, pentakis- or hexakisalkoxymethylmelamines such as N,N,N',N',N",N"-hexakis(methoxymethyl)melamine and N,N,N',N',N",N"-hexakis(butoxymethyl)melamine; and mono-, bis-, tris- or tetrakisalkoxymethylbenzoguanamines such as N,N,N',N'-tetrakis(methoxymethyl)benzoguanamine and N,N,N',N'-tetrakis(butoxymethyl)benzoguanamine.

The urea-based crosslinking agent having a crosslinking-forming group is a derivative of a urea bond-containing compound, and has a structure in which at least one of hydrogen atoms of an NH group constituting a urea bond is substituted with a crosslinking-forming group.

Specific examples of the urea-based crosslinking agent having a crosslinking-forming group include, but are not limited to, mono-, bis-, tris-, or tetrakisalkoxymethylglycolurils such as 1,3,4,6-tetrakis(methoxymethyl)glycoluril and 1,3,4,6-tetrakis(butoxymethyl)glycoluril; and mono-, bis-, tris-, or tetrakisalkoxymethylureas such as 1,3-bis(methoxymethyl)urea and 1,1,3,3-tetrakismethoxymethylurea.

The thiourea-based crosslinking agent having a crosslinking-forming group is a derivative of a thiourea bond-containing compound, and has a structure in which at least one of hydrogen atoms of an NH group constituting a thiourea bond is substituted with a crosslinking-forming group.

Specific examples of the thiourea-based crosslinking agent having a crosslinking-forming group include, but are not limited to, mono-, bis-, tris-, or tetrakisalkoxymethylthioureas such as 1,3-bis(methoxymethyl)thiourea and 1,1,3,3-tetrakismethoxymethylthiourea.

The amount of the crosslinking agent contained in the release agent composition varies depending on the coating method to be employed, the desired film thickness, and the like, and thus cannot be generally specified, but is usually 0.01 to 50 mass% with respect to the specific compound and polymer, and is preferably 0.1 mass% or more, more preferably 1 mass% or more, still more preferably 3 mass% or more, still more preferably 5 mass% or more, and preferably 45 mass% or less, more preferably 40 mass% or less, still more preferably 35 mass% or less, still more preferably 30 mass% or less from the viewpoint of achieving suitable curing and obtaining a laminate in which a semiconductor substrate or an electronic

device layer and a support substrate can be satisfactorily separated with high reproducibility.

<Acid generating agent and acid>

For the purpose of, for example, promoting the crosslinking reaction, the release agent composition may contain an acid generating agent or an acid.

Examples of the acid generating agent include a thermal acid generating agent and a photoacid generating agent.

The thermal acid generating agent is not particularly limited as long as an acid is generated by heat, and specific examples thereof include, but are not limited to, 2,4,4,6-tetrabromocyclohexadienone, benzoin tosylate, 2-nitrobenzyl tosylate, K-PURE [registered trademark] CXC-1612, CXC-1614, TAG-2172, TAG-2179, TAG-2678, TAG2689, and TAG2700 (manufactured by King Industries, Inc.), SI-45, SI-60, SI-80, SI-100, SI-110, and SI-150 (manufactured by Sanshin Chemical Industry Co., Ltd.), and other organic sulfonic acid alkyl esters.

Examples of the photoacid generating agent include an onium salt compound, a sulfonimide compound, and a disulfonyldiazomethane compound.

Specific examples of the onium salt compound include, but are not limited to, iodonium salt compounds such as diphenyliodonium hexafluorophosphate, diphenyliodonium trifluoromethanesulfonate, diphenyliodonium nonafluoronormal butanesulfonate, diphenyliodonium perfluoronormal octanesulfonate, diphenyliodonium camphor sulfonate, bis(4-tert-butylphenyl)iodonium camphor sulfonate, and bis(4-tert-butylphenyl)iodonium trifluoromethanesulfonate; and sulfonium salt compounds such as triphenylsulfonium nitrate, triphenylsulfonium hexafluoroantimonate, triphenylsulfonium nonafluoro-normal butanesulfonate, triphenylsulfonium camphorsulfonate, and triphenylsulfonium trifluoromethanesulfonate.

Specific examples of the sulfonimide compound include, but are not limited to, N-(trifluoromethanesulfonyloxy) succinimide, N-(nonafluoronormalbutanesulfonyloxy)succinimide, N-(camphorsulfonyloxy)succinimide, and N-(trifluoromethanesulfonyloxy)naphthalimide.

Specific examples of the disulfonyl diazomethane compound include, but are not limited to, bis(trifluoromethylsulfonyl)diazomethane, bis(cyclohexylsulfonyl)diazomethane, bis(phenylsulfonyl)diazomethane, bis(p-toluenesulfonyl) diazomethane, bis(2,4-dimethylbenzenesulfonyl)diazomethane, and methylsulfonyl-p-toluenesulfonyl diazomethane.

Specific examples of the acid include, but are not limited to, arylsulfonic acids and pyridinium salts such as p-toluenesulfonic acid, pyridinium p-toluenesulfonate(pyridinium paratoluenesulfonate), pyridinium trifluoromethanesulfonate, pyridinium phenolsulfonic acid, 5-sulfosalicylic acid, 4-phenolsulfonic acid, 4-chlorobenzenesulfonic acid, benzenedisulfonic acid, and 1-naphthalenesulfonic acid, and salts thereof; arylcarboxylic acids such as salicylic acid, benzoic acid, hydroxybenzoic acid, and naphthalenecarboxylic acid, and salts thereof; linear or cyclic alkylsulfonic acids such as trifluoromethanesulfonic acid and camphorsulfonic acid, and salts thereof; and linear or cyclic alkylcarboxylic acids such as citric acid, and salts thereof.

The amounts of the acid generating agent and the acid contained in the release agent composition cannot be generally specified because the amounts vary depending on the type of the crosslinking agent to be used together, the heating temperature at the time of forming the film, and the like, but are usually 0.01 to 5 mass% with respect to the film constituent component.

<Surfactant>

The release agent composition may contain a surfactant for the purpose of, for example, adjusting the liquid physical properties of the composition itself or the film physical properties of the obtained film, or preparing a highly uniform release agent composition with high reproducibility.

Examples of the surfactant may include nonionic surfactants such as polyoxyethylene alkyl ethers (for example, polyoxyethylene lauryl ether, polyoxyethylene stearyl ether, polyoxyethylene cetyl ether, and polyoxyethylene oleyl ether), polyoxyethylene alkyl allyl ethers (for example, polyoxyethylene octylphenol ether and polyoxyethylene nonylphenol ether), polyoxyethylene/polyoxypropylene block copolymers, sorbitan fatty acid esters (for example, sorbitan monolaurate, sorbitan monopalmitate, sorbitan monostearate, sorbitan monooleate, sorbitan trioleate, and sorbitan tristearate), and polyoxyethylene sorbitan fatty acid esters such as polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate, fluorine surfactants such as EFTOP EF301, EF303, and EF352 (manufactured by Tohkemy Corporation, trade name), MEGAFACE F171, F173, R-30, and R-30N (manufactured by DIC Corporation, trade name), FLUORAD FC430 and FC431 (manufactured by Sumitomo 3M Ltd., trade name), ASAHIGUARD AG710, SURFLON S-382, SC101, SC102, SC103, SC104, SC105, and SC106 (manufactured by AGC Inc., trade name), and organosiloxane polymer KP341 (manufactured by Shin-Etsu Chemical Co., Ltd.).

Surfactants can be used alone or in combination of two or more thereof.

The amount of the surfactant is usually 2 mass% or less with respect to the film constituent components of the release agent composition.

<Solvent>

The release agent composition contains a solvent.

As the solvent, for example, a highly polar solvent capable of satisfactorily dissolving the specific compound and polymer, film constituent components such as a crosslinking agent, and the like can be used, and as necessary, a low polar solvent may be used for the purpose of, for example, adjusting viscosity, surface tension, and the like. Note that in the present invention, the low polar solvent is defined as a solvent having a relative permittivity of less than 7 at a frequency of 100 kHz, and the highly polar solvent is defined as a solvent having a relative permittivity of 7 or more at a frequency of 100 kHz. The solvents can be used alone or in combination of two or more thereof.

Examples of the highly polar solvent include amide-based solvents such as N,N-dimethylformamide, N,N-dimethylacetamide, N,N-dimethylisobutyramide, N-methylpyrrolidone, and 1,3-dimethyl-2 imidazolidinone; ketone-based solvent such as ethyl methyl ketone, isophorone, or cyclohexanone; cyano-based solvents such as acetonitrile and 3-methoxypropionitrile; polyhydric alcohol-based solvent such as ethylene glycol, diethylene glycol, triethylene glycol, dipropylene glycol, 1,3-butanediol, or 2,3-butanediol; monohydric alcohol-based solvents other than aliphatic alcohols such as propylene glycol monomethyl ether, diethylene glycol monomethyl ether, diethylene glycol monophenyl ether, triethylene glycol monomethyl ether, dipropylene glycol monomethyl ether, benzyl alcohol, 2-phenoxyethanol, 2-benzyloxyethanol, 3-phenoxybenzyl alcohol, and tetrahydrofurfuryl alcohol; and sulfoxide-based solvents such as dimethyl sulfoxide.

Examples of the low polar solvent include chlorine-based solvents such as chloroform and chlorobenzene; aromatic hydrocarbon-based solvents such as alkylbenzenes (for example, toluene, xylene, tetralin, cyclohexylbenzene, and decylbenzene); aliphatic alcohol-based solvents such as 1-octanol, 1-nonanol, and 1-decanol; ether-based solvent such as tetrahydrofuran, dioxane, anisole, 4-methoxytoluene, 3-phenoxytoluene, dibenzyl ether, diethylene glycol dimethyl ether, diethylene glycol butyl methyl ether, triethylene glycol dimethyl ether, or triethylene glycol butyl methyl ether; and ester-based solvents such as methyl benzoate, ethyl benzoate, butyl benzoate, isoamyl benzoate, bis(2-ethylhexyl)phthalate, dibutyl maleate, dibutyl oxalate, hexyl acetate, propylene glycol monomethyl ether acetate, diethylene glycol monoethyl ether acetate, and diethylene glycol monobutyl ether acetate.

The content of the solvent is appropriately determined in consideration of the viscosity of the desired composition, the coating method to be adopted, the thickness of the film to be prepared, and the like, but is 99 mass% or less with respect to the entire composition, preferably 70 to 99 mass% with respect to the entire composition, more preferably 80 to 97 mass% with respect to the entire composition, that is, the amount of the film constituent component in that case is preferably 1 to 30 mass% with respect to the entire composition, more preferably 3 to 20 mass% with respect to the entire composition.

The viscosity and surface tension of the release agent composition are appropriately adjusted by changing the type of the solvent to be used, the ratio thereof, the concentration of the film constituent component, and the like in consideration of various factors such as the coating method to be used and the desired film thickness.

In an aspect of the present invention, the release agent composition contains a glycol-based solvent from the viewpoint of obtaining a highly uniform composition with good reproducibility, from the viewpoint of obtaining a highly storage-stable composition with good reproducibility, from the viewpoint of obtaining a composition that provides a highly uniform film with good reproducibility, and the like. Note that the "glycol-based solvent" as used herein is a generic term for glycols, glycol monoethers, glycol diethers, glycol monoesters, glycol diesters, and glycol ester ethers.

An example of a preferred glycol-based solvent is represented by the formula (G).

[Chem. 52]

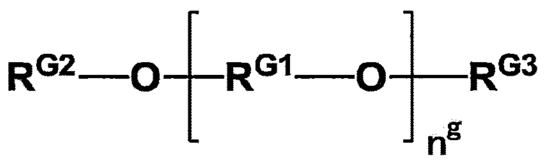

(G)

In the formula (G), $R^{G1}$ each independently represents a linear or branched alkylene group having 2 to 4 carbon atoms, $R^{G2}$ and $R^{G3}$ each independently represent a hydrogen atom, a linear or branched alkyl group having 1 to 8 carbon atoms, or an alkylacyl group in which the alkyl moiety is a linear or branched alkyl group having 1 to 8 carbon atoms, and $n^g$ is an integer of 1 to 6.

Specific examples of the linear or branched alkylene group having 2 to 4 carbon atoms include, but are not limited to, an ethylene group, a trimethylene group, a 1-methylethylene group, a tetramethylene group, a 2-methylpropane-1,3-diyl group, a pentamethylene group, and a hexamethylene group.

Among them, a linear or branched alkylene group having 2 to 3 carbon atoms is preferable, and a linear or branched alkylene group having 3 carbon atoms is more preferable from the viewpoint of obtaining a highly uniform composition with good reproducibility, from the viewpoint of obtaining a highly storage-stable composition with good reproducibility, from the viewpoint of obtaining a composition that provides a highly uniform film with good reproducibility, and the like.

Specific examples of the linear or branched alkyl group having 1 to 8 carbon atoms include, but are not limited to, a methyl group, an ethyl group, an n-propyl group, an i-propyl group, an n-butyl group, an i-butyl group, an s-butyl group, a tertiary butyl group, an n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, an n-hexyl, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, and a 1-ethyl-2-methyl-n-propyl group.

Among them, a methyl group and an ethyl group are preferable, and a methyl group is more preferable from the viewpoint of obtaining a highly uniform composition with good reproducibility, from the viewpoint of obtaining a highly storage-stable composition with good reproducibility, from the viewpoint of obtaining a composition that provides a highly uniform film with good reproducibility, and the like.

Specific examples of the linear or branched alkyl group having 1 to 8 carbon atoms in the alkylacyl group in which the alkyl moiety is a linear or branched alkyl group having 1 to 8 carbon atoms include the same as the specific examples described above.

Among them, a methylcarbonyl group and an ethylcarbonyl group are preferable, and a methylcarbonyl group is more preferable from the viewpoint of obtaining a highly uniform composition with good reproducibility, from the viewpoint of obtaining a highly storage-stable composition with good reproducibility, from the viewpoint of obtaining a composition that provides a highly uniform film with good reproducibility, and the like.

$n^g$ is preferably 4 or less, more preferably 3 or less, still more preferably 2 or less, most preferably 1 from the viewpoint of obtaining a highly uniform composition with good reproducibility, from the viewpoint of obtaining a highly storage-stable composition with good reproducibility, from the viewpoint of obtaining a composition that provides a highly uniform film with good reproducibility, and the like.

In the formula (G), preferably, at least one of $R^{G2}$ and $R^{G3}$ is a linear or branched alkyl group having 1 to 8 carbon atoms, more preferably, one of $R^{G2}$ and $R^{G3}$ is a linear or branched alkyl group having 1 to 8 carbon atoms, and the other is an alkylacyl group in which the hydrogen atom or the alkyl moiety is a linear or branched alkyl group having 1 to 8 carbon atoms from the viewpoint of obtaining a highly uniform composition with good reproducibility, from the viewpoint of obtaining a highly storage-stable composition with good reproducibility, from the viewpoint of obtaining a composition that provides a highly uniform film with good reproducibility, and the like.

The content of the glycol-based solvent is preferably 50 mass% or more, more preferably 70 mass% or more, still more preferably 80 mass% or more, still more preferably 90 mass% or more, still more preferably 95 mass% or more with respect to the solvent contained in the release agent composition from the viewpoint of obtaining a highly uniform composition with good reproducibility, from the viewpoint of obtaining a highly storage-stable composition with good reproducibility, from the viewpoint of obtaining a composition that provides a highly uniform film with good reproducibility, and the like.

In the release agent composition, the film constituent component is uniformly dispersed or dissolved, preferably dissolved in the solvent from the viewpoint of obtaining a highly uniform composition with good reproducibility, from the viewpoint of obtaining a highly storage-stable composition with good reproducibility, from the viewpoint of obtaining a composition that provides a highly uniform film with good reproducibility, and the like.

In the present invention, for the purpose of removing foreign matter, a solvent, a solution, or the like to be used may be filtered using a filter or the like during the production of the release agent composition or after mixing all the components.

(Laminate)

The laminate according to the present invention includes a semiconductor substrate or an electronic device layer, a support substrate, and a release agent layer for release by irradiation with light.

The laminate according to the present invention preferably further includes an adhesive layer, and includes a semiconductor substrate or an electronic device layer, a support substrate, a release agent layer for release by irradiation with light, and an adhesive layer.

Note that when the release agent layer according to the present invention is formed to have not only a release function of releasing the semiconductor substrate or the electronic device layer from the support substrate by irradiation with light but also an adhesion function of adhering the semiconductor substrate or the electronic device layer to the support substrate (that is, when the release agent layer is formed using a release agent composition containing a component that exhibits both functions), the laminate may be formed not in a two-layer structure of the release agent layer and the adhesive layer but in a one-layer structure of the release agent layer having adhesive performance.

The support substrate has light transmissivity.

The release agent layer for release by irradiation with light is provided between the semiconductor substrate or the electronic device layer and the support substrate.

The laminate is used for release of the semiconductor substrate or the electronic device layer from the support substrate after the release agent layer absorbs light emitted from the support substrate side.

The release agent layer for release by irradiation with light is a layer formed of the release agent composition for release by irradiation with light of the present invention described above.

The laminate of the present invention is used for temporary adhesion for processing the semiconductor substrate or the electronic device layer, and can be suitably used for processing such as thinning of the semiconductor substrate or the electronic device layer.

While the semiconductor substrate is subjected to processing such as thinning, the semiconductor substrate is supported by the support substrate. On the other hand, after the processing of the semiconductor substrate, the release agent layer is irradiated with light, and thereafter, the support substrate and the semiconductor substrate are separated from each other. Due to the specific compound and polymer contained in the release agent composition, in the release agent layer formed of the release agent composition, the specific compound and polymer absorb light (for example, laser light) to alter (for example, separate or decompose) the release agent layer. As a result, after the release agent layer is irradiated with light, the semiconductor substrate is easily released from the support substrate.

In addition, while the electronic device layer is subjected to processing such as thinning, the electronic device layer is supported by the support substrate. On the other hand, after the processing of the electronic device layer, the release agent layer is irradiated with light, and thereafter, the support substrate and the electronic device layer are separated from each other.

Owing to the release agent layer according to the present invention, the semiconductor substrate or the electronic device layer is easily released from the support substrate after being irradiated with light. Furthermore, after the semiconductor substrate or the electronic device layer is released from the support substrate, residues of the release agent layer or the adhesive layer remaining on the semiconductor substrate, the electronic device layer, or the support substrate can be removed by, for example, a cleaning agent composition for cleaning the semiconductor substrate and the like.

The wavelength of light used for release is preferably, for example, a wavelength of 250 to 600 nm, more preferably a wavelength of 250 to 370 nm. A more suitable wavelength is 308 nm, 343 nm, 355 nm, 365 nm, or 532 nm. The irradiation amount of light required for release is an irradiation amount that can cause suitable alteration, for example, decomposition of the specific compound and polymer.

The light used for release may be laser light or non-laser light emitted from a light source such as an ultraviolet lamp.

Hereinafter, a case where the laminate includes a semiconductor substrate and a case where the laminate includes an electronic device layer will be described in detail separately.

The case where the laminate includes a semiconductor substrate will be described in the following <First embodiment>, and the case where the laminate includes an electronic device layer will be described in the following

<Second embodiment>.

<First embodiment>

The laminate having a semiconductor substrate is used for processing the semiconductor substrate. While the semiconductor substrate is processed, the semiconductor substrate is adhered to the support substrate. After processing the semiconductor substrate, the release agent layer is irradiated with light, and then the semiconductor substrate is separated from the support substrate.

<<Semiconductor substrate>>

The main material constituting the entire semiconductor substrate is not particularly limited as long as the material is used for this type of application, and examples thereof include silicon, silicon carbide, and a compound semiconductor.

The shape of the semiconductor substrate is not particularly limited, and is, for example, a disk shape. Note that the disk-shaped semiconductor substrate does not need to have a completely circular surface, and for example, the outer periphery of the semiconductor substrate may have a linear portion called an orientation flat or may have a cut called a notch.

The thickness of the disk-shaped semiconductor substrate may be appropriately determined depending on the purpose of use of the semiconductor substrate and the like, and is not particularly limited, but is, for example, 500 to 1,000 μm.

The diameter of the disk-shaped semiconductor substrate may be appropriately determined depending on the purpose of use of the semiconductor substrate and the like, and is not particularly limited, but is, for example, 100 to 1,000 mm.

The semiconductor substrate may have a bump. The bump is a protruding terminal.

In the laminate, when the semiconductor substrate has a bump, the semiconductor substrate has the bump on the support substrate side.

In the semiconductor substrate, the bump is usually formed on a surface on which a circuit is formed. The circuit may be a single layer or a multilayer. The shape of the circuit is not particularly limited.

In the semiconductor substrate, a surface (back surface) opposite to the surface having the bump is a surface to be processed.

The material, size, shape, structure, and density of the bump of the semiconductor substrate are not particularly limited.

Examples of the bump include a ball bump, a print bump, a stud bump, and a plating bump.

Usually, the height, radius, and pitch of the bump are appropriately determined from the conditions of a bump height of approximately 1 to 200 μm, a bump radius of 1 to 200 μm, and a bump pitch of 1 to 500 μm.

Examples of the material of the bump include low melting point solder, high melting point solder, tin, indium, gold, silver, and copper. The bump may be composed of only a single component or may be composed of a plurality of components. More specific examples thereof include alloy plate mainly containing Sn, such as SnAg bumps, SnBi bumps, Sn bumps, and AuSn bumps.

In addition, the bump may have a laminated structure including a metal layer made of at least one of these components.

An example of the semiconductor substrate is a silicon wafer having a diameter of about 300 mm and a thickness of about 770 μm.

<<Support substrate>>

The support substrate is not particularly limited as long as the support substrate is a member that is light-transmissive to light emitted to the release agent layer and can support the semiconductor substrate when the semiconductor substrate is processed, and examples thereof include a glass support substrate.

The shape of the support substrate is not particularly limited, and examples thereof include a disk shape.

The thickness of the disk-shaped support substrate may be appropriately determined depending on the size of the semiconductor substrate and the like, and is not particularly limited, but is, for example, 500 to 1,000 μm.

The diameter of the disk-shaped support substrate may be appropriately determined depending on the size of the semiconductor substrate and the like, and is not particularly limited, but is, for example, 100 to 1,000 mm.

An example of the support substrate is a glass wafer having a diameter of about 300 mm and a thickness of about 700 μm.

<<Release agent layer>>

The release agent layer is a layer formed of a release agent composition.

The release agent layer is provided between the semiconductor substrate and the support substrate.

The release agent layer may be in contact with the support substrate or may be in contact with the semiconductor substrate.

The release agent layer is formed using the release agent composition for release by irradiation with light of the present invention described above.

The release agent composition of the present invention can be suitably used for forming the release agent layer of a laminate including a semiconductor substrate, a support substrate, and a release agent layer provided between the semiconductor substrate and the support substrate. The laminate is used for release of the semiconductor substrate from the support substrate after the release agent layer absorbs light emitted from the support substrate side.

One of the characteristics of the release agent layer obtained from the release agent composition of the present invention is that the semiconductor substrate can be easily released from the support substrate after irradiation with light.

In forming the release agent layer from the release agent composition, as long as the effect of the present invention is obtained, the specific compound and polymer may be crosslinked by itself or react with other components to form a crosslinked structure, or may maintain the structure without crosslinking or reacting.

In other words, in the release agent layer, the specific compound and polymer may be crosslinked by itself or react with other components to form a crosslinked structure, or may exist while maintaining the structure.

The thickness of the release agent layer is not particularly limited, but is usually 0.01 to 10 μm, and is preferably 0.05 μm or more, more preferably 0.1 μm or more, still more preferably 0.2 μm or more from the viewpoint of maintaining the film strength, and is preferably 10 μm or less, more preferably 8 μm or less, still more preferably 5 μm or less, still more preferably 2 μm or less from the viewpoint of avoiding nonuniformity caused by a thick film.

The method for forming the release agent layer from the release agent composition will be described in detail in the description of <<Method for producing one example of laminate in first embodiment>> described below.

<<Adhesive layer>>

The adhesive layer is provided between the support substrate and the semiconductor substrate.

The adhesive layer is in contact with, for example, the semiconductor substrate. The adhesive layer may be in contact with, for example, the support substrate.

The adhesive layer is not particularly limited, but is preferably a layer formed of an adhesive composition.

<<Adhesive composition>>

Examples of the adhesive composition include, but are not limited to, a polysiloxane-based adhesive, an acrylic resin-based adhesive, an epoxy resin-based adhesive, a polyamide-based adhesive, a polystyrene-based adhesive, a polyimide adhesive, and a phenol resin-based adhesive.

Among them, a polysiloxane-based adhesive is preferable as the adhesive composition because the adhesive composition exhibits suitable adhesive function during processing of the semiconductor substrate or the like, can be suitably released after processing, is further excellent in heat resistance, and can be suitably removed by the cleaning agent composition.

In a preferred aspect, the adhesive composition contains a polyorganosiloxane.

In another preferred aspect, the adhesive composition contains a component that cures by a hydrosilylation reaction.

For example, the adhesive composition used in the present invention contains a curable component (A) to be an adhesive component. The adhesive composition used in the present invention may contain a component (A) to be cured to be an adhesive component and a component (B) that does not cause a curing reaction. Here, examples of the component (B) that does not cause a curing reaction include a polyorganosiloxane. Note that in the present invention, the wording "does not cause a curing reaction" does not mean not causing any curing reaction, but means not causing a curing reaction occurring in the curable component (A).

In a preferred aspect, the component (A) may be a component to be cured by a hydrosilylation reaction or a polyorganosiloxane component (A') to be cured by a hydrosilylation reaction.

In another preferred aspect, the component (A) contains, for example, as an example of the component (A'), a polyorganosiloxane (a1) having an alkenyl group having 2 to 40 carbon atoms bonded to a silicon atom, a polyorganosiloxane (a2) having an Si-H group, and a platinum group metal-based catalyst (A2). Here, the alkenyl group having 2 to 40 carbon atoms may be substituted. Examples of the substituent include a halogen atom, a nitro group, a cyano group, an amino group, a hydroxy group, a carboxyl group, an aryl group, and a heteroaryl group.

In another preferred aspect, the polyorganosiloxane component (A') to be cured by a hydrosilylation reaction includes a polysiloxane (A1) containing one or two or more units selected from the group consisting of a siloxane unit (Q unit) represented by $SiO_2$, a siloxane unit (M unit) represented by $R^1R^2R^3SiO_{1/2}$, a siloxane unit (D unit) represented by $R^4R^5SiO_{2/2}$, and a siloxane unit (T unit) represented by $R^6SiO_{3/2}$, and a platinum group metal-based catalyst (A2), wherein the polysiloxane (A1) includes: a polyorganosiloxane (a1') containing one or two or more units selected from the group consisting of a siloxane unit (Q' unit) represented by $SiO_2$, a siloxane unit (M' unit) represented by $R^{1'}R^{2'}R^{3'}SiO_{1/2}$, a siloxane unit (D' unit) represented by $R^{4'}R^{5'}SiO_{2/2}$, and a siloxane unit (T' unit) represented by $R^{6'}SiO_{3/2}$, and also containing at least one selected from the group consisting of the M' unit, the D' unit, and the T' unit; and a polyorganosiloxane (a2') containing one or two or more units selected from the group consisting of a siloxane unit (Q" unit) represented by $SiO_2$, a siloxane unit (M" unit) represented by $R^{1''}R^{2''}R^{3''}SiO_{1/2}$, a siloxane unit (D" unit) represented by $R^{4''}R^{5''}SiO_{2/2}$, and a siloxane unit (T" unit) represented by $R^{6''}SiO_{3/2}$, and also containing at least one selected from the group consisting of the M" unit, the D" unit, and the T" unit.

Note that (a1') is an example of (a1), and (a2') is an example of (a2).

$R^1$ to $R^6$ are groups or atoms bonded to a silicon atom, and each independently represent an optionally

substituted alkyl group, an optionally substituted alkenyl group, or a hydrogen atom. Examples of the substituent include a halogen atom, a nitro group, a cyano group, an amino group, a hydroxy group, a carboxyl group, an aryl group, and a heteroaryl group.

$R^{1'}$ to $R^{6'}$ are groups bonded to a silicon atom and each independently represent an optionally substituted alkyl group or an optionally substituted alkenyl group, provided that at least one of $R^{1'}$ to $R^{6'}$ is an optionally substituted alkenyl group. Examples of the substituent include a halogen atom, a nitro group, a cyano group, an amino group, a hydroxy group, a carboxyl group, an aryl group, and a heteroaryl group.

$R^{1''}$ to $R^{6''}$ are groups or atoms bonded to a silicon atom, and each independently represent an optionally substituted alkyl group or a hydrogen atom, provided that at least one of $R^{1''}$ to $R^{6''}$ is a hydrogen atom. Examples of the substituent include a halogen atom, a nitro group, a cyano group, an amino group, a hydroxy group, a carboxyl group, an aryl group, and a heteroaryl group.

The alkyl group may be linear, branched, or cyclic, but is preferably a linear or branched alkyl group, and the number of carbon atoms thereof is not particularly limited, but is usually 1 to 40, preferably 30 or less, more preferably 20 or less, still more preferably 10 or less.

Specific examples of the optionally substituted linear or branched alkyl group include, but are not limited to, a methyl group, an ethyl group, an n-propyl group, an i-propyl group, an n-butyl group, an i-butyl group, an s-butyl group, a tertiary butyl group, an n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, an n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, and a 1-ethyl-2-methyl-n-propyl group, and the number of carbon atoms thereof is usually 1 to 14, preferably 1 to 10, more preferably 1 to 6. Among them, a methyl group is particularly preferable.

Specific examples of the optionally substituted cyclic alkyl group include, but are not limited to, a cycloalkyl group such as a cyclopropyl group, a cyclobutyl group, a 1-methyl-cyclopropyl group, a 2-methyl-cyclopropyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, and a 2-ethyl-3-methyl-cyclopropyl group; and a bicycloalkyl group such as a bicyclobutyl group, a bicyclopentyl group, a bicyclohexyl group, a bicycloheptyl group, a bicyclooctyl group, a bicyclononyl group, and a bicyclodecyl group, and the number of carbon atoms thereof is usually 3 to 14, preferably 4 to 10, more preferably 5 to 6.

The alkenyl group may be linear or branched, and the number of carbon atoms thereof is not particularly limited, but is usually 2 to 40, preferably 30 or less, more preferably 20 or less, still more preferably 10 or less.

Specific examples of the optionally substituted linear or branched alkenyl group include, but are not limited to, a vinyl group, an allyl group, a butenyl group, and a pentenyl group, and the number of carbon atoms thereof is usually 2 to 14, preferably 2 to 10, more preferably 1 to 6. Among them, an ethenyl group and a 2-propenyl group are particularly preferable.

Specific examples of the optionally substituted cyclic alkenyl group include, but are not limited to, cyclopentenyl and cyclohexenyl, and the number of carbon atoms thereof is usually 4 to 14, preferably 5 to 10, more preferably 5 to 6.

As described above, the polysiloxane (A1) contains a polyorganosiloxane (a1') and a polyorganosiloxane (a2'), and an alkenyl group contained in the polyorganosiloxane (a1') and a hydrogen atom (Si-H group) contained in the polyorganosiloxane (a2') form a crosslinked structure by a hydrosilylation reaction by the platinum group metal-based catalyst (A2) and are cured. As a result, a cured film is formed.

The polyorganosiloxane (a1') contains one or two or more units selected from the group consisting of a Q' unit, an M' unit, a D' unit, and a T' unit, and contains at least one selected from the group consisting of an M' unit, a D' unit, and a T' unit. As the polyorganosiloxane (a1'), two or more types of polyorganosiloxanes satisfying such conditions may be used in combination.

Examples of preferred combinations of two or more types selected from the group consisting of a Q' unit, an M' unit, a D' unit, and a T' unit include, but are not limited to, (Q' unit and M' unit), (D' unit and M' unit), (T' unit and M' unit), and (Q' unit, T' unit, and M' unit).

In addition, when two or more types of polyorganosiloxanes included in the polyorganosiloxane (a1') are

contained, a combination of (Q' unit and M' unit) and (D' unit and M' unit), a combination of (T' unit and M' unit) and (D' unit and M' unit), and a combination of (Q' unit, T' unit, and M' unit) and (T' unit and M' unit) are preferable, but the combinations are not limited thereto.

The polyorganosiloxane (a2') contains one or two or more units selected from the group consisting of a Q" unit, an M" unit, a D" unit, and a T" unit, and contains at least one selected from the group consisting of an M" unit, a D" unit, and a T" unit. As the polyorganosiloxane (a2'), two or more types of polyorganosiloxanes satisfying such conditions may be used in combination.

Examples of preferred combinations of two or more selected from the group consisting of a Q" unit, an M" unit, a D" unit, and a T" unit include, but are not limited to, (M" unit and D" unit), (Q" unit and M" unit), and (Q" unit, T" unit, and M" unit).

The polyorganosiloxane (a1') is composed of siloxane units in which alkyl groups and/or alkenyl groups are bonded to silicon atoms of the polyorganosiloxane (a1'), and the proportion of alkenyl groups in all substituents represented by $R^{1'}$ to $R^{6'}$ is preferably 0.1 to 50.0 mol%, more preferably 0.5 to 30.0 mol%, and the remaining $R^{1'}$ to $R^{6'}$ can be alkyl groups.

The polyorganosiloxane (a2') is composed of siloxane units in which alkyl groups and/or hydrogen atoms are bonded to silicon atoms of the polyorganosiloxane (a2'), and the proportion of hydrogen atoms in all substituents and substitutional atoms represented by $R^{1"}$ to $R^{6"}$ is preferably 0.1 to 50.0 mol%, more preferably 10.0 to 40.0 mol%, and the remaining $R^{1"}$ to $R^{6"}$ can be alkyl groups.

When the component (A) contains (a1) and (a2), in a preferred aspect of the present invention, the molar ratio of the alkenyl group contained in the polyorganosiloxane (a1) and the hydrogen atom constituting the Si-H bond contained in the polyorganosiloxane (a2) is in the range of 1.0 : 0.5 to 1.0 : 0.66.

The weight average molecular weight of the polysiloxane such as the polyorganosiloxane (a1) or the polyorganosiloxane (a2) is not particularly limited, but each is typically 500 to 1,000,000, and is preferably 5,000 to 50,000 from the viewpoint of achieving the effects of the present invention with good reproducibility.

Note that in the present invention, the weight average molecular weight, the number average molecular weight, and the dispersibility of the polyorganosiloxane (excluding the organosiloxane polymer) can be measured, for example, using a GPC apparatus (EcoSEC, HLC-8320GPC manufactured by Tosoh Corporation) and a GPC column (TSKgel SuperMultiporeHZ-N and TSKgel SuperMultiporeHZ-H manufactured by Tosoh Corporation), at a column temperature of 40°C, using tetrahydrofuran as an eluent (eluent solvent), at a flow rate of 0.35 mL/min, and using polystyrene (Shodex manufactured by Showa Denko K.K.) as a standard sample.

The viscosity of the polyorganosiloxane (a1) and the polyorganosiloxane (a2) is not particularly limited, but each is usually 10 to 1,000,000 (mPa·s), and is preferably 50 to 10,000 (mPa·s) from the viewpoint of achieving the effects of the present invention with good reproducibility. The viscosity of the polyorganosiloxane (a1) and the polyorganosiloxane (a2) are values measured with an E-type rotational viscometer at 25°C.

The polyorganosiloxane (a1) and the polyorganosiloxane (a2) react with each other by a hydrosilylation reaction to form a film. Accordingly, the mechanism of curing is different from a mechanism, for example, through silanol groups, and therefore, any siloxane does not need to contain a silanol group or a functional group that forms a silanol group by hydrolysis, such as an alkyloxy group.

In a preferred aspect of the present invention, the adhesive composition contains a platinum group metal-based catalyst (A2) together with the polyorganosiloxane component (A').

Such a platinum-based metal catalyst is a catalyst for promoting the hydrosilylation reaction between the alkenyl group of the polyorganosiloxane (a1) and the Si-H group of the polyorganosiloxane (a2).

Specific examples of the platinum-based metal catalyst include, but are not limited to, platinum-based catalysts such as platinum black, second platinum chloride, chloroplatinic acid, a reaction product of chloroplatinic acid and monohydric alcohol, a complex of chloroplatinic acid and olefins, and platinum bisacetoacetate.

Examples of the complex of platinum and olefins include, but are not limited to, a complex of divinyltetramethyldisiloxane and platinum.

The amount of the platinum group metal-based catalyst (A2) is not particularly limited, but is usually in the range of 1.0 to 50.0 ppm with respect to the total amount of the polyorganosiloxane (a1) and the polyorganosiloxane (a2).

The polyorganosiloxane component (A') may contain a polymerization inhibitor (A3) for the purpose of suppressing the progress of the hydrosilylation reaction.

The polymerization inhibitor is not particularly limited as long as the polymerization inhibitor can suppress the progress of the hydrosilylation reaction, and specific examples thereof include alkynyl alcohols such as 1-ethynyl-1-cyclohexanol and 1,1-diphenyl-2-propion-1-ol.

The amount of the polymerization inhibitor is not particularly limited, but is usually 1,000.0 ppm or more with respect to the total amount of the polyorganosiloxane (a1) and the polyorganosiloxane (a2) from the viewpoint of obtaining the effect, and is 10,000.0 ppm or less from the viewpoint of preventing excessive suppression of the hydrosilylation reaction.

An example of the adhesive composition used in the present invention may include the component (A) that cures and the component (B) that does not cause a curing reaction to be a release agent component. By including such a component (B) in the adhesive composition, the obtained adhesive layer can be suitably released with good reproducibility.

Typical examples of the component (B) include a non-curable polyorganosiloxane, and specific examples thereof include, but are not limited to, an epoxy group-containing polyorganosiloxane, a methyl group-containing polyorganosiloxane, and a phenyl group-containing polyorganosiloxane.

Examples of the component (B) include polydimethylsiloxane. The polydimethylsiloxane may be modified. Examples of the optionally modified polydimethylsiloxane includes, but are not limited to, an epoxy group-containing polydimethylsiloxane, an unmodified polydimethylsiloxane, or a phenyl group-containing polydimethylsiloxane.

Preferred examples of the polyorganosiloxane as the component (B) include, but are not limited to, an epoxy group-containing polyorganosiloxane, a methyl group-containing polyorganosiloxane, and a phenyl group-containing polyorganosiloxane.

The weight average molecular weight of the polyorganosiloxane as the component (B) is not particularly limited, but is usually 100,000 to 2,000,000, and is preferably 200,000 to 1,200,000, more preferably 300,000 to 900,000 from the viewpoint of achieving the effects of the present invention with good reproducibility. In addition, the dispersibility is not particularly limited, but is usually 1.0 to 10.0, and is preferably 1.5 to 5.0, more preferably 2.0 to 3.0 from the viewpoint of, for example, achieving suitable release with good reproducibility. Note that the weight average molecular weight and the dispersibility can be measured by the above-described method related to the polyorganosiloxane.

The viscosity of the polyorganosiloxane as the component (B) is not particularly limited, but is usually 1,000 to 2,000,000 $mm^2/s$. Note that the value of the viscosity of the polyorganosiloxane as the component (B) is expressed by kinematic viscosity, and centistokes (cSt) = $mm^2/s$. The value can also be determined by dividing the viscosity (mPa·s) by the density ($g/cm^3$). That is, the value can be determined from the viscosity and density measured with an E-type rotational viscometer at 25°C, and can be calculated from the equation: kinematic viscosity ($mm^2/s$) = viscosity (mPa·s)/density ($g/cm^3$).

Examples of the epoxy group-containing polyorganosiloxane include those containing a siloxane unit ($D^{10}$ unit) represented by $R^{11}R^{12}SiO_{2/2}$.

$R^{11}$ is a group bonded to a silicon atom and represents an alkyl group, $R^{12}$ is a group bonded to a silicon atom and represents an epoxy group or an organic group containing an epoxy group, and specific examples of the alkyl group can include the above-described examples.

The epoxy group in the organic group containing an epoxy group may be an independent epoxy group without being fused with another ring, or may be an epoxy group forming a fused ring with another ring, such as a 1,2-epoxycyclohexyl group.

Specific examples of the organic group containing an epoxy group include, but are not limited to, 3-glycidoxypropyl and 2-(3,4-epoxycyclohexyl)ethyl.

In the present invention, preferred examples of the epoxy group-containing polyorganosiloxane may include, but are not limited to, an epoxy group-containing polydimethylsiloxane.

The epoxy group-containing polyorganosiloxane contains the above-described siloxane unit ($D^{10}$ unit), but may contain, in addition to the $D^{10}$ unit, a Q unit, an M unit, and/or a T unit.

In a preferred aspect of the present invention, specific examples of the epoxy group-containing polyorganosiloxane include a polyorganosiloxane composed only of $D^{10}$ units, a polyorganosiloxane containing $D^{10}$ units and Q units, a polyorganosiloxane containing $D^{10}$ units and M units, a polyorganosiloxane containing $D^{10}$ units and T units, a polyorganosiloxane containing $D^{10}$ units, Q units, and M units, a polyorganosiloxane containing $D^{10}$ units, M units, and T units, or a polyorganosiloxane containing $D^{10}$ units, Q units, M units, and T units.

The epoxy group-containing polyorganosiloxane is preferably an epoxy group-containing polydimethylsiloxane having an epoxy value of 0.1 to 5. In addition, the weight average molecular weight is not particularly limited, but is usually from 1,500 to 500,000, and is preferably 100,000 or less from the viewpoint of suppressing precipitation in the composition.

Specific examples of the epoxy group-containing polyorganosiloxane include, but are not limited to, those represented by the formulas (E1) to (E3).

[Chem. 53]

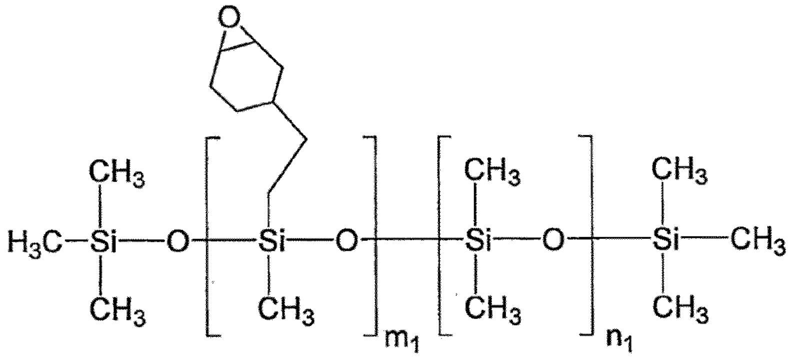

(E1)

($m_1$ and $n_1$ represent the number of respective repeating units, and are positive integers.)

[Chem. 54]

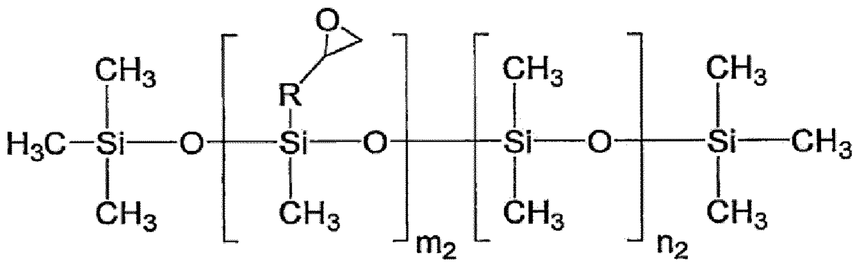

(E2)

($m_2$ and $n_2$ represent the number of respective repeating units, and are positive integers, and R is an alkylene group having 1 to 10 carbon atoms.)

[Chem. 55]

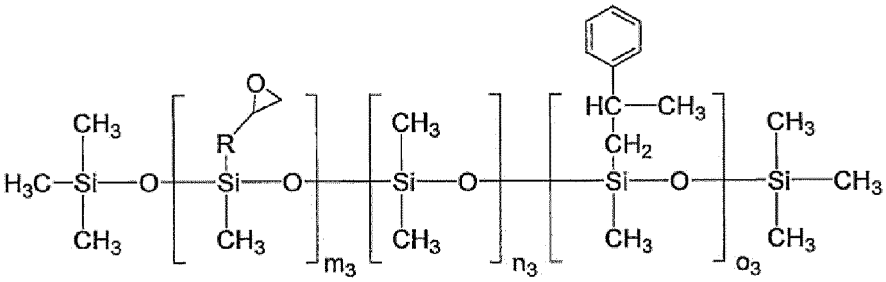

(E3)

($m_3$, $n_3$, and $o_3$ represent the number of respective repeating units, and are positive integers, and R is an alkylene group having 1 to 10 carbon atoms.)

Examples of the methyl group-containing polyorganosiloxane include those containing a siloxane unit ($D^{200}$ unit) represented by $R^{210}R^{220}SiO_{2/2}$, and preferably those containing a siloxane unit ($D^{20}$ unit) represented by $R^{21}R^{21}SiO_{2/2}$.

$R^{210}$ and $R^{220}$ are groups bonded to silicon atoms, and each independently represent an alkyl group, provided that at least one of $R^{210}$ and $R^{220}$ is a methyl group, and specific examples of the alkyl group may include the above-described examples.

$R^{21}$ is a group bonded to a silicon atom and represents an alkyl group, and specific examples of the alkyl group may include the above-described examples. Among them, a methyl group is preferable as $R^{21}$.

In the present invention, preferred examples of the methyl group-containing polyorganosiloxane may include, but are not limited to, a polydimethylsiloxane.

The methyl group-containing polyorganosiloxane contains the above-described siloxane unit ($D^{200}$ unit or $D^{20}$ unit), but may contain, in addition to the $D^{200}$ unit and the $D^{20}$ unit, a Q unit, an M unit, and/or a T unit.

In an aspect of the present invention, specific examples of the methyl group-containing polyorganosiloxane include a polyorganosiloxane composed only of $D^{200}$ units, a polyorganosiloxane containing $D^{200}$ units and Q units, a polyorganosiloxane containing $D^{200}$ units and M units, a polyorganosiloxane containing $D^{200}$ units and T units, a polyorganosiloxane containing $D^{200}$ units, Q units, and M units, a polyorganosiloxane containing $D^{200}$ units, M units, and T units, or a polyorganosiloxane containing $D^{200}$ units, Q units, M units, and T units.

In a preferred aspect of the present invention, specific examples of the methyl group-containing polyorganosiloxane include a polyorganosiloxane composed only of $D^{20}$ units, a polyorganosiloxane containing $D^{20}$ units and Q units, a polyorganosiloxane containing $D^{20}$ units and M units, a polyorganosiloxane containing $D^{20}$ units and T units, a polyorganosiloxane containing $D^{20}$ units, Q units, and M units, a polyorganosiloxane containing $D^{20}$ units, M units, and T units, or a polyorganosiloxane containing $D^{20}$ units, Q units, M units, and T units.

Specific examples of the methyl group-containing polyorganosiloxane include, but are not limited to, those represented by the formula (M1).

[Chem. 56]

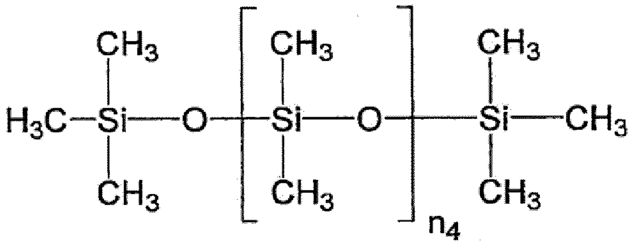

(M1)

($n_4$ represents the number of repeating units, and is a positive integer.)

Examples of the phenyl group-containing polyorganosiloxane include those containing a siloxane unit ($D^{30}$ unit) represented by $R^{31}R^{32}SiO_{2/2}$.

$R^{31}$ is a group bonded to a silicon atom and represents a phenyl group or an alkyl group, $R^{32}$ is a group bonded to a silicon atom and represents a phenyl group, and specific examples of the alkyl group may include the above-described examples, but a methyl group is preferable.

The phenyl group-containing polyorganosiloxane contains the above-described siloxane unit ($D^{30}$ unit), but may contain, in addition to the $D^{30}$ unit, a Q unit, an M unit, and/or a T unit.

In a preferred aspect of the present invention, specific examples of the phenyl group-containing polyorganosiloxane include a polyorganosiloxane composed only of $D^{30}$ units, a polyorganosiloxane containing $D^{30}$ units and Q units, a polyorganosiloxane containing $D^{30}$ units and M units, a polyorganosiloxane containing $D^{30}$ units and T units, a polyorganosiloxane containing $D^{30}$ units, Q units, and M units, a polyorganosiloxane containing $D^{30}$ units, M units, and T units, or a polyorganosiloxane containing $D^{30}$ units, Q units, M units, and T units.

Specific examples of the phenyl group-containing polyorganosiloxane include, but are not limited to, those represented by the formula (P1) or (P2).

[Chem. 57]

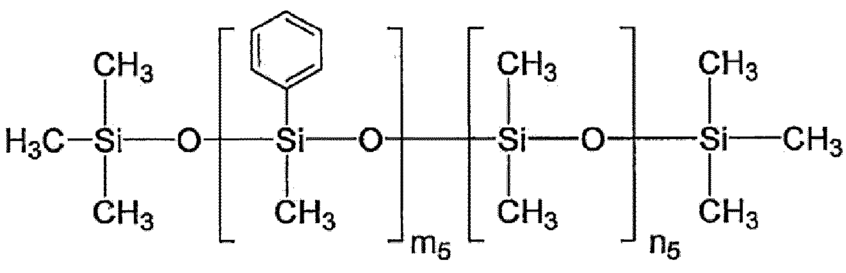

(P1)

($m_5$ and $n_5$ represent the number of respective repeating units, and are positive integers.)

[Chem. 58]

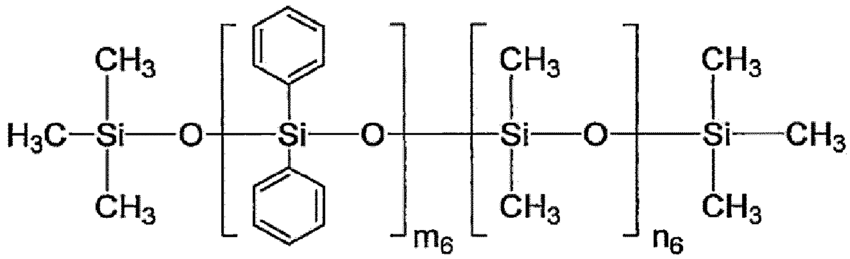

(P2)

($m_6$ and $n_6$ represent the number of respective repeating units, and are positive integers.)

The polyorganosiloxane as the release agent component (B) may be a commercially available product or a synthetic product.

Examples of commercially available products of the polyorganosiloxane include, but are not limited to, Wacker Silicone Fluid AK series (AK 50, AK 350, AK 1000, AK 10000, AK 1000000) and GENIOPLAST GUM, which are products manufactured by Wacker Chemie AG, dimethyl silicone oil (KF-96L, KF-96A, KF-96, KF-96H, KF-69, KF-965, KF-968) and cyclic dimethyl silicone oil (KF-995) manufactured by Shin-Etsu Chemical Co., Ltd.; epoxy group-containing polyorganosiloxane manufactured by Gelest, Inc. (trade name: CMS-227, ECMS-327), epoxy group-containing polyorganosiloxane manufactured by Shin-Etsu Chemical Co., Ltd. (KF-101, KF-1001, KF-1005, X-22-343), epoxy group-containing polyorganosiloxane (BY16-839) manufactured by Dow Corning Corporation; and phenyl group-containing polyorganosiloxane (PMM-1043, PMM-1025, PDM-0421, PDM-0821) manufactured by Gelest, Inc., phenyl group-containing polyorganosiloxane (KF50-3000CS) manufactured by Shin-Etsu Chemical Co., Ltd., and phenyl group-containing polyorganosiloxane (TSF431, TSF433) manufactured by Momentive Performance Materials, Inc.

In one aspect, the adhesive composition used in the present invention contains a component (A) to be cured and a component (B) that does not cause a curing reaction, and in another aspect, a polyorganosiloxane is contained as the component (B).

An example of the adhesive composition used in the present invention can contain the component (A) and the component (B) in any ratio, but in consideration of the balance between adhesiveness and releasability, the ratio of the component (A) and the component (B) is preferably 99.995 : 0.005 to 30 : 70, more preferably 99.9 : 0.1 to 75 : 25 in mass ratio [(A) : (B)].

That is, when the polyorganosiloxane component (A') cured by a hydrosilylation reaction is contained, the ratio of the component (A') and the component (B) is preferably 99.995 : 0.005 to 30 : 70, more preferably 99.9 : 0.1 to 75 : 25 in mass ratio [(A') : (B)].

The viscosity of the adhesive composition used in the present invention is not particularly limited, but is usually 500 to 20,000 mPa·s, preferably 1,000 to 10,000 mPa·s at 25°C.

An example of the adhesive composition used in the present invention can be produced by mixing the component (A) and the component (B) when used with a solvent.

The mixing order is not particularly limited, but examples of the method for easily and reproducibly producing the adhesive composition include, but are not limited to, a method in which the component (A) and the component (B) are dissolved in a solvent, and a method in which a part of the component (A) and the component (B) is dissolved in a solvent, the rest is dissolved in a solvent, and the obtained solution is mixed. Note that when the adhesive composition is prepared, the components may be heated, if appropriate, as long as the components are not decomposed or altered.

In the present invention, for the purpose of removing foreign matter, a solvent, a solution, or the like to be used may be filtered using a filter or the like during the production of the adhesive composition or after mixing all the components.

The thickness of the adhesive layer included in the laminate of the present invention is not particularly limited, but is usually 5 to 500 μm, and is preferably 10 μm or more, more preferably 20 μm or more, still more preferably 30 μm or more from the viewpoint of maintaining the film strength, and is preferably 200 μm or less, more preferably 150 μm or less, still more preferably 120 μm or less, still more preferably 70 μm or less from the viewpoint of avoiding nonuniformity caused by a thick film.

The method for forming the adhesive layer from the adhesive composition will be described in detail in the description of <<Method for producing one example of laminate in first embodiment>> described below.

Hereinafter, an example of the configuration of the laminate of the first embodiment will be described with reference to the drawings.

The laminate of Fig. 1 includes a semiconductor substrate 1, an adhesive layer 2, a release agent layer 3, and a support substrate 4 in this order.

The adhesive layer 2 and the release agent layer 3 are provided between the semiconductor substrate 1 and the

support substrate 4. The adhesive layer 2 is in contact with the semiconductor substrate 1. The release agent layer 3 is in contact with the adhesive layer 2 and the support substrate 4.

<<Method for producing one example of laminate in first embodiment>>

A method for producing a laminate will be described below with the laminate shown in Fig. 1 as an example of the laminate in the first embodiment.

An example of the laminate of the present invention can be produced, for example, by a method including the following Steps 1 to 3.

Step 1: a step of applying an adhesive composition onto a semiconductor substrate to form an adhesive coating layer
Step 2: a step of applying a release agent composition onto a support substrate to form a release agent layer
Step 3: a step of heating the adhesive coating layer in a state where the adhesive coating layer and the release agent layer are in contact with each other to form an adhesive layer.

The coating method for the adhesive composition is not particularly limited, but is usually a spin coating method. Note that a method for separately forming a coating film by a spin coating method or the like, forming a sheet-like coating film, and sticking the sheet-like coating film as an adhesive coating layer can be adopted.

The heating temperature of the applied adhesive composition varies depending on the type and amount of the adhesive component contained in the adhesive composition, whether or not a solvent is contained, the boiling point of the solvent used, the desired thickness of the adhesive layer, and the like, and thus cannot be generally specified, but the heating temperature is usually 80 to 150°C, and the heating time is usually 30 seconds to 5 minutes.

When the adhesive composition contains a solvent, the applied adhesive composition is usually heated.

The film thickness of an adhesive coating layer obtained by applying an adhesive composition and heating the adhesive composition, if necessary, is usually about 5 to 500 μm, and finally, is appropriately determined to fall within the above-described range of the thickness of the adhesive layer.

The coating method for the release agent composition is not particularly limited, but is usually a spin coating method.

The heating temperature of the applied release agent composition varies depending on the type and amount of the release agent component contained in the release agent composition, the desired thickness of the release agent layer, and the like, and thus cannot be generally specified, but from the viewpoint of achieving a suitable release agent layer with good reproducibility, the heating temperature is 80°C or more and 300°C or less, and the heating time is appropriately determined usually in the range of 10 seconds to 10 minutes depending on the heating temperature. The heating temperature is preferably 100°C or higher and 280°C or lower, more preferably 150°C or higher and 250°C or lower. The heating time is preferably 30 seconds or more and 8 minutes or less, more preferably 1 minute or more and 5 minutes or less.

Heating can be performed using a hot plate, an oven, or the like.

The film thickness of the release agent layer obtained by applying the release agent composition and heating the release agent composition, if necessary, is usually about 5 nm to 100 μm.

In the present invention, the laminate of the present invention can be obtained by combining such coating layers to be in contact with each other, bringing the two layers into close contact with each other by applying a load in the thickness direction of the semiconductor substrate and the support substrate while performing heat treatment or decompression treatment or both thereof, and then performing post-heat treatment. Note that which treatment condition of heat treatment, decompression treatment, and combination use of both is adopted is appropriately determined in consideration of various circumstances such as the type of the adhesive composition, the specific composition of the release agent composition, the compatibility of films obtained from both compositions, the film thickness, and the required adhesive strength.

The heat treatment is appropriately determined from the range of usually 20 to 150°C from the viewpoint of removing the solvent from the composition, the viewpoint of softening the adhesive coating layer to achieve suitable bonding with the release agent layer, and the like. In particular, from the viewpoint of suppressing or avoiding excessive curing and unnecessary alteration of the adhesive component (A), the heating temperature is preferably 130°C or lower, more preferably 90°C or lower, and the heating time is appropriately determined depending on the heating temperature and the type of the adhesive. However, from the viewpoint of reliably exhibiting suitable adhesion, the heating time is usually 30 seconds or longer, preferably 1 minute or longer. From the viewpoint of suppressing alteration of the adhesive layer and other members, the heating time is usually 10 minutes or shorter, preferably 5 minutes or shorter.

In the decompression treatment, the adhesive coating layer and the release agent layer in contact with each other may be exposed to an atmospheric pressure of 10 to 10,000 Pa. The time for the decompression treatment is usually 1 to 30 minutes.

From the viewpoint of obtaining a laminate in which the substrate can be satisfactorily separated with good

reproducibility, the two layers in contact with each other are bonded to each other preferably by decompression treatment, more preferably by combined use of heat treatment and decompression treatment.

The load in the thickness direction of the semiconductor substrate and the support substrate is not particularly limited as long as the load does not adversely affect the semiconductor substrate, the support substrate, and the two layers therebetween, and can bring them into close contact with each other, but is usually within the range of 10 to 1,000 N.

The temperature of the post-heating is preferably 120°C or higher from the viewpoint of achieving a sufficient curing rate and the like, and is preferably 260°C or lower from the viewpoint of preventing alteration of the substrate and each layer, and the like.

The post-heating time is usually 1 minute or more, preferably 5 minutes or more from the viewpoint of achieving suitable bonding of the substrate and the layer constituting the laminate, and is usually 180 minutes or less, preferably 120 minutes or less from the viewpoint of suppressing or avoiding an adverse effect on each layer due to excessive heating, and the like.

Heating can be performed using a hot plate, an oven, or the like. When post-heating is performed using a hot plate, heating may be performed with either the semiconductor substrate or the support substrate of the laminate facing downward, but it is preferable to perform post-heating with the semiconductor substrate facing downward from the viewpoint of achieving suitable release with good reproducibility.

Note that one object of the post-heat treatment is to achieve an adhesive layer and a release agent layer which are more suitable self-standing films, particularly to suitably achieve curing by a hydrosilylation reaction.

Hereinafter, an example of a method for producing the laminate of Fig. 1 will be described with reference to Figs. 2A to 2C.

Figs. 2A to 2C are views for illustrating one aspect of producing the laminate.

First, a laminate in which the adhesive coating layer 2a is formed on the semiconductor substrate 1 is prepared (Fig. 2A). This laminate can be obtained, for example, by applying the adhesive composition onto the semiconductor substrate 1, followed by heating.

Separately, a laminate in which the release agent layer 3 is formed on the support substrate 4 is prepared (Fig. 2B). This laminate can be obtained, for example, by applying the release agent composition on the support substrate 4, followed by heating.

Next, the laminate shown in Fig. 2A and the laminate shown in Fig. 2B are bonded to each other so that the adhesive coating layer 2a and the release agent layer 3 are in contact with each other. Then, after a load is applied in the thickness direction between the semiconductor substrate 1 and the support substrate 4 under reduced pressure, a heating device (not illustrated; a hot plate) is disposed on the surface opposite to a surface of the semiconductor substrate 1 with which the adhesive coating layer 2a is in contact, and the adhesive coating layer 2a is heated and cured by the heating device to be converted into the adhesive layer 2 (Fig. 2C).

The laminate is obtained by the steps shown in Figs. 2A to 2C.

Note that, in Fig. 1, in the laminate, the semiconductor substrate 1, the adhesive layer 2, the release agent layer 3, and the support substrate 4 are stacked in this order, and thus the above-described production method has been exemplified. However, for example, when producing a laminate in which the semiconductor substrate 1, the release agent layer 3, the adhesive layer 2, and the support substrate 4 are stacked in this order, the laminate can be produced by a method including a first step of coating a surface of the semiconductor substrate with the release agent composition and, if necessary, heating the release agent composition to form the release agent layer, a second step of coating a surface of the support substrate with the release agent composition and, if necessary, heating the release agent composition to form the adhesive coating layer, and a third step of bringing the release agent layer of the semiconductor substrate and the adhesive coating layer of the support substrate into close contact with each other by applying a load in the thickness direction of the semiconductor substrate and the support substrate while performing at least one of heat treatment and decompression treatment, and then performing post-heat treatment to form the laminate.

Note that as long as the effect of the present invention is not impaired, application and heating of each composition may be sequentially performed on any one of the substrates.

<Second embodiment>

The laminate having an electronic device layer is used for processing of the electronic device layer. While the electronic device layer is being processed, the electronic device layer is adhered to the support substrate. After processing the electronic device layer, the release agent layer is irradiated with light, and then the electronic device layer is separated from the support substrate.

<<Electronic device layer>>

The electronic device layer refers to a layer having an electronic device, and in the present invention, refers to a

layer in which a plurality of semiconductor chip substrates are embedded in a sealing resin, that is, a layer including a plurality of semiconductor chip substrates and a sealing resin disposed between the semiconductor chip substrates.

Here, the "electronic device" means a member constituting at least a part of an electronic component. The electronic device is not particularly limited, and can be one in which various mechanical structures and circuits are formed on the surface of a semiconductor substrate. The electronic device is preferably a composite of a member made of metal or a semiconductor and a resin that seals or insulates the member. The electronic device may be one in which a rewiring layer, which will be described later, and/or a semiconductor element or other elements are sealed or insulated with a sealing material or an insulating material, and has a single-layer or multi-layer structure.

<<Support substrate>>

As the support substrate, those similar to those described in the section of <<Support substrate>> above of <First embodiment> above are exemplified.

<<Release agent layer>>

The release agent layer is formed using the release agent composition for release by irradiation with light of the present invention described above.

The detailed description of the release agent layer is as described in the section of <<Release agent layer>> above of <First embodiment> above.

<<Adhesive layer>>

The adhesive layer is formed using the adhesive composition described above.

The detailed description of the adhesive layer is as described in the section of <<Adhesive layer>> above of <First embodiment> above.

Hereinafter, an example of the configuration of the laminate of the second embodiment will be described with reference to the drawings.

Fig. 3 shows a schematic cross-sectional view of an example of the laminate of the second embodiment.

The laminate of Fig. 3 includes the support substrate 24, the release agent layer 23, the adhesive layer 22, and the electronic device layer 26 in this order.

The electronic device layer 26 includes a plurality of semiconductor chip substrates 21 and a sealing resin 25 which is a sealing material disposed between the semiconductor chip substrates 21.

The adhesive layer 22 and the release agent layer 23 are provided between the electronic device layer 26 and the support substrate 24. The adhesive layer 22 is in contact with the electronic device layer 26. The release agent layer 23 is in contact with the adhesive layer 22 and the support substrate 24.

In addition, another example of the configuration of the laminate of the second embodiment is shown in Fig. 4.

When the release agent layer according to the present invention is a release agent layer having adhesive performance having both the release function and the adhesive function, the laminate may be formed not in a two-layer structure of the release agent layer and the adhesive layer but in a one-layer structure of the release agent layer having adhesive performance.

Fig. 4 illustrates a schematic cross-sectional view of another example of the laminate.

The laminate of Fig. 4 includes the support substrate 24, the release agent layer 27 having adhesive performance, and the electronic device layer 26 in this order.

The release agent layer 27 having adhesive performance is provided between the support substrate 24 and the electronic device layer 26. The release agent layer 27 having adhesive performance can be prepared by mixing components of a release agent composition that forms a release agent with components of an adhesive composition that forms an adhesive layer.

<<Method for producing one example of laminate in second embodiment>>

A method for producing a laminate will be described below with the laminate shown in Fig. 3 as an example of the laminate in the second embodiment.

The laminate of the present invention can be produced, for example, by a method including the following Steps 1 to 5.

Step 1: a step of coating a surface of the support substrate with the release agent composition to form a release agent coating layer (if necessary, further heating is performed to form a release agent layer)

Step 2: a step of coating a surface of the release agent coating layer or the release agent layer with the adhesive

composition to form an adhesive coating layer (if necessary, further heating is performed to form an adhesive layer)

Step 3: a step of placing a semiconductor chip substrate on the adhesive coating layer or the adhesive layer, and bonding the semiconductor chip substrate to the adhesive coating layer or the adhesive layer while performing at least one of heat treatment and decompression treatment

Step 4: a step of curing the adhesive coating layer by post-heat treatment to form an adhesive layer

Step 5: a step of sealing the semiconductor chip substrate fixed onto the adhesive layer using a sealing resin

To describe the third step in more detail, for example, there is the following step (i) of the embodiment.

(i) The semiconductor chip substrate is placed on the adhesive coating layer or the adhesive layer, and while at least one of the heat treatment and the decompression treatment is performed, a load is applied in the thickness direction of the semiconductor chip substrate and the support substrate to bring the semiconductor chip substrate and the support substrate into close contact with each other, and the semiconductor chip substrate is bonded to the adhesive coating layer or the adhesive layer.

Note that Step 4 may be performed after the semiconductor chip substrate in Step 3 is bonded to the adhesive coating layer, or may be performed in combination with Step 3. For example, by placing the semiconductor chip substrate on the adhesive coating layer and heating and curing the adhesive coating layer while applying a load in the thickness direction of the semiconductor chip substrate and the support substrate, adhesion between the semiconductor chip substrate and the adhesive coating layer and curing from the adhesive coating layer to the adhesive layer may be performed together, and the adhesive layer and the semiconductor chip substrate may be bonded to each other.

In addition, Step 4 may be performed before Step 3, the semiconductor chip substrate may be placed on the adhesive layer, and while a load is applied in the thickness direction of the semiconductor chip substrate and the support substrate, the adhesive layer and the semiconductor chip substrate may be bonded to each other.

The coating method, the heating temperature of the applied release agent composition or adhesive composition, the heating means, and the like are as described in

<<Method for producing one example of laminate in first embodiment>> above of <first embodiment> above.

Hereinafter, the procedure of the method for producing the laminate of the second embodiment will be described in more detail with reference to the drawings. In this production method, the laminate shown in Fig. 3 is produced.

As shown in Fig. 5A, a release agent coating layer 23' made of the release agent composition is formed on the support substrate 24. At that time, the release agent coating layer 23' may be heated to form a release agent layer 23.

Next, as shown in Fig. 5B, an adhesive coating layer 22' made of the adhesive composition is formed on the release agent coating layer 23' or the release agent layer 23. At that time, the adhesive coating layer 22' may be heated to form an adhesive layer 22.

Next, as shown in Fig. 5C, the semiconductor chip substrate 21 is placed on the adhesive layer 22 or the adhesive coating layer 22', and while at least one of the heat treatment and the decompression treatment is performed, a load is applied in the thickness direction of the semiconductor chip substrate 21 and the support substrate 24 to bring the semiconductor chip substrate 21 and the support substrate 24 into close contact with each other, and the semiconductor chip substrate 21 is bonded to the adhesive layer 22 or the adhesive coating layer 22'. When the semiconductor chip substrate 21 is bonded to the adhesive coating layer 22', the adhesive coating layer 22' is cured by post-heat treatment to form the adhesive layer 22, and the semiconductor chip substrate 21 is fixed to the adhesive layer 22.

Note that when the adhesive coating layer 22' is subjected to the post-heat treatment, the release agent coating layer 23' may also be subjected to the post-heat treatment to form the release agent layer 23.

Next, as illustrated in Fig. 5D, the semiconductor chip substrate 21 fixed onto the adhesive layer 22 is sealed using the sealing resin 25. In Fig. 5D, the plurality of semiconductor chip substrates 21 temporarily adhered onto the support substrate 24 via the adhesive layer 22 is sealed with the sealing resin 25. The electronic device layer 26, which includes the semiconductor chip substrate 21 and the sealing resin 25 disposed in the semiconductor chip substrate 21, is formed on the adhesive layer 22, and as described above, the electronic device layer 26 is a base material layer in which a plurality of semiconductor chip substrates are embedded in the sealing resin.

<<<Sealing step>>>

The semiconductor chip substrate 21 is sealed using a sealing material.

As the sealing material for sealing the semiconductor chip substrate 21, a member capable of insulating or sealing a member made of metal or a semiconductor is used.

In the present invention, for example, a resin composition (sealing resin) is used as the sealing material. The type of the sealing resin is not particularly limited as long as it is possible to seal and/or insulate metal or a semiconductor, but for

example, an epoxy-based resin or a silicone-based resin is preferably used.

The sealing material may contain, in addition to the resin component, other components such as a filler. Examples of the filler include spherical silica particles.

In the sealing step, for example, the sealing resin heated to 130 to 170°C is supplied onto the adhesive layer 22 to cover the semiconductor chip substrate 21 while maintaining a high viscosity state, and is compression-molded to form a layer including the sealing resin 25 on the adhesive layer 22. At this time, the temperature condition is, for example, 130 to 170°C. In addition, the pressure applied to the semiconductor chip substrate 21 is, for example, 50 to 500 $N/cm^2$.

(Method for producing processed semiconductor substrate or electronic device layer)

When the laminate according to the present invention is used, a method for producing a processed semiconductor substrate or a method for producing a processed electronic device layer can be provided.

In the "method for producing a processed semiconductor substrate", the laminate described in the section of <First embodiment> above of the (Laminate) above is used. In addition, in the "method for producing a processed electronic device layer", the laminate described in the section of <Second embodiment> above of the (Laminate) above is used.

A "method for producing a processed semiconductor substrate" will be described in <Third embodiment> below, and a "method for producing a processed electronic device layer" will be described in <Fourth embodiment> below.

<Third embodiment>

The method for producing a processed semiconductor substrate of the present invention includes the following Step 5A and the following Step 6A. The method for producing the processed electronic device layer may further include the following Step 7A.

Here, Step 5A is a step of processing the semiconductor substrate in the laminate described in the section of

<First embodiment> above.

In addition, Step 6A is a step of separating the semiconductor substrate processed in Step 5A and the support substrate from each other.

In addition, Step 7A is a step of cleaning the processed semiconductor substrate after Step 6A.

The processing performed on the semiconductor substrate in Step 5A is, for example, processing on the side opposite to the circuit surface of the wafer, and includes thinning of the wafer by polishing the back surface of the wafer. Thereafter, for example, a through silicon via (TSV) or the like is formed, and then the thinned wafer is released from the support substrate to form a laminate of wafers which are three-dimensionally mounted. In addition, for example, before and after that, a wafer back surface electrode and the like are also formed. Heat of approximately 250 to 350°C is applied to thinning of a wafer and a TSV process in a state of being adhered to the support substrate. The laminate of the present invention usually includes the adhesive layer to provide heat resistance to the load.

Note that the processing is not limited to the above-described processing, and includes, for example, implementation of a process of mounting a semiconductor component in a case where the semiconductor component is temporarily adhered to the support substrate in order to support a base material for mounting the semiconductor component.

In Step 6A, examples of the method for separating (releasing) the semiconductor substrate and the support substrate include, but are not limited to, a method for mechanical release with equipment having a sharp part, a releasing method for separation between the support and the semiconductor wafer, and the like after the irradiation with light to the release agent layer.

By irradiating the release agent layer with light from the support substrate side, the release agent layer is altered (for example, the release agent layer is separated or decomposed) as described above, and thereafter, for example, one of the substrates is pulled up, and the semiconductor substrate and the support substrate can be easily separated from each other.

The release agent layer is not necessarily irradiated with light over the entire region of the release agent layer. Even when the region irradiated with light and the region not irradiated with light are mixed, the semiconductor substrate and the support substrate can be separated from each other by a slight external force such as pulling up of the support substrate as long as the release agent layer as a whole has sufficiently improved releasing ability. The ratio and positional relationship between the region irradiated with light and the region not irradiated with light vary depending on the type and specific composition of the adhesive to be used, the thickness of the adhesive layer, the thickness of the adhesive layer, the thickness of the release agent layer, the intensity of light to be emitted, and the like, but those skilled in the art can appropriately set conditions without requiring an excessive test. For such circumstances, according to the method for

producing a processed semiconductor substrate of the present invention, for example, in a case where the support substrate of the laminate to be used is light-transmissive, it is possible to shorten the irradiation time with light when release is performed by irradiation with light from the support substrate side, and as a result, not only improvement in throughput can be expected, but also physical stress and the like required for release can be avoided, and the semiconductor substrate and the support substrate can be easily and efficiently separated from each other only by irradiation with light.

The dose of light required for release is usually 50 to 3,000 $mJ/cm^2$. The irradiation time is appropriately determined depending on the wavelength and the irradiation amount.

The wavelength of the light used for release is preferably, for example, a wavelength of 250 to 600 nm, more preferably a wavelength of 250 to 370 nm as described above. A more suitable wavelength is 308 nm, 343 nm, 355 nm, 365 nm, or 532 nm. The irradiation amount of light required for release is an irradiation amount that can cause suitable alteration, for example, decomposition of the specific compound and polymer.

The light used for release may be laser light or non-laser light emitted from a light source such as an ultraviolet lamp.

The substrate can be cleaned by spraying a cleaning agent composition onto the surface of at least one of the separated semiconductor substrate and the support substrate, or immersing the separated semiconductor substrate or the support substrate in a cleaning agent composition.

In addition, the surface of the processed semiconductor substrate or the like may be cleaned using a removal tape or the like.

As an example of cleaning the substrate, Step 7A of cleaning the processed semiconductor substrate may be performed after Step 6A.

Examples of the cleaning agent composition to be used for cleaning include the following.

The cleaning agent composition usually contains a solvent.

Examples of the solvent include lactones, ketones, polyhydric alcohols, compounds having an ester bond, derivatives of polyhydric alcohols, cyclic ethers, esters, and aromatic organic solvents.

Examples of the lactones include γ-butyrolactone.

Examples of the ketones include acetone, methyl ethyl ketone, cyclohexanone, methyl-n-pentyl ketone, methyl isopentyl ketone, and 2-heptanone.

Examples of the polyhydric alcohols include ethylene glycol, diethylene glycol, propylene glycol, and dipropylene glycol.

Examples of the compounds having an ester bond include ethylene glycol monoacetate, diethylene glycol monoacetate, propylene glycol monoacetate, and dipropylene glycol monoacetate.

Examples of the derivatives of polyhydric alcohol include monoalkyl ethers such as monomethyl ether, monoethyl ether, monopropyl ether, and monobutyl ether of the polyhydric alcohols or the compounds having an ester bond, or compounds having an ether bond such as monophenyl ether. Among them, propylene glycol monomethyl ether acetate (PGMEA) and propylene glycol monomethyl ether (PGME) are preferable.

Examples of the cyclic ethers include dioxane.

Examples of the esters include methyl lactate, ethyl lactate (EL), methyl acetate, ethyl acetate, butyl acetate, methyl pyruvate, ethyl pyruvate, methyl methoxypropionate, and ethyl ethoxypropionate.

Examples of the aromatic organic solvents include anisole, ethyl benzyl ether, cresyl methyl ether, diphenyl ether, dibenzyl ether, phenetol, butyl phenyl ether, ethylbenzene, diethylbenzene, pentylbenzene, isopropylbenzene, toluene, xylene, cymene, and mesitylene.

These can be used alone or in combination of two or more thereof.

Among them, propylene glycol monomethyl ether acetate (PGMEA), propylene glycol monomethyl ether (PGME), cyclohexanone, and ethyl lactate (EL) are preferable.

In addition, a mixed solvent obtained by mixing PGMEA and a polar solvent is also preferable. The blending ratio (mass ratio) may be appropriately determined in consideration of compatibility between PGMEA and the polar solvent or the like, and is preferably in the range of 1 : 9 to 9 : 1, more preferably 2 : 8 to 8 : 2.

For example, when EL is blended as the polar solvent, the mass ratio of PGMEA : EL is preferably 1 : 9 to 9 : 1, more preferably 2 : 8 to 8 : 2. In addition, when PGME is blended as the polar solvent, the mass ratio of PGMEA : PGME is preferably 1 : 9 to 9 : 1, more preferably 2 : 8 to 8 : 2, still more preferably 3 : 7 to 7 : 3. In addition, when PGME and cyclohexanone are blended as the polar solvent, the mass ratio of PGMEA : (PGME + cyclohexanone) is preferably 1 : 9 to 9 : 1, more preferably 2 : 8 to 8 : 2, still more preferably 3 : 7 to 7 : 3.

The cleaning agent composition may contain a salt or otherwise, but it is preferable that the cleaning agent composition does not contain a salt from the viewpoint of enhancing versatility in processing a semiconductor substrate using a laminate, and suppressing cost.

An example of the case where the cleaning agent composition contains a salt includes a cleaning agent composition containing a quaternary ammonium salt and a solvent.

The quaternary ammonium salt is composed of a quaternary ammonium cation and an anion, and is not

particularly limited as long as the quaternary ammonium salt is used for this type of application.

Such quaternary ammonium cations typically include tetra (hydrocarbon) ammonium cations. On the other hand, examples of an anion paired therewith include, but are not limited to, a hydroxide ion ($OH^-$); a halogen ion such as a fluorine ion ($F^-$), a chlorine ion ($Cl^-$), a bromine ion ($Br^-$), and an iodine ion ($I^-$); a tetrafluoroborate ion ($BF_4^-$); or a hexafluorophosphate ion ($PF_6^-$).

The quaternary ammonium salt is preferably a halogen-containing quaternary ammonium salt, more preferably a fluorine-containing quaternary ammonium salt.

In the quaternary ammonium salt, the halogen atom may be contained in the cation or the anion, but is preferably contained in the anion.

In a preferred aspect, the fluorine-containing quaternary ammonium salt is tetra(hydrocarbon)ammonium fluoride.

Specific examples of the hydrocarbon group in tetra(hydrocarbon)ammonium fluoride include an alkyl group having 1 to 20 carbon atoms, an alkenyl group having 2 to 20 carbon atoms, an alkynyl group having 2 to 20 carbon atoms, and an aryl group having 6 to 20 carbon atoms.

In a more preferred aspect, the tetra(hydrocarbon)ammonium fluoride contains tetraalkylammonium fluoride.

Specific examples of tetraalkylammonium fluoride include, but are not limited to, tetramethylammonium fluoride, tetraethylammonium fluoride, tetrapropylammonium fluoride, and tetrabutylammonium fluoride. Among them, tetrabutylammonium fluoride is preferable.

As the quaternary ammonium salt such as tetra(hydrocarbon)ammonium fluoride, a hydrate may be used. In addition, the quaternary ammonium salts such as tetra(hydrocarbon)ammonium fluoride may be used alone or in combination of two or more thereof.

The amount of the quaternary ammonium salt is not particularly limited as long as the quaternary ammonium salt dissolves in the solvent contained in the cleaning agent composition, but is usually 0.1 to 30 mass% with respect to the cleaning agent composition.

When the cleaning agent composition contains a salt, the solvent to be used in combination is not particularly limited as long as the solvent is used for this type of application and dissolves a salt such as a quaternary ammonium salt, but from the viewpoint of obtaining a cleaning agent composition having excellent cleanability with good reproducibility, the viewpoint of obtaining a cleaning agent composition having excellent uniformity by dissolving a salt such as a quaternary ammonium salt well, and the like, the cleaning agent composition preferably contains one or more amide-based solvents.

Suitable examples of the amide-based solvents include an acid amide derivative represented by the formula (Z).

[Chem. 59]

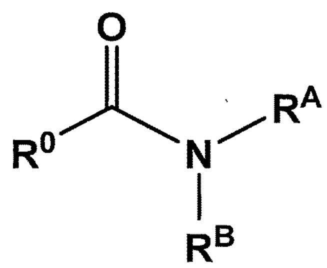

(Z)

In the formula, $R^0$ represents an ethyl group, a propyl group or an isopropyl group, and is preferably an ethyl group or an isopropyl group, more preferably an ethyl group. $R^A$ and $R^B$ each independently represent an alkyl group having 1 to 4 carbon atoms. The alkyl group having 1 to 4 carbon atoms may be linear, branched, or cyclic, and specific examples thereof include a methyl group, an ethyl group, a propyl group, an isopropyl group, a cyclopropyl group, an n-butyl group, an isobutyl group, an s-butyl group, a t-butyl group, and a cyclobutyl group. Among them, $R^A$ and $R^B$ are preferably a methyl group or an ethyl group, more preferably a methyl group or an ethyl group, still more preferably a methyl group.

Examples of the acid amide derivative represented by the formula (Z) include N,N-dimethylpropionamide, N,N-diethylpropionamide, N-ethyl-N-methylpropionamide, N,N-dimethylbutyramide, N,N-diethylbutyramide, N-ethyl-N-methylbutyramide, N,N-dimethylisobutyramide, N,N-diethylisobutyramide, or N-ethyl-N-methylisobutyramide. Among them, N,N-dimethylpropionamide and N,N-dimethylisobutyramide are particularly preferable, and N,N-dimethylpropionamide is more preferable.

The acid amide derivative represented by the formula (Z) may be synthesized by a substitution reaction between a corresponding carboxylic acid ester and an amine, or a commercially available product may be used.

Another example of the preferred amide-based solvents includes a lactam compound represented by the formula (Y).

[Chem. 60]

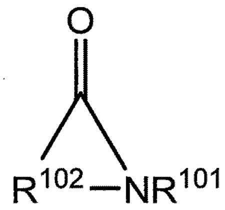

(Y)

In the formula (Y), $R^{101}$ represents a hydrogen atom or an alkyl group having 1 to 6 carbon atoms, and $R^{102}$ represents an alkylene group having 1 to 6 carbon atoms. Specific examples of the alkyl group having 1 to 6 carbon atoms include a methyl group, an ethyl group, an n-propyl group, and an n-butyl group, and specific examples of the alkylene group having 1 to 6 carbon atoms include, but are not limited to, a methylene group, an ethylene group, a trimethylene group, a tetramethylene group, a pentamethylene group, and a hexamethylene group.

Specific examples of the lactam compound represented by the formula (Y) may include an α-lactam compound, a β-lactam compound, a γ-lactam compound, and a δ-lactam compound, and these compounds can be used alone or in combination of two or more thereof.

In a preferred aspect, the lactam compound represented by the formula (Y) contains 1-alkyl-2 pyrrolidone (N-alkyl-γ-butyrolactam), in a more preferred aspect, N-methylpyrrolidone (NMP) or N-ethylpyrrolidone (NEP), and in a still more preferred aspect, N-methylpyrrolidone (NMP).

Note that the cleaning agent composition used in the present invention may contain water as the solvent, but usually, only an organic solvent is intended to be used as the solvent, for example, from the viewpoint of avoiding corrosion of the substrate and the like. Note that in this case, it is not denied that hydrated water of the salt or trace amounts of water contained in the organic solvent is contained in the cleaning agent composition. The water content of the cleaning agent composition used in the present invention is usually 5 mass% or less.

The constituent elements and method elements related to the above-described steps of the method for producing a processed semiconductor substrate of the present invention may be variously changed without departing from the gist of the present invention.

The method for producing a processed semiconductor substrate of the present invention may include steps other than the above-described steps.

In the releasing method of the present invention, when the semiconductor substrate or the support substrate of the laminate of the present invention has light transmissivity, the semiconductor substrate and the support substrate of the laminate are separated from each other by irradiating the release agent layer with light from the semiconductor substrate side or the support substrate side.

In an example of the laminate of the present invention, since the semiconductor substrate and the support substrate are temporarily adhered to each other by the adhesive layer and the release agent layer to be suitably releasable, for example, when the support substrate is light-transmissive, the semiconductor substrate and the support substrate can be easily separated from each other by irradiating the release agent layer with light from the support substrate side of the laminate. Usually, release is performed after the semiconductor substrate of the laminate is processed.

An example of the third embodiment will be described with reference to Figs. 6A to 6D. This example is an example of producing a thinned semiconductor substrate.

First, a laminate is prepared (Fig. 6A). This laminate is the same laminate as the laminate shown in Figs. 1 and 2C.

Next, the surface of the semiconductor substrate 1 opposite to a surface in contact with the adhesive layer 2 is polished using a polishing apparatus (not shown) to thin the semiconductor substrate 1 (Fig. 6B). Note that, for example, a through via may be formed on the thinned semiconductor substrate 1.

Next, after the release agent layer 3 is irradiated with light from the support substrate 4 side, the thinned semiconductor substrate 1 and the support substrate 4 are separated from each other using a releasing device (not shown) (Fig. 6C).

Then, the thinned semiconductor substrate 1 is obtained (Fig. 6D).

Here, residues of the adhesive layer 2 and the release agent layer 3 may remain on the thinned semiconductor substrate 1. Accordingly, it is preferable to clean the thinned semiconductor substrate 1 using the cleaning agent composition to remove the residues of the adhesive layer 2 and the release agent layer 3 from the semiconductor substrate 1.

<Fourth embodiment>

The method for producing a processed electronic device layer of the present invention includes the following Step 5B and the following Step 6B. The method for producing a processed electronic device layer may further include the following Step 7B.

Here, Step 5B is a step of processing the electronic device layer in the laminate described in the section of

<Second embodiment> above.

In addition, Step 6B is a step of separating the electronic device layer processed in Step 5B from the support substrate.

In addition, Step 7B is a step of cleaning the processed electronic device layer after Step 6B.

Hereinafter, a specific example of the fourth embodiment will be described with reference to Figs. 7A to 7F.

Examples of the processing performed on the electronic device layer in Step 5B include a grinding step and a wiring layer forming step.

<<Grinding step>>

The grinding step is a step of grinding the resin part of the layer of the sealing resin 25 in the electronic device layer 26 such that a part of the semiconductor chip substrate 21 is exposed.

For example, as shown in Fig. 7B, the sealing resin part is ground by grinding the layer of the sealing resin 25 of the laminate shown in Fig. 7A until the layer has a thickness substantially equal to that of the semiconductor chip substrate 21. Note that the laminate shown in Fig. 7A is the same laminate as the laminate shown in Figs. 3 and 5D.

<<Wiring layer forming step>>

The wiring layer forming step is a step of forming a wiring layer on the exposed semiconductor chip substrate 21 after the grinding step.

In Fig. 7C, a wiring layer 28 is formed on the electronic device layer 26 including a layer of the semiconductor chip substrate 21 and the sealing resin 25.

The wiring layer 28 is also called a redistribution layer (RDL), is a thin-film wiring body constituting wiring connected to a substrate, and may have a single-layer or multi-layer structure. The wiring layer may be, but is not limited to, one in which wiring is formed of a conductor (for example, metals such as aluminum, copper, titanium, nickel, gold, and silver, and alloys such as a silver-tin alloy) between dielectrics (for example, photosensitive resin such as silicon oxide ($SiO_x$) and photosensitive epoxy) .

Examples of the method for forming the wiring layer 28 include the following methods.

First, a dielectric layer of silicon oxide ($SiO_x$), a photosensitive resin, or the like is formed on the layer of the sealing resin 25. The dielectric layer made of silicon oxide can be formed by, for example, a sputtering method, a vacuum vapor deposition method, or the like. The dielectric layer made of a photosensitive resin can be formed by coating the layer of the sealing resin 25 with a photosensitive resin by a method such as spin coating, dipping, roller blade, spray coating, or slit coating.

Subsequently, wiring is formed on the dielectric layer with a conductor such as metal. As a method for forming the wiring, for example, a known semiconductor process approach such as lithography processing such as photolithography (registry lithography) or etching processing can be used. Examples of such lithography processing include lithography processing using a positive resist material and lithography processing using a negative resist material.

In the method for producing a laminate according to a fourth embodiment, a bump can be further formed or an element can be mounted on the wiring layer 28. The element can be mounted on the wiring layer 28 using, for example, a chip mounter or the like.

The laminate according to the fourth embodiment may be a laminate prepared in a process based on a fan-out type technology in which a terminal provided on a semiconductor chip substrate is mounted on a wiring layer extending outside a chip area.

In Step 6B, examples of the method for separating (releasing) the electronic device layer and the support substrate include, but are not limited to, a method for mechanical releasing with equipment having a sharp part, a releasing method for separation between the support and the electronic device layer, and the like after the irradiation with light to the release agent layer.

By irradiating the release agent layer with light from the support substrate side, the release agent layer is altered (for example, the release agent layer is separated or decomposed) as described above, and thereafter, for example, one of the substrates is pulled up, and the electronic device layer and the support substrate can be easily separated from each

other.

Figs. 7D to 7E are schematic cross-sectional views for illustrating a separation method for the laminate, and Fig. 7F is a schematic cross-sectional view for illustrating a cleaning method after separation of the laminate. One embodiment of the method for producing a semiconductor package (electronic component) can be described with reference to Figs. 7D to 7F.

As shown in Fig. 7D, the step of separating the laminate is a step of separating the electronic device layer 26 and the support substrate 24 from each other by irradiating the release agent layer 23 with light (arrow) through the support substrate 24 to alter the release agent layer 23.

After irradiating the release agent layer 23 with light (arrow) to alter the release agent layer 23, the support substrate 24 is separated from the electronic device layer 26 as shown in Fig. 7E.

The irradiation conditions, irradiation methods, and the like of irradiation of the adhesive layer with light are as described in the section of <Third embodiment> above.

The substrate can be cleaned by spraying the cleaning agent composition onto the surface of at least one of the separated electronic device layer and the support substrate, or immersing the separated electronic device layer or the support substrate in the cleaning agent composition.

In addition, the surface of the processed electronic device layer or the like may be cleaned using a removal tape or the like.

For example, in Fig. 7E, the adhesive layer 22 and the release agent layer 23 are attached to the electronic device layer 26 after the separation step, but the adhesive layer 22 and the release agent layer 23 can be removed by decomposing the adhesive layer 22 and the release agent layer 23 using a cleaning agent composition such as acid or alkali. By removing the release agent layer and the adhesive layer, a processed electronic device layer (electronic component) as shown in Fig. 7F can be suitably obtained.

The constituent elements and method elements related to the above-described steps of the method for producing a processed electronic device layer of the present invention may be variously changed without departing from the gist of the present invention.

The method for producing a processed electronic device layer of the present invention may include steps other than the above-described steps.

In the laminate of the present invention, since the electronic device layer and the support substrate are temporarily adhered to each other by the adhesive layer to be suitably releasable, for example, when the support substrate is light-transmissive, the electronic device layer and the support substrate can be easily separated from each other by irradiating the release agent layer with light from the support substrate side of the laminate. Usually, release is performed after the electronic device layer of the laminate is processed.

## Examples

Hereinafter, the present invention will be more specifically described with reference to examples, but the present invention is not limited to the following examples. Note that the apparatus used is as follows.

### [Apparatus]

(1) Stirrer: planetary centrifugal mixer ARE-500 manufactured by Thinky Corporation
(2) Viscometer: rotational viscometer TVE-22H manufactured by Toki Sangyo Co., Ltd.
(3) Vacuum bonding apparatus: automatic bonder manufactured by SUSS MicroTec SE
(4) Film thickness measurement: DEKTAK XT-A manufactured by Bruker
(5) Laser irradiation device: IPEX-848 manufactured by Light Machinery Co., Ltd.

### [Condition for measuring molecular weight]

The weight average molecular weight of the resin composition was measured using a GPC apparatus (HLC-8320GPC manufactured by Tosoh Corporation) and a GPC column (TSKgel Super-MultiporeHZ-N (2 columns)), at a column temperature of 40°C, using THF (tetrahydrofuran) as an eluent (elution solvent), at a flow rate of 0.35 mL/min, and using polystyrene (Shodex manufactured by Showa Denko K.K.) as a standard sample.

### [1] Preparation of adhesive composition

[Preparation Example 1]

In a 600 mL vessel dedicated to the stirrer were put 80 g of an MQ resin (manufactured by Wacker Chemie GmbH) containing a polysiloxane skeleton and a vinyl group, 2.52 g of SiH group-containing linear polydimethylsiloxane (manufactured by Wacker Chemie GmbH) having a viscosity of 100 mPa·s, 5.89 g of SiH group-containing linear polydimethylsiloxane (manufactured by Wacker Chemie GmbH) having a viscosity of 70 mPa·s, and 0.22 g of 1-ethynyl-1-cyclohexanol (manufactured by Wacker Chemie GmbH), followed by stirring with the stirrer for 5 minutes to yield a mixture (I).

Stirred were 0.147 g of a platinum catalyst (manufactured by Wacker Chemie GmbH) and 5.81 g of vinyl group-containing linear polydimethylsiloxane (manufactured by Wacker Chemie GmbH) having a viscosity of 1,000 mPa·s with the stirrer for 5 minutes to yield a mixture (II).

To the mixture (I) was added 3.96 g of the obtained mixture (II), followed by stirring with the stirrer for 5 minutes to yield a mixture (III).

Finally, the resultant mixture (III) was filtered through a nylon filter 300 mesh to yield an adhesive composition.

[2]Synthesis of resin composition

[Synthesis Example A]

In a flask were put 5.00 g of neopentyl glycol glycidyl ether (manufactured by Nagase ChemteX Corporation, trade name: Denacol EX-211L), 3.37 g of α-cyano-4-hydroxycinnamic acid, 0.29 g of tetrabutylphosphonium bromide, and 34.65 g of propylene glycol monomethyl ether (hereinafter, abbreviated as PGME) to prepare a raw material mixture. Then, the raw material mixture was heated and refluxed at 105°C for 24 hours under a nitrogen atmosphere. After the mixture was cooled to room temperature, a cation exchange resin and an anion exchange resin were added to the resultant reaction mixture, and then the mixture was stirred at room temperature for 4 hours to remove unreacted monomers and a catalyst used for the reaction. Finally, the ion exchange resin was removed by filtration to yield a solution containing a reaction product as a filtrate. The amount of the cation exchange resin and the amount of the anion exchange resin were each the same mass as the solid of the raw material mixture prepared at the beginning. The resultant reaction product corresponds to the following formula (A-1), and as a result of measurement by the above-described method, the weight average molecular weight was 1,923.

Formula (A-1)

[Chem. 61]

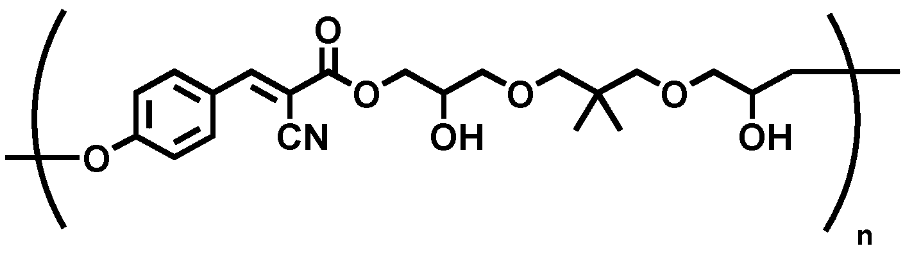

[Synthesis Example B]

In a flask were put 5.00 g of 1,4-cyclohexanedimethanol diglycidyl ether (manufactured by Nagase ChemteX Corporation, trade name: Denacol EX-216L), 3.37 g of α-cyano-4-hydroxycinnamic acid, 0.29 g of tetrabutylphosphonium bromide, and 34.65 g of PGME to prepare a raw material mixture. Then, the raw material mixture was heated and refluxed at 105°C for 24 hours under a nitrogen atmosphere. After the mixture was cooled to room temperature, a cation exchange resin and an anion exchange resin were added to the resultant reaction mixture, and then the mixture was stirred at room temperature for 4 hours to remove unreacted monomers and a catalyst used for the reaction. Finally, the ion exchange resin was removed by filtration to yield a solution containing a reaction product as a filtrate. The amount of the cation exchange resin and the amount of the anion exchange resin were each the same mass as the solid of the raw material mixture prepared at the beginning. The resultant reaction product corresponds to the following formula (A-2), and as a result of measurement by the above-described method, the weight average molecular weight was 1,810.

Formula (A-2)

[Chem. 62]

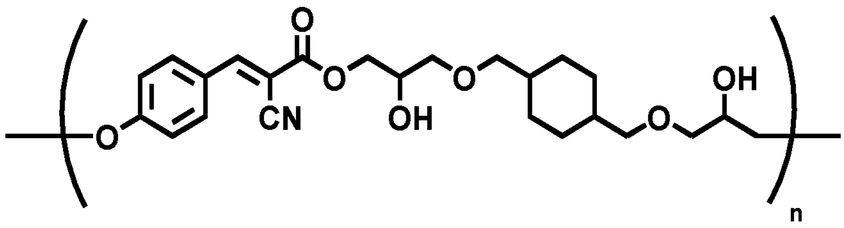

[Synthesis Example C]

In a flask were put 5.00 g of hydrogenated bisphenol A diglycidyl ether (manufactured by Nagase ChemteX Corporation, trade name: Denacol EX-252), 2.34 g of α-cyano-4-hydroxycinnamic acid, 0.20 g of tetrabutylphosphonium bromide, and 30.14 g of propylene glycol monomethyl ether PGME to prepare a raw material mixture. Then, the raw material mixture was heated and refluxed at 105°C for 24 hours under a nitrogen atmosphere. After the mixture was cooled to room temperature, a cation exchange resin and an anion exchange resin were added to the resultant reaction mixture, and then the mixture was stirred at room temperature for 4 hours to remove unreacted monomers and a catalyst used for the reaction. Finally, the ion exchange resin was removed by filtration to yield a solution containing a reaction product as a filtrate. The amount of the cation exchange resin and the amount of the anion exchange resin were each the same mass as the solid of the raw material mixture prepared at the beginning. The resultant reaction product corresponds to the following formula (A-3), and as a result of measurement by the above-described method, the weight average molecular weight was 2,080.

Formula (A-3)

[Chem. 63]

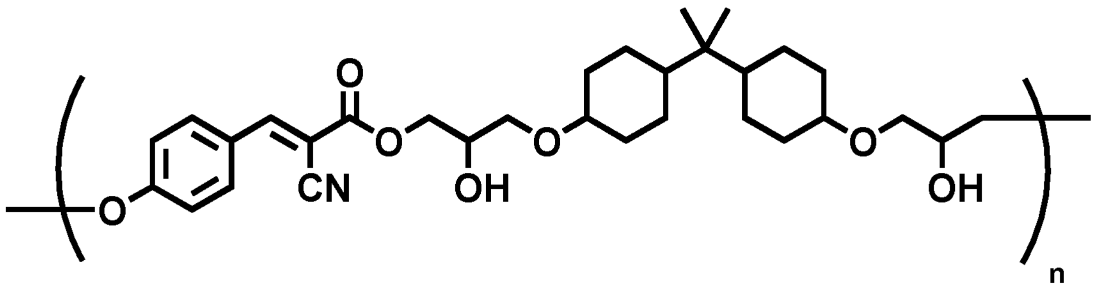

[Synthesis Example D]

In a flask were put 5.00 g of 3',4'-epoxycyclohexylmethyl 3,4-epoxycyclohexanecarboxylate (manufactured by Daicel Corporation, trade name: CEL2021P), 2.34 g of α-cyano-4-hydroxycinnamic acid, 0.20 g of tetrabutylphosphonium bromide, and 30.14 g of PGME to prepare a raw material mixture. Then, the raw material mixture was heated and refluxed at 105°C for 24 hours under a nitrogen atmosphere. After the mixture was cooled to room temperature, a cation exchange resin and an anion exchange resin were added to the resultant reaction mixture, and then the mixture was stirred at room temperature for 4 hours to remove unreacted monomers and a catalyst used for the reaction. Finally, the ion exchange resin was removed by filtration to yield a solution containing a reaction product as a filtrate. The amount of the cation exchange resin and the amount of the anion exchange resin were each the same mass as the solid of the raw material mixture prepared at the beginning. The resultant reaction product corresponds to the following formula (A-4), and as a result of measurement by the above-described method, the weight average molecular weight was 1,500.

Formula (A-4)

[Chem. 64]

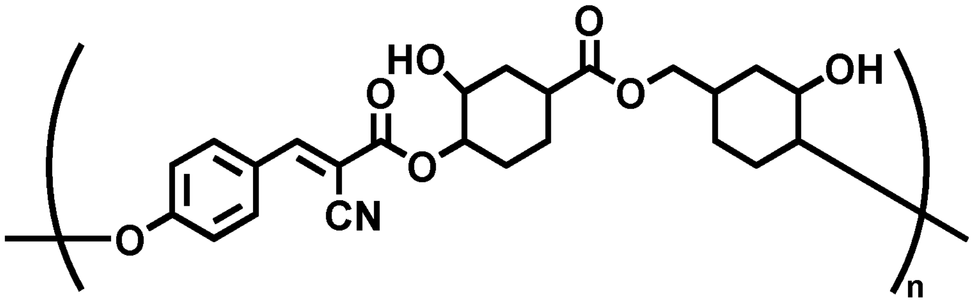

[Synthesis Example E]

In a flask were put 15.00 g of a 30 mass% PGME solution of 5,5-dimethyl-1,3-bis(oxiranylmethyl)imidazolidine-2,4-dione, 3.78 g of α-cyano-4-hydroxycinnamic acid, 0.32 g of tetrabutylphosphonium bromide, and 24.09 g of PGME to prepare a raw material mixture. Then, the raw material mixture was heated and refluxed at 105°C for 24 hours under a nitrogen atmosphere. After the mixture was cooled to room temperature, a cation exchange resin and an anion exchange resin were added to the resultant reaction mixture, and then the mixture was stirred at room temperature for 4 hours to remove unreacted monomers and a catalyst used for the reaction. Finally, the ion exchange resin was removed by filtration to yield a solution containing a reaction product as a filtrate. The amount of the cation exchange resin and the amount of the anion exchange resin were each the same mass as the solid of the raw material mixture prepared at the beginning. The resultant reaction product corresponds to the following formula (A-5), and as a result of measurement by the above-described method, the weight average molecular weight was 1,964.

Formula (A-5)

[Chem. 65]

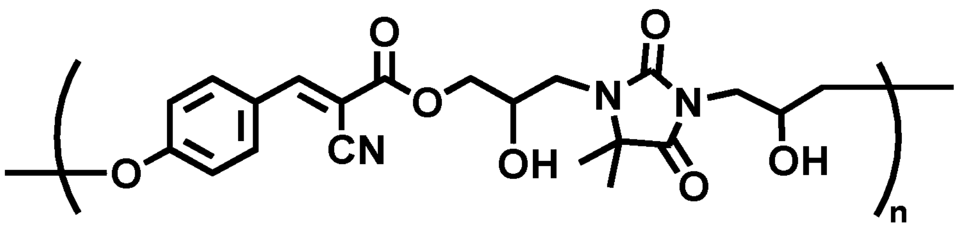

[Synthesis Example F]

In a flask were put 5.00 g of diglycidyl terephthalate (manufactured by Nagase ChemteX Corporation, trade name: Denacol EX711), 3.43 g of α-cyano-4-hydroxycinnamic acid, 0.29 g of tetrabutylphosphonium bromide, and 34.90 g of PGME to prepare a raw material mixture. Then, the raw material mixture was heated and refluxed at 105°C for 24 hours under a nitrogen atmosphere. After the mixture was cooled to room temperature, a cation exchange resin and an anion exchange resin were added to the resultant reaction mixture, and then the mixture was stirred at room temperature for 4 hours to remove unreacted monomers and a catalyst used for the reaction. Finally, the ion exchange resin was removed by filtration to yield a solution containing a reaction product as a filtrate. The amount of the cation exchange resin and the amount of the anion exchange resin were each the same mass as the solid of the raw material mixture prepared at the beginning. The resultant reaction product corresponds to the following formula (A-6), and as a result of measurement by the above-described method, the weight average molecular weight was 2,135.

Formula (A-6)

[Chem. 66]

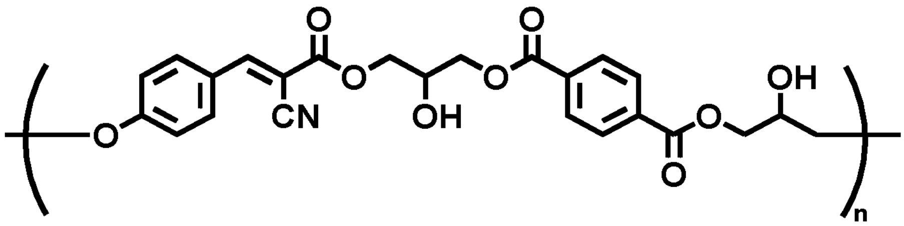

[Synthesis Example G]

In a flask were put 5.00 g of 3,3',5,5'-tetramethyl-4,4'-bis(glycidyloxy)-1,1'-biphenyl (manufactured by Mitsubishi Chemical Corporation, trade name: YX4000), 2.56 g of α-cyano-4-hydroxycinnamic acid, 0.23 g of tetrabutylphosphonium bromide, and 31.16 g of PGME to prepare a raw material mixture. Then, the raw material mixture was heated and refluxed at 105°C for 24 hours under a nitrogen atmosphere. After the mixture was cooled to room temperature, a cation exchange resin and an anion exchange resin were added to the resultant reaction mixture, and then the mixture was stirred at room temperature for 4 hours to remove unreacted monomers and a catalyst used for the reaction. Finally, the ion exchange resin was removed by filtration to yield a solution containing a reaction product as a filtrate. The amount of the cation exchange resin and the amount of the anion exchange resin were each the same mass as the solid of the raw material mixture prepared at the beginning. The resultant reaction product corresponds to the following formula (A-7), and as a result of measurement by the above-described method, the weight average molecular weight was 2,730.

Formula (A-7)

[Chem. 67]

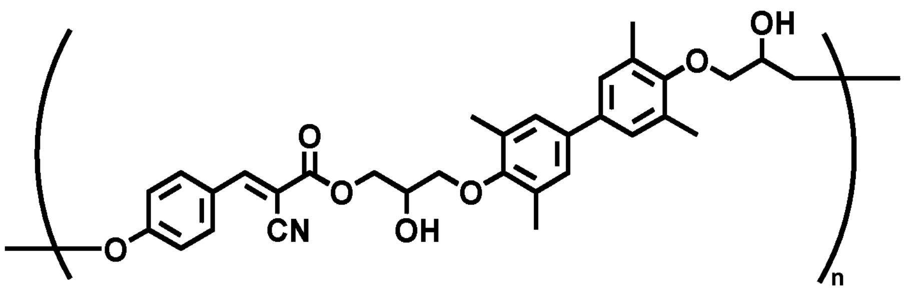

[Synthesis Example H]

In a flask were put 5.00 g of 1,6-bis(2,3-epoxypropane-1-yloxy)naphthalene (manufactured by DIC Corporation, trade name: HP-4032D), 2.56 g of α-cyano-4-hydroxycinnamic acid, 0.23 g of tetrabutylphosphonium bromide, and 31.16 g of PGME to prepare a raw material mixture. Then, the raw material mixture was heated and refluxed at 105°C for 24 hours under a nitrogen atmosphere. After the mixture was cooled to room temperature, a cation exchange resin and an anion exchange resin were added to the resultant reaction mixture, and then the mixture was stirred at room temperature for 4 hours to remove unreacted monomers and a catalyst used for the reaction. Finally, the ion exchange resin was removed by filtration to yield a solution containing a reaction product as a filtrate. The amount of the cation exchange resin and the amount of the anion exchange resin were each the same mass as the solid of the raw material mixture prepared at the beginning. The resultant reaction product corresponds to the following formula (A-8), and as a result of measurement by the above-described method, the weight average molecular weight was 2,295.

Formula (A-8)

[Chem. 68]

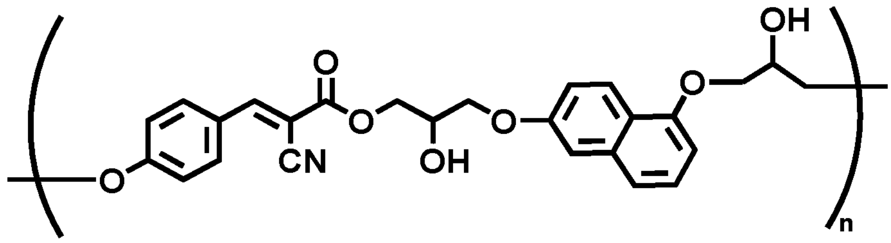

[Synthesis Example I]

In a flask were put 6.00 g of 3',4'-epoxycyclohexylmethyl 3,4-epoxycyclohexanecarboxylate (manufactured by Daicel Corporation, trade name: CEL2021P), 3.90 g of trans-4-hydroxycinnamic acid, 0.38 g of tetrabutylphosphonium bromide, and 41.11 g of PGME to prepare a raw material mixture. Then, the raw material mixture was heated and refluxed at 105°C for 24 hours under a nitrogen atmosphere. After the mixture was cooled to room temperature, a cation exchange resin and an anion exchange resin were added to the resultant reaction mixture, and then the mixture was stirred at room temperature for 4 hours to remove unreacted monomers and a catalyst used for the reaction. Finally, the ion exchange resin was removed by filtration to yield a solution containing a reaction product as a filtrate. The amount of the cation exchange resin and the amount of the anion exchange resin were each the same mass as the solid of the raw material mixture prepared at the beginning. The resultant reaction product corresponds to the following formula (A-9), and as a result of measurement by the above-described method, the weight average molecular weight was 1,532.

Formula (A-9)

[Chem. 69]

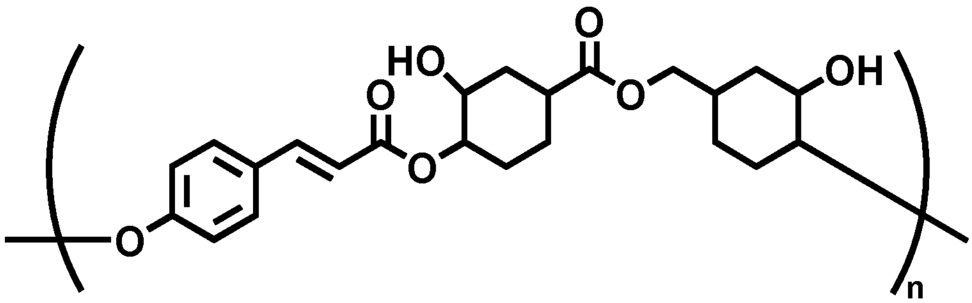

[Synthesis Example J]

In a flask were put 20.00 g of a 30 mass% PGME solution of 5,5-dimethyl-1,3-bis(oxiranylmethyl)imidazolidine-2,4-dione, 4.37 g of trans-4-hydroxycinnamic acid, 0.43 g of tetrabutylphosphonium bromide, and 29.45 g of PGME to prepare a raw material mixture. Then, the raw material mixture was heated and refluxed at 105°C for 24 hours under a nitrogen atmosphere. After the mixture was cooled to room temperature, a cation exchange resin and an anion exchange resin were added to the resultant reaction mixture, and then the mixture was stirred at room temperature for 4 hours to remove unreacted monomers and a catalyst used for the reaction. Finally, the ion exchange resin was removed by filtration to yield a solution containing a reaction product as a filtrate. The amount of the cation exchange resin and the amount of the anion exchange resin were each the same mass as the solid of the raw material mixture prepared at the beginning. The resultant reaction product corresponds to the following formula (A-10), and as a result of measurement by the above-described method, the weight average molecular weight was 3,546.

Formula (A-10)

[Chem. 70]

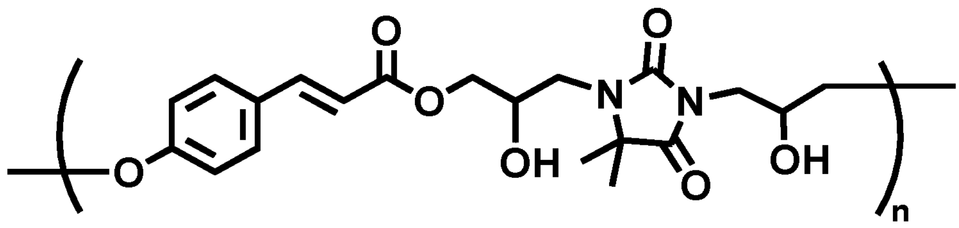

[Synthesis Example K]

In a flask were put 5.00 g of diglycidyl terephthalate (manufactured by Nagase ChemteX Corporation, trade name: Denacol EX711), 2.98 g of trans-4-hydroxycinnamic acid, 0.29 g of tetrabutylphosphonium bromide, and 33.08 g of PGME to prepare a raw material mixture. Then, the raw material mixture was heated and refluxed at 105°C for 24 hours under a nitrogen atmosphere. After the mixture was cooled to room temperature, a cation exchange resin and an anion exchange resin were added to the resultant reaction mixture, and then the mixture was stirred at room temperature for 4 hours to remove unreacted monomers and a catalyst used for the reaction. Finally, the ion exchange resin was removed by filtration to yield a solution containing a reaction product as a filtrate. The amount of the cation exchange resin and the amount of the anion exchange resin were each the same mass as the solid of the raw material mixture prepared at the beginning. The resultant reaction product corresponds to the following formula (A-11), and as a result of measurement by the above-described method, the weight average molecular weight was 2,728.

Formula (A-11)

[Chem. 71]

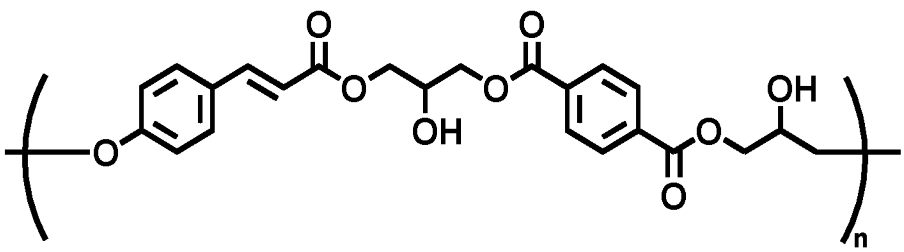

[Synthesis Example L]

In a flask were put 6.00 g of 3,3',5,5'-tetramethyl-4,4'-bis(glycidyloxy)-1,1'-biphenyl (manufactured by Mitsubishi Chemical Corporation, trade name: YX4000), 2.80 g of trans-4-hydroxycinnamic acid, 0.28 g of tetrabutylphosphonium bromide, and 36.30 g of PGME to prepare a raw material mixture. Then, the raw material mixture was heated and refluxed at 105°C for 24 hours under a nitrogen atmosphere. After the mixture was cooled to room temperature, a cation exchange resin and an anion exchange resin were added to the resultant reaction mixture, and then the mixture was stirred at room temperature for 4 hours to remove unreacted monomers and a catalyst used for the reaction. Finally, the ion exchange resin was removed by filtration to yield a solution containing a reaction product as a filtrate. The amount of the cation exchange resin and the amount of the anion exchange resin were each the same mass as the solid of the raw material mixture prepared at the beginning. The resultant reaction product corresponds to the following formula (A-12), and as a result of measurement by the above-described method, the weight average molecular weight was 4,619.

Formula (A-12)

[Chem. 72]

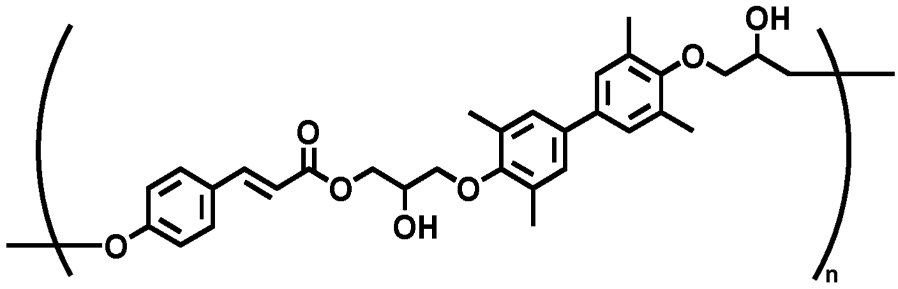

[Synthesis Example M]

In a flask were put 56.02 g of N-phenyl-1-naphthylamine, 50.00 g of 1-pyrenecarboxaldehyde, 6.67 g of 4-(trifluoromethyl) benzaldehyde, and 2.46 g of methanesulfonic acid, followed by addition of 86.36 g of 1,4-dioxane and 86.36 g of toluene. Then, the mixture was refluxed and stirred for 18 hours under a nitrogen atmosphere.

The resultant reaction mixture was allowed to cool, then diluted by adding 96 g of tetrahydrofuran, and the diluted solution was added dropwise to methanol to yield a precipitate. The resultant precipitate was collected by filtration, and the filtrate was washed with methanol, and dried at 60°C under reduced pressure to yield 72.12 g of a reaction product. The resultant reaction product corresponds to the following formula (A-13), and as a result of measurement by the above-described method, the weight average molecular weight was 1,100.

Formula (A-13)

[Chem. 73]

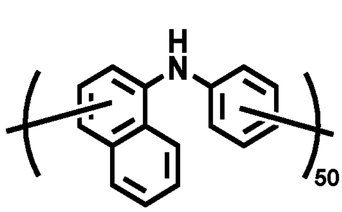
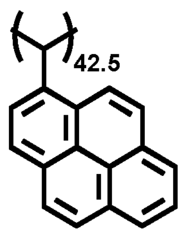
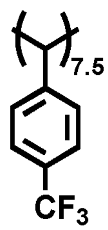

[3] Preparation of release agent composition

[Example 1-1]

PGME was added such that the resin solution obtained in Synthesis Example A had a solid content of 6 mass% to yield a release agent composition.

[Example 1-2] to [Example 1-12]

A release agent composition having a solid content of 6 mass% was obtained in the same manner as in Example 1-1 except that each of the resin solutions obtained in Synthesis Examples B to L was used as a resin solution.

[Comparative Example 1-1]

The resin obtained in Synthesis Example M was dissolved in propylene glycol monomethyl acetate such that the solid content was 6 mass% to yield a release agent composition.

[4] Production of laminate

[Example 2-1] to [Example 2-12], [Comparative Example 2-1]

The release agent compositions obtained in Examples 1-1 to 1-12 and Comparative Example 1-1 were spin-coated on a 300 mm glass wafer (EAGLE-SG, manufactured by Corning Incorporated, thickness: 700 μm) as a substrate on the carrier side such that the film thickness in the finally obtained laminate was 250 nm, and fired at 200°C for 5 minutes to form a release agent coating layer on the glass wafer.

On the other hand, the adhesive composition obtained in Preparation Example 1 was spin-coated on a 300 mm silicon wafer (thickness: 775 μm) as a substrate on the device side such that the film thickness in the finally obtained laminate was 65 μm to form an adhesive coating layer on the silicon wafer that is a semiconductor substrate.

Then, using a bonding apparatus, the glass wafer and the silicon wafer were bonded so as to sandwich the release agent coating layer and the adhesive coating layer, followed by post-heating treatment at 200°C for 10 minutes to prepare a laminate. Note that bonding was performed under a load of 30 N at a temperature of 23°C and a degree of vacuum of 1,000 Pa. The obtained laminate was cut into a 4 cm square using a dicing device.

[5] Calculation of carbon content

The carbon content of the resins obtained in [Synthesis Example A] to [Synthesis Example M] was calculated by the following formula. The results are shown in Table 1-1 to Table 1-5.

When the composition formula of the resin is $C_iH_{ii}N_{iii}O_{iv}F_v$,

$$(\text{Carbon content})\ (\%) = (12 \times i) \times 100/(12 \times i + 1 \times ii + 14 \times iii + 16 \times iv + 19 \times v)$$

[6] Confirmation of releasability

Using a laser irradiation device, the release agent layer was irradiated with a laser having a wavelength of 308 nm at various irradiation amounts shown in Tables 1-1 to 1-3 from the glass wafer side of the fixed laminate. Then, the support substrate was manually lifted to confirm whether or not the support substrate can be released. A case where the silicon wafer was released without being damaged was evaluated as "○", and a case where the silicon wafer was not released was evaluated as "×". The results of the release are shown in Table 1-1 to Table 1-5.

[7] Confirmation of cleanability

The glass substrate (glass wafer) obtained after laser releasing was immersed in 7 mL of PGME for 5 minutes and air-dried to yield a cleaned substrate. For determination of whether or not cleaning was possible, the glass substrate after cleaning was observed with an optical microscope, and a case where a residue of the release agent layer was not observed was evaluated as "○", and a case where a residue was observed was evaluated as "×". In Comparative Example 2-1, cleaning was performed using PGMEA (propylene glycol monomethyl ether acetate) instead of PGME. The results are shown in Table 1-1 to Table 1-5.

[Table 1-1]

| | Example 2-1 | | | | Example 2-2 | | | | Example 2-3 | | | |
|---|---|---|---|---|---|---|---|---|---|---|---|---|
| Release agent composition | Example 1-1 | | | | Example 1-2 | | | | Example 1-3 | | | |
| | Synthesis Example A | | | | Synthesis Example B | | | | Synthesis Example C | | | |
| Carbon content [%] | 62.2 | | | | 64.7 | | | | 68.8 | | | |
| Irradiation amount [mJ/cm$^2$] | 100 | 120 | 150 | 200 | 100 | 120 | 150 | 200 | 100 | 120 | 150 | 200 |
| Result of release | × | ○ | ○ | ○ | ○ | - | ○ | ○ | ○ | - | ○ | ○ |
| Result of cleaning | - | ○ | ○ | ○ | ○ | - | ○ | ○ | ○ | - | ○ | ○ |

[Table 1-2]

| | Example 2-4 | | | | Example 2-5 | | | | Example 2-6 | | | |
|---|---|---|---|---|---|---|---|---|---|---|---|---|
| Release agent composition | Example 1-4 | | | | Example 1-5 | | | | Example 1-6 | | | |
| | Synthesis Example D | | | | Synthesis Example E | | | | Synthesis Example F | | | |
| Carbon content [%] | 65.8 | | | | 58.7 | | | | 61.7 | | | |
| Irradiation amount [mJ/cm$^2$] | 100 | 120 | 150 | 200 | 100 | 120 | 150 | 200 | 100 | 120 | 150 | 200 |
| Result of release | ○ | ○ | ○ | ○ | ○ | ○ | ○ | ○ | ○ | ○ | ○ | ○ |
| Result of cleaning | ○ | ○ | ○ | × | ○ | ○ | ○ | ○ | ○ | ○ | × | × |

[Table 1-3]

| | Example 2-7 | | | | Example 2-8 | | | | Example 2-9 | | | |
|---|---|---|---|---|---|---|---|---|---|---|---|---|
| Release agent composition | Example 1-7 | | | | Example 1-8 | | | | Example 1-9 | | | |
| | Synthesis Example G | | | | Synthesis Example H | | | | Synthesis Example I | | | |
| Carbon content [%] | 70.7 | | | | 67.7 | | | | 66.2 | | | |
| Irradiation amount [mJ/cm$^2$] | 100 | 120 | 150 | 200 | 100 | 120 | 150 | 200 | 100 | 120 | 150 | 200 |
| Result of release | ○ | ○ | ○ | ○ | ○ | ○ | ○ | ○ | ○ | ○ | ○ | ○ |
| Result of cleaning | ○ | ○ | × | × | ○ | ○ | × | × | ○ | ○ | ○ | ○ |

[Table 1-4]

| | Example 2-10 | | | | Example 2-11 | | | | Example 2-12 | | | |
|---|---|---|---|---|---|---|---|---|---|---|---|---|
| Release agent composition | Example 1-10 | | | | Example 1-11 | | | | Example 1-12 | | | |
| | Synthesis Example J | | | | Synthesis Example K | | | | Synthesis Example L | | | |
| Carbon content [%] | 59.4 | | | | 62.4 | | | | 71.8 | | | |
| Irradiation amount [mJ/cm$^2$] | 100 | 120 | 150 | 200 | 100 | 120 | 150 | 200 | 100 | 120 | 150 | 200 |
| Result of release | ○ | ○ | ○ | ○ | ○ | ○ | ○ | ○ | ○ | ○ | ○ | ○ |
| Result of cleaning | ○ | ○ | ○ | ○ | ○ | ○ | ○ | × | ○ | ○ | × | × |

[Table 1-5]

| | | | | |
|---|---|---|---|---|
| | | | Comparative Example 2-1 | |
| Release agent composition | | | Comparative Example 1-1 | |
| | | | Synthesis Example M | |
| Carbon content [%] | 89.3 | | | |
| Irradiation amount [$mJ/cm^2$] | 100 | 120 | 150 | 200 |
| Result of release | ○ | ○ | ○ | ○ |
| Result of cleaning | × | × | × | × |

As shown in the tables, in a laminate including a layer (release agent layer) exhibiting releasability by irradiation with light, a semiconductor substrate, and a support substrate, using a release agent composition containing a polymer having a structure similar to cinnamic acid and having a low carbon content for formation of the release agent layer can achieve good releasability and cleanability even after irradiation with light.

Reference Signs List

1 Semiconductor substrate
2 Adhesive layer
2a Adhesive coating layer
3 Release agent layer
4 Support substrate
21 Semiconductor chip substrate
22 Adhesive layer
23 Release agent layer
24 Support substrate
25 Sealing resin
26 Electronic device layer
27 Release agent layer having adhesive performance
28 Wiring layer

## Claims

**1.** A release agent composition for release by irradiation with light, comprising:

at least one of a compound and a polymer having a structure represented by a following formula (1) and having a carbon content of 80% or less; and a solvent,

[Chem. 1]

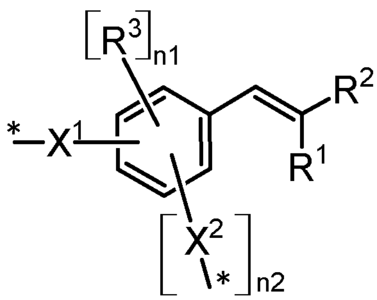

(1)

wherein in the formula (1), $R^1$ and $R^2$ each independently represent a hydrogen atom, a cyano group, a phenyl group, an alkyl group having 1 to 13 carbon atoms, a halogen atom, $-COOR^{11}$ ($R^{11}$ represents a hydrogen atom or

an alkyl group having 1 to 4 carbon atoms), or -COO-,
$R^3$ represents a methoxy group, an alkyl group having 1 to 13 carbon atoms, or a halogen atom,
n1 represents an integer of 0 to 4, and n2 represents 0 or 1, provided that a sum of n1 and n2 is 4 or less,
$X^1$ represents an ether bond or an ester bond,
$X^2$ represents an ether bond or an ester bond, and
* represents a bond.

2. The release agent composition according to claim 1, wherein at least one of the compound and the polymer has at least one of a structure represented by a following formula (2), a structure represented by a following formula (3), and a structure represented by a following formula (4),

[Chem. 2]

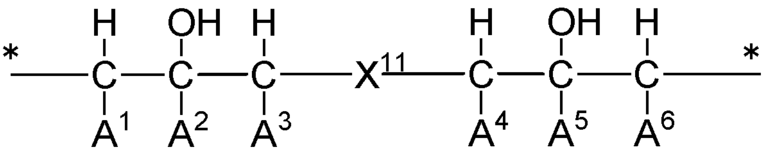
(2)

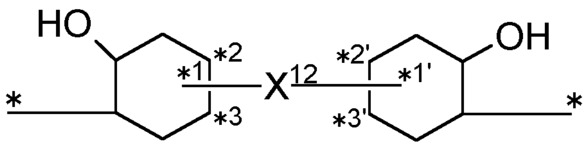
(3)

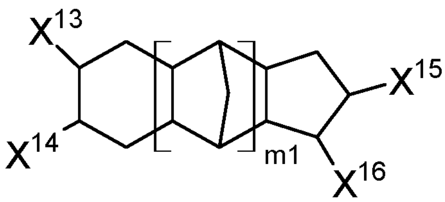
(4)

wherein in the formula (2), $X^{11}$ represents a divalent group, $A^1$, $A^2$, $A^3$, $A^4$, $A^5$, and $A^6$ each independently represent a hydrogen atom, a methyl group, or an ethyl group, and * represents a bond,
in the formula (3), $X^{12}$ represents a divalent group, *, *1, and *1' represent a bond, the bond *1 is bonded to a carbon atom *2 or a carbon atom *3, and the bond *1' is bonded to a carbon atom *2' or a carbon atom *3', and
in the formula (4), one of $X^{13}$ and $X^{14}$ represents a hydroxy group, the other represents a bond, and one of $X^{15}$ and $X^{16}$ represents a hydroxy group, the other represents a bond, and m1 represents 0 or 1.

3. The release agent composition according to claim 2, wherein $X^{11}$ in the formula (2) is either a structure represented by a following formula (2-1) or a structure represented by a following formula (2-2),

[Chem. 3]

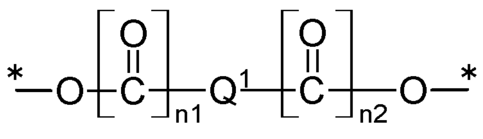
(2-1)

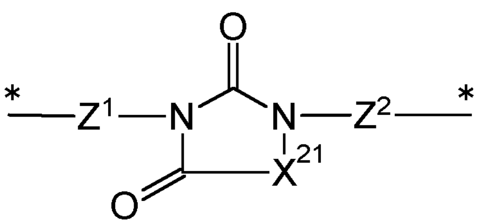
(2-2)

wherein in the formula (2-1), $Q^1$ represents a divalent acyclic hydrocarbon group having 2 to 20 carbon atoms which may be interrupted by an oxygen atom, a divalent organic group represented by a following formula (2-1-1), a divalent organic group represented by a following formula (2-1-2), a divalent organic group represented by a following formula (2-1-3), or a divalent organic group represented by a following formula (2-1-4), n1 and n2 each independently represent 0 or 1, and * represents a bond, and
in the formula (2-2), $X^{21}$ represents a divalent group represented by any one of following formulas (2-2-1) to (2-2-4), and $Z^1$ and $Z^2$ each independently represent a single bond or a divalent group represented by a following formula (2-2-5),

[Chem. 4]

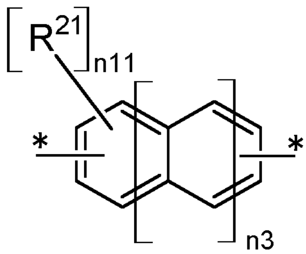
(2-1-1)

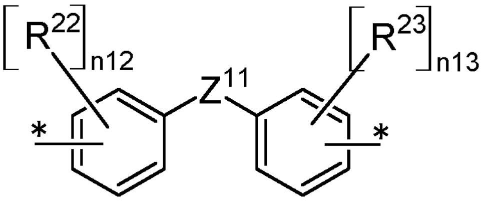
(2-1-2)

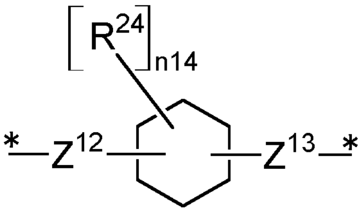
(2-1-3)

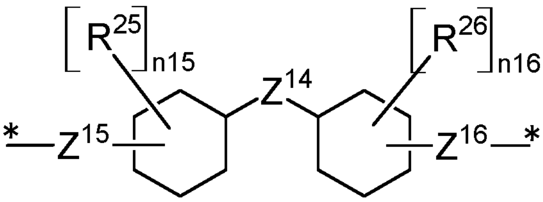
(2-1-4)

in the formulas (2-1-1) to (2-1-4), $R^{21}$ to $R^{26}$ each independently represent a halogen atom, a hydroxy group, an alkyl group having 1 to 6 carbon atoms, an alkenyl group having 2 to 6 carbon atoms, an alkynyl group having 2 to 6 carbon atoms, an alkoxy group having 1 to 6 carbon atoms, an alkenyloxy group having 2 to 6 carbon atoms, an alkynyloxy group having 2 to 6 carbon atoms, an acyl group having 2 to 6 carbon atoms, an aryloxy group having 6 to 12 carbon atoms, an arylcarbonyl group having 7 to 13 carbon atoms, or an aralkyl group having 7 to 13 carbon atoms, and * represents a bond,
in the formula (2-1-1), n3 represents 0 or 1, when n3 is 0, n11 represents an integer of 0 to 4, when n3 is 1, n11 represents an integer of 0 to 6, and when two or more $R^{21}$s are present, the two or more $R^{21}$s may be identical to or different from each other,
in the formula (2-1-2), $Z^{11}$ represents a single bond, an oxygen atom, a sulfur atom, a carbonyl group, a sulfonyl group, or an alkylene group having 1 to 6 carbon atoms, n12 and n13 each independently represent an integer of 0 to 4, when two or more $R^{22}$s are present, the two or more $R^{22}$s may be identical to or different from each other, and when two or more $R^{23}$s are present, the two or more $R^{23}$s may be identical to or different from each other,
in the formula (2-1-3), $Z^{12}$ and $Z^{13}$ each independently represent a single bond or a linear or branched alkylene group having 1 to 6 carbon atoms, n14 represents an integer of 0 to 4, and when two or more $R^{24}$s are present, the

two or more $R^{24}$s may be identical to or different from each other, and
in the formula (2-1-4), $Z^{14}$ represents a single bond, an oxygen atom, a sulfur atom, a carbonyl group, a sulfonyl group, or an alkylene group having 1 to 6 carbon atoms, $Z^{15}$ and $Z^{16}$ each independently represent a single bond or a linear or branched alkylene group having 1 to 6 carbon atoms, n15 and n16 each independently represent an integer of 0 to 4, when two or more $R^{25}$s are present, the two or more $R^{25}$s may be identical to or different from each other, and when two or more $R^{26}$s are present, the two or more $R^{26}$s may be identical to or different from each other,

[Chem. 5]

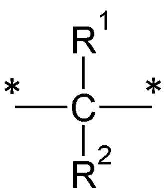
(2-2-1)

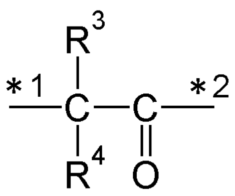
(2-2-2)

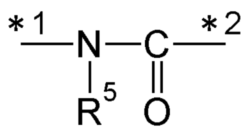
(2-2-3)

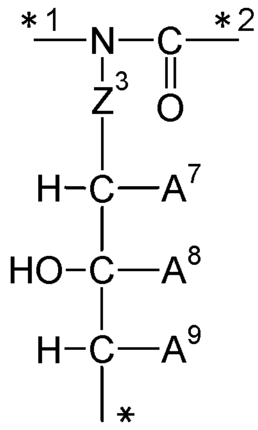
(2-2-4)

in the formulas (2-2-1) to (2-2-3), $R^1$ to $R^5$ each independently represent a hydrogen atom, an alkyl group having 1 to 10 carbon atoms which may be interrupted by an oxygen atom or a sulfur atom, an alkenyl group having 2 to 10 carbon atoms which may be interrupted by an oxygen atom or a sulfur atom, an alkynyl group having 2 to 10 carbon atoms which may be interrupted by an oxygen atom or a sulfur atom, a benzyl group, or a phenyl group, wherein the phenyl group may be substituted with at least one monovalent group selected from the group consisting of an alkyl group having 1 to 6 carbon atoms, a halogen atom, an alkoxy group having 1 to 6 carbon atoms, a nitro group, a cyano group, and an alkylthio group having 1 to 6 carbon atoms, $R^1$ and $R^2$ may be bonded to each other to form a ring having 3 to 6 carbon atoms, and $R^3$ and $R^4$ may be bonded to each other to form a ring having 3 to 6 carbon atoms, and
in the formula (2-2-4), $Z^3$ represents a single bond or a divalent group represented by a following formula (2-2-5), $A^7$, $A^8$, and $A^9$ each independently represent a hydrogen atom, a methyl group, or an ethyl group,
* represents a bond, *1 represents a bond bonded to a carbon atom in the formula (2-2), and *2 represents a bond bonded to a nitrogen atom in the formula (2-2), and

[Chem. 6]

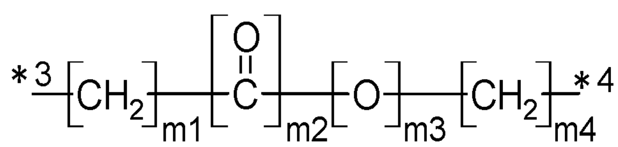
(2-2-5)

in the formula (2-2-5), m1 is an integer of 0 to 4, m2 is 0 or 1, m3 is 0 or 1, and m4 is an integer of 0 to 2, provided that, when m3 is 1, m1 and m2 are not both 0 at the same time, *3 represents a bond bonded to a nitrogen atom in the formula (2-2) or (2-2-4), and *4 represents a bond.

**4.** The release agent composition according to claim 1, wherein the carbon content is 50% or more.

**5.** The release agent composition according to claim 1, wherein

X[1] in the formula (1) represents an ether bond,

$R^1$ in the formula (1) represents a cyano group,
$R^2$ in the formula (1) represents -COO-, and
n2 in the formula (1) represents 0.

**6.** A laminate comprising:

a semiconductor substrate or an electronic device layer;
a light-transmissive support substrate; and
a release agent layer provided between the semiconductor substrate or the electronic device layer and the support substrate, wherein
the release agent layer is a release agent layer formed of the release agent composition according to any one of claims 1 to 5.

**7.** The laminate according to claim 6, comprising an adhesive layer provided between the semiconductor substrate or the electronic device layer and the support substrate.

**8.** A method for producing a processed semiconductor substrate or a processed electronic device layer, the method comprising:

Step 5A of processing the semiconductor substrate of the laminate according to claim 6, or Step 5B of processing the electronic device layer of the laminate according to claim 6; and
Step 6A of separating the semiconductor substrate processed in the Step 5A and the support substrate from each other, or Step 6B of separating the electronic device layer processed in the Step 5B and the support substrate from each other.

**9.** The method for producing a processed semiconductor substrate or a processed electronic device layer according to claim 8, wherein the Step 6A or the Step 6B comprises a step of irradiating the laminate with a laser from the support substrate side.

FIG. 1

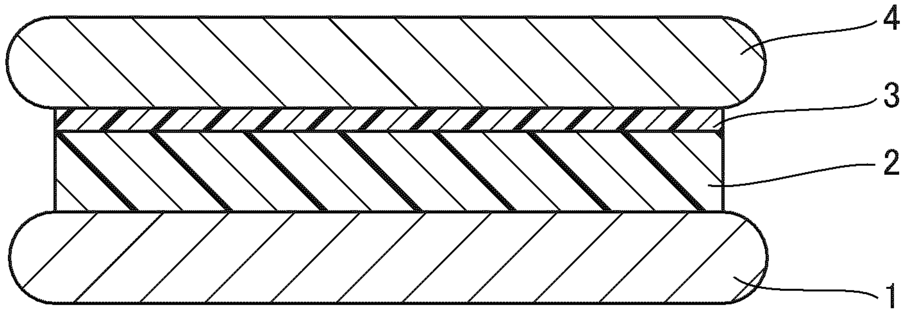

FIG. 2A

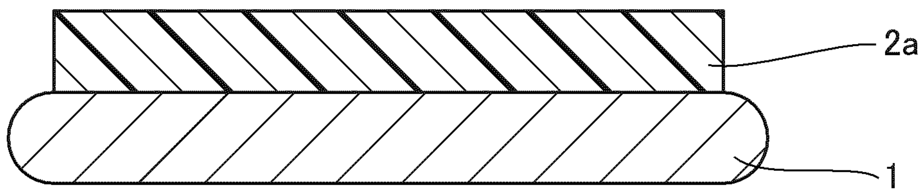

FIG. 2B

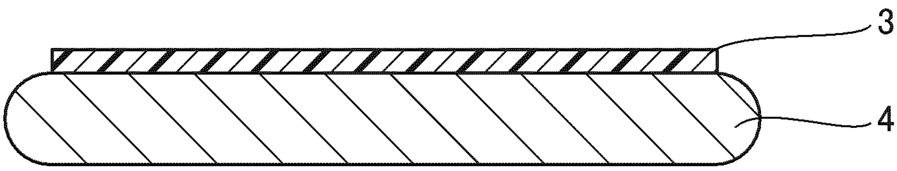

FIG. 2C

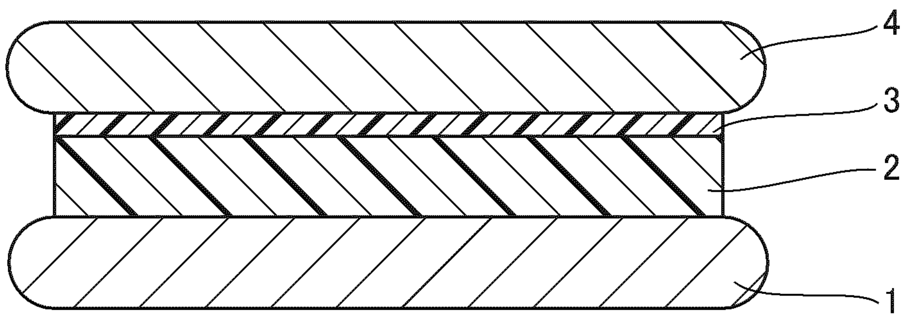

FIG. 3

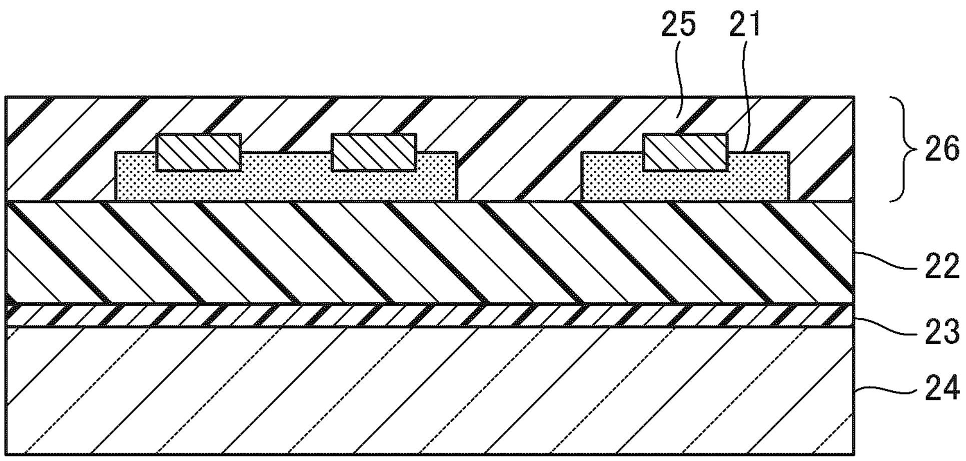

FIG. 4

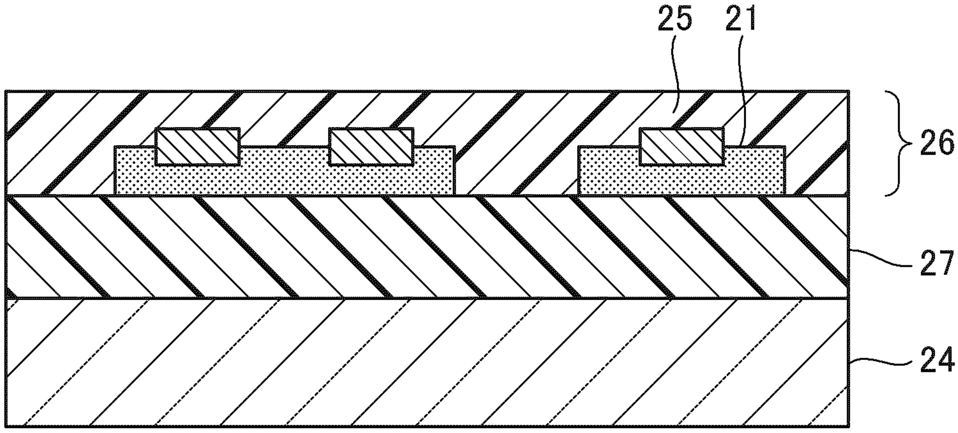

FIG. 5A

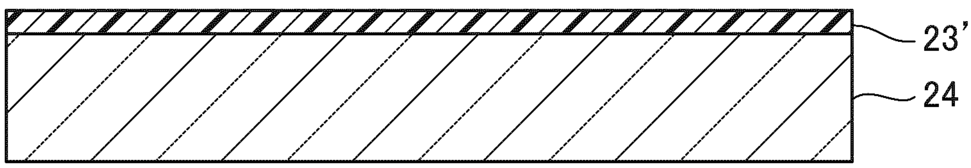

FIG. 5B

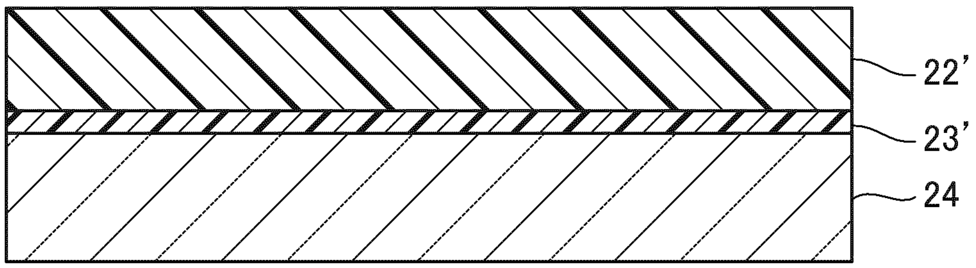

FIG. 5C

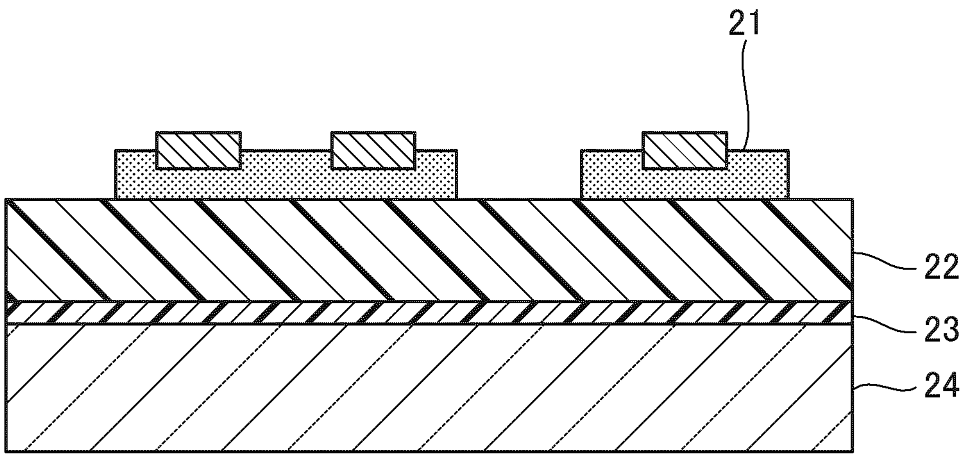

FIG. 5D

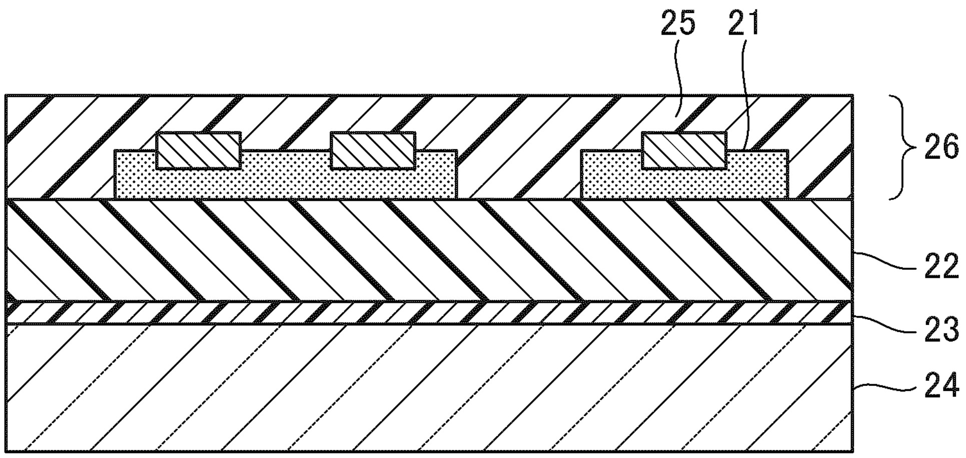

FIG. 6A

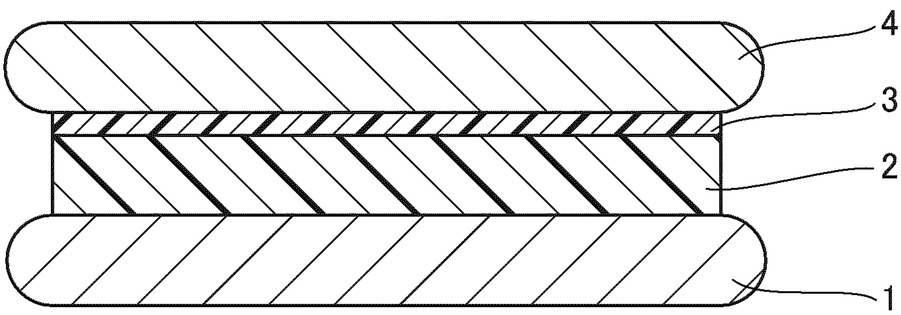

FIG. 6B

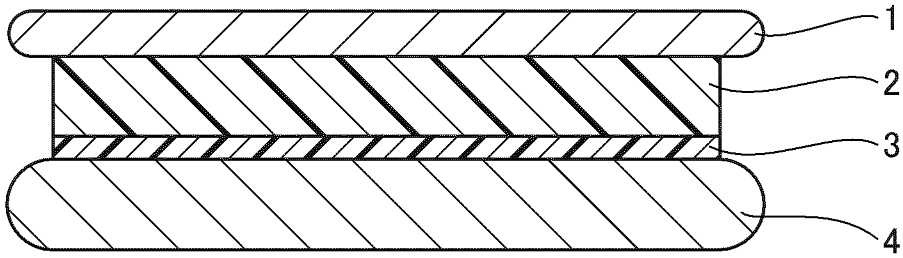

FIG. 6C

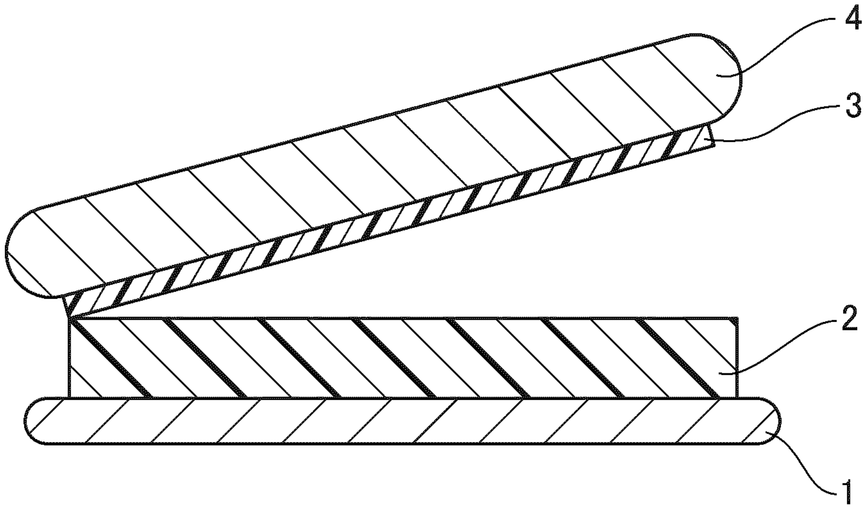

FIG. 6D

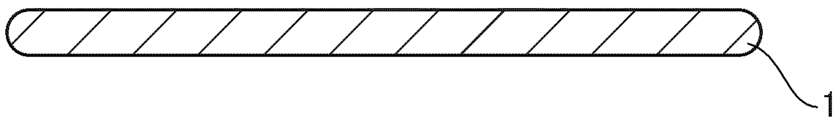

FIG. 7A

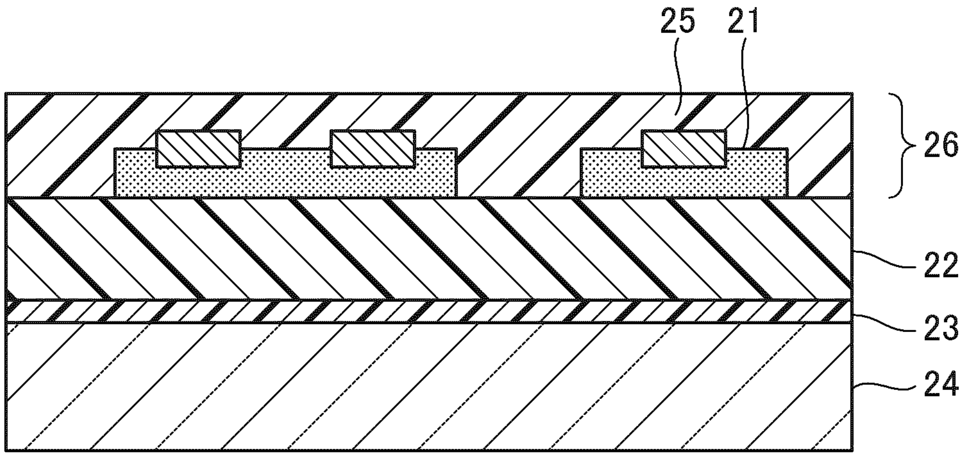

FIG. 7B

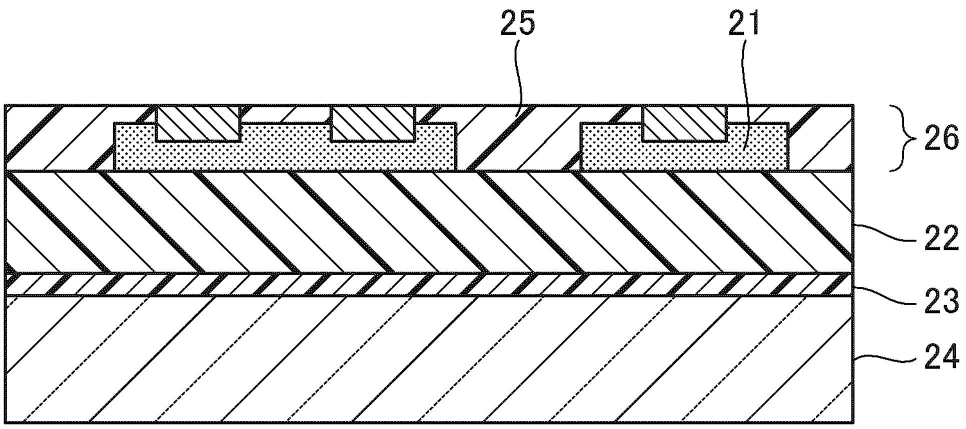

FIG. 7C

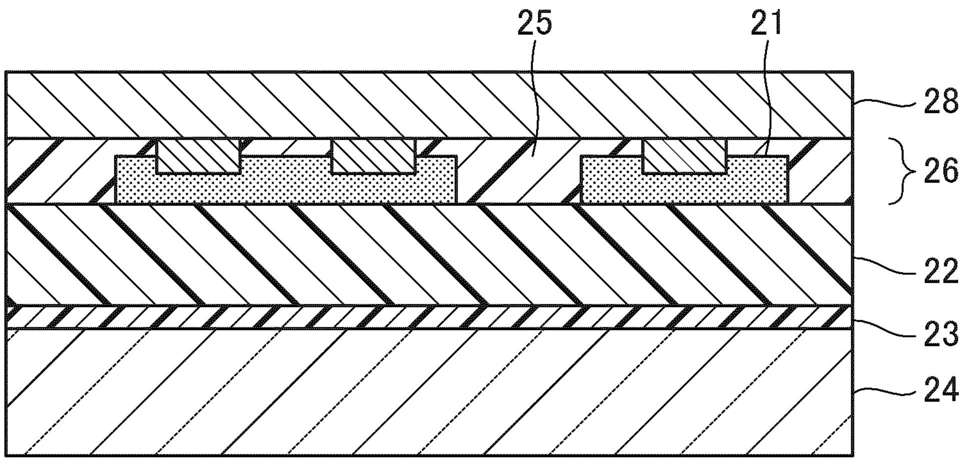

FIG. 7D

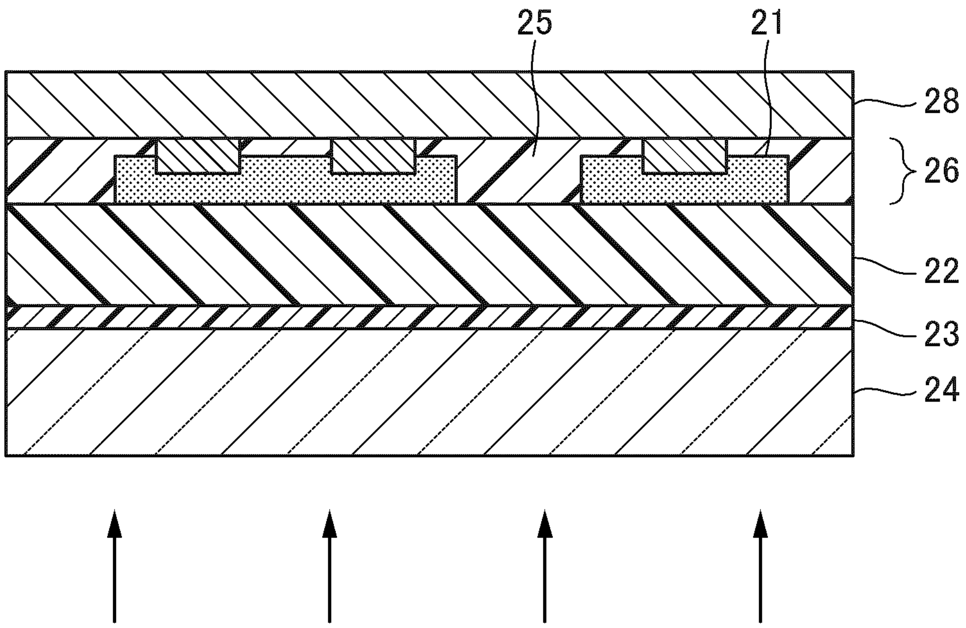

FIG. 7E

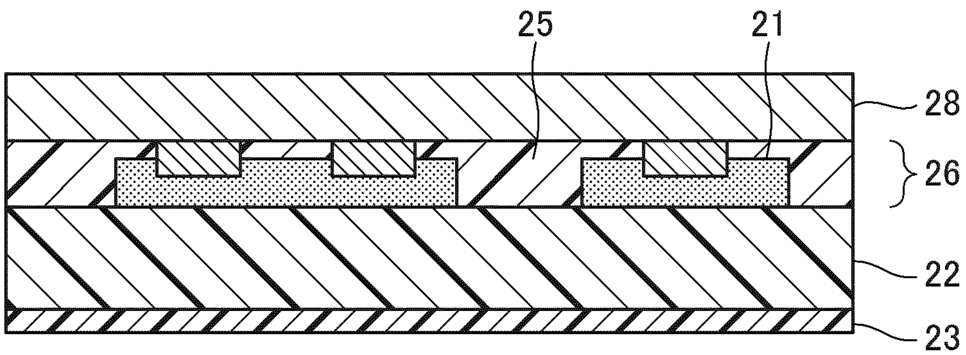

FIG. 7F

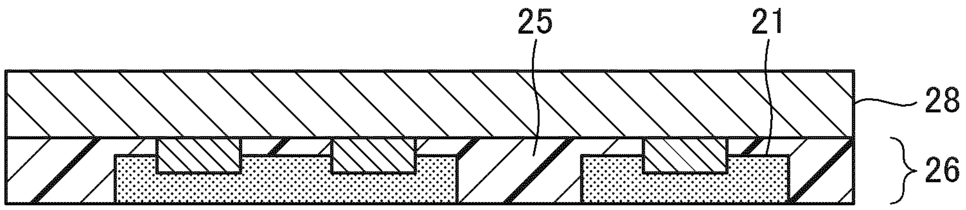

**INTERNATIONAL SEARCH REPORT**

International application No. **PCT/JP2023/033176**

**A. CLASSIFICATION OF SUBJECT MATTER**

***H01L 21/02***(2006.01)i; ***B32B 27/36***(2006.01)i; ***C08G 59/14***(2006.01)i; ***C08G 63/00***(2006.01)i; ***C09D 5/00***(2006.01)i; ***C09D 167/00***(2006.01)i; ***C09D 171/12***(2006.01)i; ***C09J 7/30***(2018.01)i; ***C09J 7/40***(2018.01)i; ***C09J 201/00***(2006.01)i; ***H01L 21/304***(2006.01)i; ***H01L 21/683***(2006.01)i

FI: H01L21/02 C; H01L21/304 622J; H01L21/68 N; C09J7/40; C09D5/00 Z; C09D167/00; C09D171/12; C08G63/00; C08G59/14; B32B27/36; C09J7/30; C09J201/00

According to International Patent Classification (IPC) or to both national classification and IPC

**B. FIELDS SEARCHED**

Minimum documentation searched (classification system followed by classification symbols)

H01L21/02; B32B27/36; C08G59/14; C08G63/00; C09D5/00; C09D167/00; C09D171/12; C09J7/30; C09J7/40; C09J201/00; H01L21/304; H01L21/683

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | WO 2022/102691 A1 (SEKISUI CHEMICAL CO., LTD.) 19 May 2022 (2022-05-19) paragraphs [0008]-[0070], fig. 1-4 | 1, 4, 6-9 |
| Y | | 5 |
| A | | 2-3 |
| Y | JP 2006-521567 A (PRESIDENT AND FELLOWS OF HARVARD COLLEGE) 21 September 2006 (2006-09-21) paragraph [0046] | 5 |
| A | WO 2022/186231 A1 (NISSAN CHEMICAL CORPORATION) 09 September 2022 (2022-09-09) entire text | 1-9 |

☑ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **07 November 2023** | **14 November 2023** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

INTERNATIONAL SEARCH REPORT

International application No.
**PCT/JP2023/033176**

**C. DOCUMENTS CONSIDERED TO BE RELEVANT**

| Category* | Citation of document, with indication, where appropriate, of the relevant passages | Relevant to claim No. |
|---|---|---|
| A | WO 2021/256386 A1 (NISSAN CHEMICAL CORPORATION) 23 December 2021 (2021-12-23)<br>entire text | 1-9 |
| A | WO 2019/088103 A1 (NISSAN CHEMICAL CORPORATION) 09 May 2019 (2019-05-09)<br>entire text | 1-9 |
| A | JP 2017-82196 A (NIPPON SYNTHETIC CHEM IND CO LTD) 18 May 2017 (2017-05-18)<br>entire text | 1-9 |
| A | JP 2013-235962 A (HITACHI CHEMICAL CO LTD) 21 November 2013 (2013-11-21)<br>entire text, all drawings | 1-9 |
| P, X<br><br><br>P, A | WO 2022/210238 A1 (NISSAN CHEMICAL CORPORATION) 06 October 2022 (2022-10-06)<br>paragraphs [0011]-[0026], [0286]-[0287], [0302] | 1, 4-9<br><br><br>2-3 |
| P, A | WO 2023/100506 A1 (NISSAN CHEMICAL CORPORATION) 08 June 2023 (2023-06-08)<br>entire text | 1-9 |

Form PCT/ISA/210 (second sheet) (January 2015)

**INTERNATIONAL SEARCH REPORT**
**Information on patent family members**

International application No.
**PCT/JP2023/033176**

| Patent document cited in search report | Publication date (day/month/year) | Patent family member(s) | Publication date (day/month/year) |
|---|---|---|---|
| WO 2022/102691 A1 | 19 May 2022 | TW 202235576 A | |
| JP 2006-521567 A | 21 September 2006 | US 2007/0249060 A1<br>paragraph [0054]<br>WO 2004/088325 A2<br>EP 1606629 A2<br>CA 2520191 A1<br>AU 2004225496 A1 | |
| WO 2022/186231 A1 | 09 September 2022 | TW 202302688 A | |
| WO 2021/256386 A1 | 23 December 2021 | EP 4166324 A1<br>entire text<br>CN 115702204 A<br>KR 10-2023-0024371 A<br>TW 202204530 A | |
| WO 2019/088103 A1 | 09 May 2019 | US 2020/0353735 A1<br>entire text<br>EP 3706156 A1<br>CN 111316401 A<br>KR 10-2020-0079491 A<br>SG 11202003989R A<br>TW 201933460 A | |
| JP 2017-82196 A | 18 May 2017 | (Family: none) | |
| JP 2013-235962 A | 21 November 2013 | (Family: none) | |
| WO 2022/210238 A1 | 06 October 2022 | TW 202311026 A | |
| WO 2023/100506 A1 | 08 June 2023 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2004064040 A
- JP 2012106486 A
- WO 2019088103 A